(19) Europäisches Patentamt
European Patent Office
Office européen des brevets

(11) EP 4 653 926 A1

(12) **EUROPEAN PATENT APPLICATION**
published in accordance with Art. 153(4) EPC

(43) Date of publication:
**26.11.2025 Bulletin 2025/48**

(21) Application number: **24763799.4**

(22) Date of filing: **22.02.2024**

(51) International Patent Classification (IPC):
***G02B 5/28*** $^{(2006.01)}$ ***G02B 1/115*** $^{(2015.01)}$
***G02B 5/26*** $^{(2006.01)}$

(52) Cooperative Patent Classification (CPC):
**G02B 1/115; G02B 5/26; G02B 5/28**

(86) International application number:
**PCT/JP2024/006615**

(87) International publication number:
**WO 2024/181319 (06.09.2024 Gazette 2024/36)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.02.2023 JP 2023029894**

(71) Applicant: **Tokai Optical Co., Ltd.**
**Okazaki-shi, Aichi 444-2192 (JP)**

(72) Inventors:
- **SUGIURA Muneo**
**Aza-shimoda, Eta-cho, Okazaki-shi, Aichi 444-2192 (JP)**
- **TAMURA Koichi**
**Aza-shimoda, Eta-cho, Okazaki-shi, Aichi 444-2192 (JP)**

(74) Representative: **Prüfer & Partner mbB**
**Patentanwälte · Rechtsanwälte**
**Sohnckestraße 12**
**81479 München (DE)**

(54) **OPTICAL THIN FILM**

(57) Provided is an optical thin film that allows sufficient suppression of deformation of a base member, has a higher performance, has a higher degree of freedom in design, and is more easily formed at lower cost. An optical thin film 1 includes one or more first films having a first material, one or more second films having a second material, and one or more third films having a third material. The first material is an oxidized compound containing Ti and La. Each of the first films has a tensile stress. A refractive index of the first film and a refractive index of each of the second films are higher than a refractive index of each of the third films. The third film has a compressive stress.

FIG.1

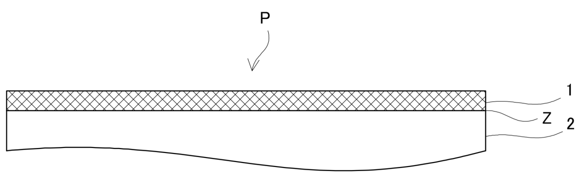


EP 4 653 926 A1

**Description**

TECHNICAL FIELD

The present invention relates to an optical thin film including a plurality of stacked films.

BACKGROUND ART

An optical laminate described in JP S59-10901 A (Patent Literature 1) is known. The optical laminate includes $TiO_2$ vapor-deposited films and $SiO_2$ vapor-deposited films alternately stacked on a substrate which is deformable by internal stresses of the stacked vapor-deposited films. In the optical laminate, the internal stresses of the $TiO_2$ vapor-deposited films and the internal stresses of the $SiO_2$ vapor-deposited films are balanced with each other.

Since the internal stresses of the $TiO_2$ vapor-deposited films having tensile stresses and the internal stresses of the $SiO_2$ vapor-deposited films having compressive stresses are balanced with each other in the optical laminate, deformation of the substrate is suppressed.

Recently, regarding optical thin films having a plurality of films, the film densities of one or more of the films are further increased for the purpose of improving performances of the optical thin films. The further increase in the film densities of $TiO_2$ films leads to further decrease in the tensile stresses of the $TiO_2$ films and also causes the tensile stresses of the $TiO_2$ films to become compressive stresses. Therefore, in the case of using $TiO_2$ films having further increased film densities, suppression of deformation of a substrate by the above optical laminate is not performed.

Meanwhile, JP 2003-277911 A (Patent Literature 2) describes an optical thin film in which an oxidized compound containing Ti and La is used as a material of high refractive index films instead of $TiO_2$ films. In this case, the high refractive index films can have high film densities and also have tensile stresses. Therefore, when the high refractive index films are combined with low refractive index films formed from $SiO_2$ having compressive stresses, this optical thin film can be formed so as to suppress deformation of a substrate and so as to also have a high performance.

CITATION LIST

[PATENT LITERATURE]

[PTL 1] JP S59-10901 A
[PTL 2] JP 2003-277911 A

SUMMARY OF THE INVENTION

PROBLEMS TO BE SOLVED BY THE INVENTION

The above optical thin film has a structure in which the optical film thickness of each of the high refractive index films is set to be three times the film thickness of the corresponding low refractive index film in order to attain balance with the compressive stress of the low refractive index film. More specifically, the following case is assumed in relation to a film structure. That is, a low refractive index film is represented by "L" and a high refractive index film is represented by "H". Further, numerals representing the optical film thicknesses of these films are written to be adjacent to and located leftward of "L" and "H" according to a rule in which an optical film thickness corresponding to $\lambda_D/4$ where $\lambda_D$ represents a design wavelength is represented by 1, an optical film thickness that is twice the optical film thickness corresponding to $\lambda_D/4$ is represented by 2, ···. That is, with the substrate side being defined as the left side, each of the numerals representing the optical film thicknesses and "H" or "L" are sequentially arrayed from the left side to the right side. In this case, the above optical thin film has a structure in which (1L3H) is repeated.

Furthermore, the above optical thin film has a structure in which each film having a tensile stress and the corresponding film having a compressive stress are assuredly adjacent to each other.

Design of the above optical thin film is restricted by such a structure. For example, if a reflective film (i.e., mirror) that is one of optical thin films and that reflects light within a predetermined wavelength range is formed of the above optical thin film, a wavelength range within which a sufficient reflectance is obtained is significantly narrowed.

Also, in particular, since the optical thin films serving as high refractive index films are thick, there is room for improvement in terms of easiness of, and cost for, forming the above optical thin film.

Considering this, a main object of the present disclosure is to provide an optical thin film that allows sufficient suppression of deformation of a base member.

Furthermore, another main object of the present disclosure is to provide an optical thin film that has a higher performance.

Moreover, still another main object of the present disclosure is to provide an optical thin film that has a higher degree of freedom in design.

In addition, still another main object of the present disclosure is to provide an optical thin film that is more easily formed at lower cost.

SOLUTION TO THE PROBLEMS

The present specification discloses an optical thin film. The optical thin film may include one or more first films having a first material. The optical thin film may further include one or more second films having a second material. The optical thin film may further include one or more third films having a third material. The first material may be an oxidized compound containing Ti and La. Each of the first films may have a tensile stress. A refractive index of the first film and a refractive index of each of the second films may be higher than a refractive index of each of the third films. The third film may have a compressive stress.

ADVANTAGEOUS EFFECTS OF THE INVENTION

A main advantageous effect of the present disclosure is provision of an optical thin film that allows sufficient suppression of deformation of a base member.

Furthermore, another main advantageous effect of the present disclosure is provision of an optical thin film having a higher performance.

Moreover, still another main advantageous effect of the present disclosure is provision of an optical thin film having a higher degree of freedom in design.

In addition, still another main advantageous effect of the present disclosure is provision of an optical thin film that is more easily formed at lower cost.

BRIEF DESCRIPTION OF THE DRAWINGS

[FIG. 1] FIG. 1 is a schematic diagram of an optical product including an optical thin film of the present disclosure.
[FIG. 2] FIG. 2 is a schematic diagram regarding a warp $\delta$ of a substrate.
[FIG. 3] FIG. 3 shows a graph indicating reflectance distributions of respective s-polarized and p-polarized lights within a wavelength range including a design wavelength in Example 1.
[FIG. 4] FIG. 4 shows a graph indicating reflectance distributions of respective s-polarized and p-polarized lights within the wavelength range including a design wavelength in Example 2.
[FIG. 5] FIG. 5 shows a graph indicating reflectance distributions of respective s-polarized and p-polarized lights within the wavelength range including a design wavelength in Example 3.
[FIG. 6] FIG. 6 shows a graph indicating reflectance distributions of respective s-polarized and p-polarized lights within the wavelength range including a design wavelength in Example 4.
[FIG. 7] FIG. 7 shows a graph indicating reflectance distributions of respective s-polarized and p-polarized lights within the wavelength range including a design wavelength in Example 5.
[FIG. 8] FIG. 8 shows a graph indicating reflectance distributions of respective s-polarized and p-polarized lights within the wavelength range including a design wavelength in Example 6.
[FIG. 9] FIG. 9 shows a graph indicating reflectance distributions of respective s-polarized and p-polarized lights within the wavelength range including a design wavelength in Example 7.
[FIG. 10] FIG. 10 shows a graph indicating reflectance distributions of respective s-polarized and p-polarized lights within the wavelength range including a design wavelength in Example 8.
[FIG. 11] FIG. 11 shows a graph indicating reflectance distributions of respective s-polarized and p-polarized lights within the wavelength range including a design wavelength in Example 9.
[FIG. 12] FIG. 12 shows a graph indicating reflectance distributions of respective s-polarized and p-polarized lights within the wavelength range including a design wavelength in Example 10.
[FIG. 13] FIG. 13 shows a graph indicating reflectance distributions of respective s-polarized and p-polarized lights within the wavelength range including a design wavelength in Example 11.
[FIG. 14] FIG. 14 shows a graph indicating reflectance distributions of respective s-polarized and p-polarized lights within the wavelength range including a design wavelength in Example 12.
[FIG. 15] FIG. 15 shows a graph indicating reflectance distributions of respective s-polarized and p-polarized lights within the wavelength range including a design wavelength in Example 13.
[FIG. 16] FIG. 16 shows a graph indicating reflectance distributions of respective s-polarized and p-polarized lights within the wavelength range including a design wavelength in Example 14.
[FIG. 17] FIG. 17 shows a graph indicating reflectance distributions of respective s-polarized and p-polarized lights within the wavelength range including a design wavelength in Example 15.
[FIG. 18] FIG. 18 shows a graph indicating reflectance distributions of respective s-polarized and p-polarized lights within the wavelength range including a design wavelength in Comparative Example 1.
[FIG. 19] FIG. 19 shows a graph indicating reflectance distributions of respective s-polarized and p-polarized lights within the wavelength range including a design wavelength in Comparative Example 2.
[FIG. 20] FIG. 20 shows a graph indicating reflectance distributions of respective s-polarized and p-polarized lights within the wavelength range including a design wavelength in Comparative Example 3.
[FIG. 21] FIG. 21 shows a graph indicating reflectance distributions of respective s-polarized and p-polarized lights within the wavelength range including a design wavelength in Comparative Example 4.
[FIG. 22] FIG. 22 shows a graph indicating reflectance distributions of respective s-polarized and p-polarized lights within the wavelength range including a design wavelength in Comparative Example 5.
[FIG. 23] FIG. 23 shows a graph indicating reflectance distributions of respective s-polarized and p-polarized lights within the wavelength range including a design wavelength in Comparative Example 6.
[FIG. 24] FIG. 24 shows a graph indicating reflectance distributions of respective s-polarized and p-polarized lights within the wavelength range including a design wavelength in Comparative Example 7.
[FIG. 25] FIG. 25 shows a graph indicating a $GDD_{rs}$ and a $GDD_{rp}$ in Example 1.
[FIG. 26] FIG. 26 shows a graph indicating a $GDD_{rs}$ and a $GDD_{rp}$ in Example 2.
[FIG. 27] FIG. 27 shows a graph indicating a $GDD_{rs}$ and a $GDD_{rp}$ in Example 3.
[FIG. 28] FIG. 28 shows a graph indicating a $GDD_{rs}$ and a $GDD_{rp}$ in Example 4.
[FIG. 29] FIG. 29 shows a graph indicating a $GDD_{rs}$ and a $GDD_{rp}$ in Example 5.
[FIG. 30] FIG. 30 shows a graph indicating a $GDD_{rs}$ and a $GDD_{rp}$ in Example 6.
[FIG. 31] FIG. 31 shows a graph indicating a $GDD_{rs}$ and a $GDD_{rp}$ in Example 7.
[FIG. 32] FIG. 32 shows a graph indicating a $GDD_{rs}$ and a $GDD_{rp}$ in Example 8.
[FIG. 33] FIG. 33 shows a graph indicating a $GDD_{rs}$ and a $GDD_{rp}$ in Example 9.
[FIG. 34] FIG. 34 shows a graph indicating a $GDD_{rs}$ and a $GDD_{rp}$ in Example 10.
[FIG. 35] FIG. 35 shows a graph indicating a $GDD_{rs}$ and a $GDD_{rp}$ in Example 11.
[FIG. 36] FIG. 36 shows a graph indicating a $GDD_{rs}$ and a $GDD_{rp}$ in Example 12.
[FIG. 37] FIG. 37 shows a graph indicating a $GDD_{rs}$ and a $GDD_{rp}$ in Example 13.
[FIG. 38] FIG. 38 shows a graph indicating a $GDD_{rs}$ and a $GDD_{rp}$ in Example 14.
[FIG. 39] FIG. 39 shows a graph indicating a $GDD_{rs}$ and a $GDD_{rp}$ in Example 15.
[FIG. 40] FIG. 40 shows a graph indicating a $GDD_{rs}$ and a $GDD_{rp}$ in Comparative Example 1.
[FIG. 41] FIG. 41 shows a graph indicating a $GDD_{rs}$ and a $GDD_{rp}$ in Comparative Example 2.
[FIG. 42] FIG. 42 shows a graph indicating a $GDD_{rs}$ and a $GDD_{rp}$ in Comparative Example 3.
[FIG. 43] FIG. 43 shows a graph indicating a $GDD_{rs}$ and a $GDD_{rp}$ in Comparative Example 4.
[FIG. 44] FIG. 44 shows a graph indicating a $GDD_{rs}$ and a $GDD_{rp}$ in Comparative Example 5.
[FIG. 45] FIG. 45 shows a graph indicating a $GDD_{rs}$ and a $GDD_{rp}$ in Comparative Example 6.
[FIG. 46] FIG. 46 shows a graph indicating a $GDD_{rs}$ and a $GDD_{rp}$ in Comparative Example 7.
[FIG. 47] FIG. 47 shows a graph indicating change amounts of surface flatness, $R_p$ width ratios, and $GDD_{rp}$ width ratios and a table indicating first pair number ratios $p_T$ and the values of t, h, and c of physical film thickness ratios, in Examples 1 to 15 and Comparative Examples 1 to 7.

DESCRIPTION OF EMBODIMENTS

Hereinafter, examples of embodiments of the present disclosure will be described with reference to the drawings as appropriate. The embodiments of the present disclosure are not limited to these examples.
As shown in FIG. 1, an optical thin film 1 of the present disclosure is formed on an outer side relative to a surface of a base member 2. The outer side relative to the base member 2 may be rephrased as a side opposite to the base member. The outer side relative to the base member 2 may be rephrased as an environmental side. In a case where the environment is in the ambient air, the outer side relative to the base member 2 may be rephrased as an ambient air side.
The surface of the base member 2 on which the optical thin film 1 is disposed is a film-formation-target surface U. A plurality of optical thin films 1 may be formed on one base member 2. In this case, the plurality of optical thin films 1 may be formed on a plurality of respective portions on one film-formation-target surface U or may be formed on a plurality of respective film-formation-target surfaces U.
The optical thin film 1 and the base member 2 form an optical product P.

The optical product P is, for example, a mirror and is more specifically a galvanometer mirror or a low dispersion mirror.

The galvanometer mirror can be used in the field of laser machining. An incidence angle range within which the galvanometer mirror has a sufficient reflectance is preferably set to be sufficiently wide in order to further facilitate control of an optical path for a laser. Therefore, the wavelength range for a sufficient reflectance of the galvanometer mirror needs to be set to be sufficiently wide.

The low dispersion mirror can be used for a femtosecond laser optical system. In the femtosecond laser optical system, ultrashort pulse light of a femtosecond order, i.e., femtosecond pulse light, is used. A femtosecond is $10^{-15}$ seconds. The femtosecond pulse light has a peak intensity of, for example, about $10^{12}$ W or higher. The femtosecond pulse light is obtained by superimposing lights having various wavelengths in a state where the phases thereof coincide with one another. That is, the femtosecond pulse light includes lights having a wide range of wavelengths. Therefore, in the femtosecond laser optical system, each of a wavelength range within which the low dispersion mirror has a sufficiently low group delay dispersion (hereinafter, referred to as GDD) and a wavelength range within which the low dispersion mirror has a sufficiently high reflectance needs to be set to be sufficiently wide. When the femtosecond pulse light propagates through the inside of a medium in which the velocity of light differs depending on the wavelength thereof, i.e., a medium in which the group velocity of light has wavelength dependence, a light having one wavelength advances relatively faster than a light having another wavelength in the propagation direction thereof or is superimposed on the light having the other wavelength. Consequently, the femtosecond pulse light comes to have a widened pulse width or a decreased peak intensity. Occurrence of variation in the velocity of light according to the wavelength thereof due to the wavelength dependence of the group velocity of the light is called a chirp. Characteristics of the femtosecond pulse light are impaired according to the extent to which the pulse width has widened or the peak intensity has decreased owing to the chirp. Thus, suppression of occurrence of the chirp in the low dispersion mirror is required. Therefore, the absolute value of the GDD of the low dispersion mirror is required to be sufficiently small.

In a case where the optical product P is a mirror, the outer side relative to the base member 2 may be rephrased as an incidence medium side or a reflection medium side.

The optical product P may include another constituent. For example, an intermediate film may be disposed between the film-formation-target surface U of the base member 2 and the optical thin film 1. The intermediate film may be a single-layer film or a multilayer film. Alternatively, a surface layer film may be disposed on the outer side of the optical thin film 1. The surface layer film may be a single-layer film or a multilayer film.

The base member 2 may have the shape of a plate or a block. In a case where the base member 2 has the shape of a plate, the base member 2 serves as a substrate.

The base member 2 is, for example, a substrate or a prism.

A material of the base member 2 is, for example, optical glass BK7 (hereinafter, simply referred to as "BK7"), quartz glass, glass ceramic, ceramic, crystal, or a semiconductor. The quartz glass may be Fused silica glass. The glass ceramic may be CLEARCERAM.

The base member 2 preferably has a linear expansion coefficient smaller than $2\times10^{-6}$/°C from the viewpoint of suppressing deformation of the base member 2 owing to change in temperature.

The optical thin film 1 is a multilayer film including a plurality of films.

The films of the optical thin film 1 are preferably formed from at least three types of materials. The materials of the films of the optical thin film 1 preferably include a first material, a second material, and a third material.

Some of the plurality of films of the optical thin film 1 preferably have compressive stresses, and other ones of the films preferably have tensile stresses.

As a material of some or all of the films having tensile stresses, an oxidized compound containing Ti and La is preferably used. The first material is preferably the oxidized compound containing Ti and La. Each of the films having the first material is a first film. Hereinafter, the oxidized compound containing Ti and La is sometimes written as $TiO_2$-$La_2O_3$.

A $TiO_2$-$La_2O_3$ film which is a film formed from $TiO_2$-$La_2O_3$ is used as a high refractive index film. $TiO_2$-$La_2O_3$ is a mixture of Ti oxide and La oxide. The $TiO_2$-$La_2O_3$ film has tensile stress even in a state where the film density thereof is sufficiently high. The $TiO_2$-$La_2O_3$ film is a first film.

As a material of some or all of films having compressive stresses, $TiO_2$ which is Ti oxide is preferably used. The second material is preferably $TiO_2$. Each of the films having the second material is a second film. A $TiO_2$ film which is a film formed from $TiO_2$ is used as a high refractive index film. $TiO_2$ is titanium oxide and is titania.

Alternatively, as a material of other ones or all of the films having compressive stresses, $Ta_2O_5$ which is Ta oxide is preferably used. The second material may be $Ta_2O_5$. The second film may be a $Ta_2O_5$ film. The $Ta_2O_5$ film which is a film formed from $Ta_2O_5$ is used as a high refractive index film. $Ta_2O_5$ is tantalum oxide and is tantala.

Alternatively, as a material of other ones or all of the films having compressive stresses, $Nb_2O_5$ which is Nb oxide is preferably used. The second material may be $Nb_2O_5$. The second film may be an $Nb_2O_5$ film. The $Nb_2O_5$ film which is a film formed from $Nb_2O_5$ is used as a high refractive index film. $Nb_2O_5$ is niobium oxide and is niobia.

Alternatively, as a material of other ones or all of the films having compressive stresses, $ZrO_2$ which is Zr oxide is preferably used. The second material may be $ZrO_2$. The second film may be a $ZrO_2$ film. The $ZrO_2$ film which is a film formed from $ZrO_2$ is used as a high refractive index film. $ZrO_2$ is zirconium oxide and is zirconia.

Alternatively, as a material of other ones or all of the films having compressive stresses, $HfO_2$ which is Hf oxide is preferably used. The second material may be $HfO_2$. The second film may be an $HfO_2$ film. The $HfO_2$ film which is a film formed from $HfO_2$ is used as a high refractive index film. $HfO_2$ is hafnium oxide and is hafnia.

As a material of some or all of other films having compressive stresses, $SiO_2$ which is Si oxide is preferably used. The third material is preferably $SiO_2$. Each of the films having the third material is a third film. An $SiO_2$ film which is a film formed from $SiO_2$ is used as a low refractive index film. $SiO_2$ is silicon oxide and is silica.

A refractive index of the first film and a refractive index of the second film are higher than a refractive index of the third film.

The first films or the second films, and the third films, are preferably disposed alternately in the optical thin film 1. Pairs of the first films and the third films and pairs of the second films and the third films are preferably used for the optical thin film 1. In a case where the film of the optical thin film 1 that is closest to the base member 2 is any of the first films or the second films, the third films are preferably disposed at even-numbered positions as counted from the base member 2 side. Meanwhile, in a case where the film of the optical thin film 1 that is closest to the base member 2 is any of the third films, the third films are preferably disposed at odd-numbered positions as counted from the base member 2 side.

In the optical thin film 1, at least two types of films among $TiO_2$ films, $Ta_2O_5$ films, $Nb_2O_5$ films, $ZrO_2$ films, and $HfO_2$ films may be used in combination. For example, $TiO_2$ films may be used as $(2\text{-}1)^{th}$ films, and $ZrO_2$ films may be used as $(2\text{-}2)^{th}$ films. In addition, intermediate refractive index films may further be disposed.

Hereinafter, the film structure of the optical thin film 1 may be described according to the following rules.

That is, the $TiO_2$-$La_2O_3$ films are indicated as "H". Also, the $TiO_2$ films are indicated as "T". Furthermore, the $SiO_2$ films are indicated as "L". Also, the $Ta_2O_5$ films are indicated as "A". Furthermore, the $Nb_2O_5$ films are indicated as "B". Moreover, the $ZrO_2$ films are indicated as "Z". In addition, the $HfO_2$ films are indicated as "F".

A numeral is written to be adjacent to and located leftward of "H". The numeral adjacent to and located leftward of "H" results from dividing the optical film thickness of each of the $TiO_2$-$La_2O_3$ films by $\lambda_D/4$. $\lambda_D$ is a design wavelength and is, for example, 645 nm (nanometers).

A numeral is written to be adjacent to and located leftward of "T". The numeral adjacent to and located leftward of "T" results from dividing the optical film thickness of each of the $TiO_2$ films by $\lambda_D/4$.

A numeral is written to be adjacent to and located leftward of "L". The numeral adjacent to and located leftward of "L" results from dividing the optical film thickness of each of the $SiO_2$ films by $\lambda_D/4$.

A numeral is written to be adjacent to and located leftward of "A". The numeral adjacent to and located leftward of "A" results from dividing the optical film thickness of each of the $Ta_2O_5$ films by $\lambda_D/4$.

A numeral is written to be adjacent to and located leftward of "B". The numeral adjacent to and located leftward of "B" results from dividing the optical film thickness of each of the $Nb_2O_5$ films by $\lambda_D/4$.

Hereinafter, no numeral is written to be adjacent to and located leftward of "Z" or to be adjacent to and located leftward of "F".

A pair of "H" and the corresponding numeral, a pair of "T" and the corresponding numeral, a pair of "L" and the corresponding numeral, a pair of "A" and the corresponding numeral, and a pair of "B" and the corresponding numeral, are sequentially arrayed from the left side to the right side with the base member 2 side being the left side according to the arrangement of the films of the optical thin film 1.

In a case where the arrangement of the films of the optical thin film 1 includes repetitions of a predetermined pattern, the arrangement is sometimes represented by enclosing the predetermined pattern by parentheses and placing the number of the repetitions on the upper right of the enclosed pattern. For example, a film structure of the optical thin film 1 represented by "$(1L2H)^3$" is a film structure in which a pattern composed of an $SiO_2$ film having an optical film thickness of $\lambda_D/4$ and a $TiO_2$-$La_2O_3$ film having an optical film thickness of $2\times\lambda_D/4$ has been repeated three times in this order from the base member 2 side. Thus, this film structure is equivalent to "1L2H1L2H1L2H". In this case, the number of the films of the optical thin film 1 is six. Likewise, a film structure of the optical thin film 1 represented by "$(1L2H)^3 1L$"is equivalent to "1L2H1L2H1L2H1L". In this case, the number of the films of the optical thin film 1 is seven.

From the viewpoint of obtaining a sufficient performance and also decreasing cost, the optical thin film 1 preferably has a first pair number ratio $p_T$ of 0.09 or higher and 0.55 or lower, the first pair number ratio $p_T$ being the ratio of a TL pair number to the total of the TL pair number and an HL pair number, the TL pair number being a first pair number and being represented by $x_T$, the HL pair number being a second pair number and being represented by y. Here, the first pair number ratio $p_T$ is expressed as $p_T=x_T/(x_T+y)$. The TL pair number $x_T$ is the number of existing pairs of the $TiO_2$ films and the $SiO_2$ films adjacent thereto on the outer side in the film structure of the optical thin film 1. The HL pair number y is the number of existing pairs of the $TiO_2$-$La_2O_3$ films and the $SiO_2$ films adjacent thereto on the outer side in the film structure of the optical thin film 1.

Furthermore, from the viewpoint of obtaining a sufficient performance and also decreasing cost, the optical thin film 1 preferably has a physical film thickness ratio t:h:c expressed as t:h:c=0.12 to 0.19:0.17 to 0.28:0.63 to 0.64, the physical film thickness ratio t:h:c being the ratio between t, h, and c, where t represents the total physical film thickness of the one or more $TiO_2$ films, h represents the total physical film thickness of the one or more $TiO_2$-$La_2O_3$ films, and c represents the total physical film thickness of the one or more $SiO_2$ films. That is, the numerical value of t, the numerical value of h, and the numerical value of c in the physical film thickness ratio t:h:c are preferably within a range of 0.12 or higher and 0.19 or lower, a range of 0.17 or higher and 0.28 or lower, and a range of 0.63 or higher and 0.64 or lower, respectively. The total physical film thickness t of the $TiO_2$ films is a second subtotal physical film thickness. The total physical film thickness h of the $TiO_2$-$La_2O_3$ films is a first subtotal physical film thickness. The total physical film thickness c of the $SiO_2$ films is a third subtotal physical film thickness.

Also, from the viewpoint of obtaining a sufficient performance and also decreasing cost, the optical thin film 1 preferably has a second pair number ratio $p_A$ of 0.05 or higher and 0.20 or lower, the second pair number ratio $p_A$ being the ratio of an AL pair number to the total of the AL pair number and the HL pair number, the AL pair number being a third pair number and being represented by $x_A$. Here, the second pair number ratio $p_A$ is expressed as $p_A=x_A/(x_A+y)$. The AL pair number $x_A$ is the number of existing pairs of the $Ta_2O_5$ films and the $SiO_2$ films adjacent thereto on the outer side in the film structure of the optical thin film 1.

Furthermore, from the viewpoint of obtaining a sufficient performance and also decreasing cost, the optical thin film 1 preferably has a third pair number ratio $p_B$ of 0.05 or higher and 0.20 or lower, the third pair number ratio $p_B$ being the ratio of a BL pair number to the total of the BL pair number and the HL pair number, the BL pair number being a fourth pair number and being represented by $x_B$. Here, the third pair number ratio $p_B$ is expressed as $p_B=x_B/(x_B+y)$. The BL pair number $x_B$ is the number of existing pairs of the $Nb_2O_5$ films and the $SiO_2$ films adjacent thereto on the outer side in the film structure of the optical thin film 1.

In addition, any of the TL pairs, the AL pairs, the BL pairs, the ZL pairs, and the FL pairs is preferably disposed at the outermost position in the film structure of the optical thin film 1.

Each of the TL pairs is a pair of a $TiO_2$ film and an $SiO_2$ film adjacent thereto on the outer side.

Each of the AL pairs is a pair of a $Ta_2O_5$ film and an $SiO_2$ film adjacent thereto on the outer side.

Each of the BL pairs is a pair of an $Nb_2O_5$ film and an $SiO_2$ film adjacent thereto on the outer side.

Each of the ZL pairs is a pair of a $ZrO_2$ film and an $SiO_2$ film adjacent thereto on the outer side.

Each of the FL pairs is a pair of an $HfO_2$ film and an $SiO_2$ film adjacent thereto on the outer side.

Each of a refractive index of the $TiO_2$ film of the TL pair, a refractive index of the $Ta_2O_5$ film of the AL pair, a refractive index of the $Nb_2O_5$ film of the BL pair, a refractive index of the $ZrO_2$ film of the ZL pair, and a refractive index of the $HfO_2$ film of the FL pair is higher than a refractive index of the $TiO_2$-$La_2O_3$ film. Therefore, the performance of the optical thin film 1 is improved. In a case where any of the TL pairs, the AL pairs, the BL pairs, the ZL pairs, and the FL pairs is disposed at the outermost position, the $SiO_2$ film is the outermost film. Therefore, the durability of the optical thin film 1 is improved.

Next, Examples of the present disclosure will be described.

However, the Examples do not limit the scope of the present disclosure.

According to interpretation of the present invention, Examples are sometimes substantially regarded as Comparative Examples departing from the scope of the present disclosure, or Comparative Examples are sometimes substantially regarded as Examples within the scope of the present disclosure.

In each of the Examples, a product in which a corresponding type of optical thin film 1 was formed on one surface of a plate-shaped base member 2 was made or simulated.

The one surface was the film-formation-target surface U. Meanwhile, in each of Comparative Examples, a product in which a corresponding type of optical thin film having a structure similar to the structure of the optical thin film 1 was formed on one surface of a plate-shaped base member 2 was made or simulated. In each of the Examples and the Comparative Examples, a mirror for reflecting light within a wavelength range including a design wavelength $\lambda_D$ defined as a center wavelength was assumed.

The material of each of the base members 2 was at least one of optical glass BK7, Fused silica glass, and CLEARCERAM. The base member 2 had the shape of a circular plate having a diameter of 30 mm. The base member 2 had a thickness of 3 mm.

Each of optical thin films 1 in respective Examples 1 to 6 included $TiO_2$-$La_2O_3$ films, $TiO_2$ films, and $SiO_2$ films. Each of the optical thin films 1 in respective Examples 1 to 6 had a design wavelength $\lambda_D$ of 645 nm. The film density of each of the $TiO_2$-$La_2O_3$ films, the $TiO_2$ films, and the $SiO_2$ films was higher than the film density of an ordinary vapor-deposited film owing to a film formation process such as ion-assisted deposition or sputtering. That is, the $TiO_2$-$La_2O_3$ films, the $TiO_2$ films, and $SiO_2$ films were high-density films.

The optical thin film 1 in Example 1 had a film structure represented by $(1T1L)^2(1H1L)^7 1T2L$. The number of the films of the optical thin film 1 in Example 1 was 20. The optical thin film 1 in Example 1 had a first pair number ratio $p_T$ expressed as $p_T=3/(3+7)=0.30$. The optical thin film 1 in Example 1 had a physical film thickness ratio t:h:c expressed as t:h:c=0.099:0.271:0.631. The optical thin film 1 in Example 1 was actually formed on each of base members 2 formed from optical glass BK7, Fused silica glass, and CLEARCERAM. Hereinafter, a combination of the base member 2 formed from optical glass BK7 and the optical thin film 1 in Example 1 is sometimes referred to as Example 1-B. Also, a combination of the base member 2 formed from Fused silica glass and the optical thin film 1 in Example 1 is sometimes referred to as Example 1-Q. Furthermore, a combination of the base member 2 formed from CLEARCERAM and the optical thin film 1 in Example 1 is sometimes referred to as Example 1-C. These naming rules sometimes apply to the other Examples and the Comparative Examples.

The optical thin film 1 in Example 2 had a film structure represented by $(1T1L)^3(1H1L)^7$1T2L. The number of the films of the optical thin film 1 in Example 2 was 22. The optical thin film 1 in Example 2 had a first pair number ratio $p_T$ expressed as $p_T$=4/(4+7)=0.36. The optical thin film 1 in Example 2 had a physical film thickness ratio t:h:c expressed as t:h:c=0.120:0.248:0.631. In Example 2, actual formation on each of the base members 2 formed from optical glass BK7, Fused silica glass, and CLEARCERAM was performed, i.e., Examples 2-B, 2-Q, and 2-C were actually formed.

The optical thin film 1 in Example 3 had a film structure represented by $(1T1L)^3(1H1L)^7$1T1L1T2L. The number of the films of the optical thin film 1 in Example 3 was 24. The optical thin film 1 in Example 3 had a first pair number ratio $p_T$ expressed as $p_T$=5/(5+7)=0.42. The optical thin film 1 in Example 3 had a physical film thickness ratio t:h:c expressed as t:h:c=0.139:0.229:0.632. In Example 3, Examples 3-B, 3-Q, and 3-C were actually formed.

The optical thin film 1 in Example 4 had a film structure represented by $(1T1L)^3(1H1L)^5(1T1L)^2$1T2L. The number of the films of the optical thin film 1 in Example 4 was 22. The optical thin film 1 in Example 4 had a first pair number ratio $p_T$ expressed as $p_T$=6/(6+5)=0.55. The optical thin film 1 in Example 4 had a physical film thickness ratio t:h:c expressed as t:h:c=0.183:0.179:0.638. In Example 4, Examples 4-B, 4-Q, and 4-C were actually formed.

The optical thin film 1 in Example 5 had a film structure represented by $(1T1L)^4(1H1L)^6$1H2L. The number of the films of the optical thin film 1 in Example 5 was 22. The optical thin film 1 in Example 5 had a first pair number ratio $p_T$ expressed as $p_T$=4/(4+7)=0.36. The optical thin film 1 in Example 5 had a physical film thickness ratio t:h:c expressed as t:h:c=0.120:0.248:0.631. In Example 5, Examples 5-B and 5-Q were simulated.

The optical thin film 1 in Example 6 had a film structure represented by $(1H1L)^7(1T1L)^3$1T2L. The number of the films of the optical thin film 1 in Example 6 was 22. The optical thin film 1 in Example 6 had a first pair number ratio $p_T$ expressed as $p_T$=4/(4+7)=0.36. The optical thin film 1 in Example 6 had a physical film thickness ratio t:h:c expressed as t:h:c=0.120:0.248:0.631. In Example 6, Examples 6-B and 6-Q were simulated.

Each of optical thin films 1 in respective Examples 7 and 8 included $TiO_2$-$La_2O_3$ films, $Ta_2O_5$ films, and $SiO_2$ films. Each of the optical thin films 1 in respective Examples 7 and 8 had a design wavelength $\lambda_D$ of 645 nm.

The optical thin film 1 in Example 7 had a film structure represented by $(1H1L)^{14}(1A1L)^2$1A2L. The number of the films of the optical thin film 1 in Example 7 was 34. The optical thin film 1 in Example 7 had a second pair number ratio $p_A$ expressed as $p_A$=3/(3+14)=0.18. In Example 7, Examples 7-B, 7-Q, and 7-C were simulated.

The optical thin film 1 in Example 8 had a film structure represented by $(1H1L)^{16}$1A2L. The number of the films of the optical thin film 1 in Example 8 was 34. The optical thin film 1 in Example 8 had a second pair number ratio $p_A$ expressed as $p_A$=1/(1+16)=0.06. In Example 8, Examples 8-B, 8-Q, and 8-C were simulated.

An optical thin film 1 in Example 9 included $TiO_2$-$La_2O_3$ films, $TiO_2$ films, and $SiO_2$ films. The optical thin film 1 in Example 9 had a design wavelength $\lambda_D$ of 645 nm.

The optical thin film 1 in Example 9 had a film structure represented by $(1H1L)^{10}$1T2L. The number of the films of the optical thin film 1 in Example 9 was 22. The optical thin film 1 in Example 9 had a first pair number ratio $p_T$ expressed as $p_T$=1/(1+10)=0.09. In Example 9, Examples 9-B, 9-Q, and 9-C were simulated.

Each of optical thin films 1 in respective Examples 10 and 11 included $TiO_2$-$La_2O_3$ films, $Nb_2O_5$ films, and $SiO_2$ films. Each of the optical thin films 1 in respective Examples 10 and 11 had a design wavelength $\lambda_D$ of 645 nm.

The optical thin film 1 in Example 10 had a film structure represented by $(1H1L)^{14}(1B1L)^2$1B2L. The number of the films of the optical thin film 1 in Example 10 was 34. The optical thin film 1 in Example 10 had a third pair number ratio $p_B$ expressed as $p_B$=3/(3+14)=0.18. In Example 10, Examples 10-B, 10-Q, and 10-C were simulated.

The optical thin film 1 in Example 11 had a film structure represented by $(1H1L)^{16}$1B2L. The number of the films of the optical thin film 1 in Example 11 was 34. The optical thin film 1 in Example 11 had a third pair number ratio $p_B$ expressed as $p_B$=1/(1+16)=0.06. In Example 11, Examples 11-B, 11-Q, and 11-C were simulated.

An optical thin film 1 in Comparative Example 1 included $TiO_2$ films and $SiO_2$ films. The optical thin film 1 in Comparative Example 1 had a design wavelength $\lambda_D$ of 633 nm.

The optical thin film 1 in Comparative Example 1 had a film structure represented by (1T1L)'1T2L. The number of the films of the optical thin film 1 in Comparative Example 1 was 16. The optical thin film 1 in Comparative Example 1 had a first pair number ratio $p_T$ expressed as $p_T$=8/(8+0)=1. The optical thin film 1 in Comparative Example 1 had a physical film thickness ratio t:h:c expressed as t:h:c=0.337:0:0.663. In Comparative Example 1, Comparative Examples 1-B, 1-Q, and 1-C were actually formed.

Each of optical thin films 1 in respective Comparative Examples 2 to 6 included $TiO_2$-$La_2O_3$ films and $SiO_2$ films. The optical thin film 1 in Comparative Example 2 had a design wavelength $\lambda_D$ of 633 nm. Each of the optical thin films 1 in respective Comparative Examples 3 to 6 had a design wavelength $\lambda_D$ of 645 nm.

The optical thin film 1 in Comparative Example 2 had a film structure represented by $(1H1L)^{11}$1H2L. The number of the films of the optical thin film 1 in Comparative Example 2 was 24. The optical thin film 1 in Comparative Example 2 had a first pair number ratio $p_T$ expressed as $p_T$=0/(0+12)=0. The optical thin film 1 in Comparative Example 2 had a physical film thickness ratio t:h:c expressed as t:h:c=0:0.383:0.617. In Comparative Example 2, Comparative Examples 2-B and 2-Q were actually formed.

The optical thin film 1 in Comparative Example 3 had a film structure represented by $(1.5H0.5L)^{14}$1.5H1L. The number of the films of the optical thin film 1 in Comparative Example 3 was 30. The optical thin film 1 in Comparative Example 3 had a first pair number ratio $p_T$ expressed as $p_T$=0/(0+15)=0. The optical thin film 1 in Comparative Example 3 had a physical film thickness ratio t:h:c expressed as t:h:c=0:0.655:0.345. In Comparative Example 3, Comparative Examples 3-B, 3-Q, and 3-C were simulated.

The optical thin film 1 in Comparative Example 4 had a film structure represented by $(0.5H1.5L)^{14}$0.5H2L. The number of the films of the optical thin film 1 in Comparative Example 4 was 30. The optical thin film 1 in Comparative Example 4 had a first pair number ratio $p_T$ expressed as $p_T$=0/(0+15)=0. The optical thin film 1 in Comparative Example 4 had a physical film thickness ratio t:h:c expressed as t:h:c=0:0.180:0.820. In Comparative Example 4, Comparative Examples 4-B, 4-Q, and 4-C were simulated.

The optical thin film 1 in Comparative Example 5 had a film structure represented by $(1.5H0.5L)^{6}$1.5H1L$(0.5H1.5L)^{7}$0.5H2L. The number of the films of the optical thin film 1 in Comparative Example 5 was 30. The optical thin film 1 in Comparative Example 5 had a first pair number ratio $p_T$ expressed as $p_T$=0/(0+15)=0. The optical thin film 1 in Comparative Example 5 had a physical film thickness ratio t:h:c expressed as t:h:c=0:0.372:0.628. In Comparative Example 5, Comparative Examples 5-B, 5-Q, and 5-C were simulated.

The optical thin film 1 in Comparative Example 6 had a film structure represented by $(1.5H0.5L)^{5}$1.5H1L$(0.5H1.5L)^{8}$0.5H2L. The number of the films of the optical thin film 1 in Comparative Example 6 was 30. The optical thin film 1 in Comparative Example 6 had a first pair number ratio $p_T$ expressed as $p_T$=0/(0+15)=0. The optical thin film 1 in Comparative Example 6 had a physical film thickness ratio t:h:c expressed as t:h:c=0:0.342:0.658. In Comparative Example 6, Comparative Examples 6-B, 6-Q, and 6-C were simulated.

An optical thin film 1 in Comparative Example 7 included $Ta_2O_5$ films and $SiO_2$ films. The optical thin film 1 in Comparative Example 7 had a design wavelength $\lambda_D$ of 645 nm.

The optical thin film 1 in Comparative Example 7 had a film structure represented by $(1A1L)^{16}$1A2L. The number of the films of the optical thin film 1 in Comparative Example 7 was 34. The optical thin film 1 in Comparative Example 7 had a second pair number ratio $p_A$ expressed as $p_A$=17/(17+0)=1. In Comparative Example 7, Comparative Examples 7-B, 7-Q, and 7-C were simulated.

An optical thin film 1 in Example 12 included $TiO_2$-$La_2O_3$ films, $TiO_2$ films, and $SiO_2$ films. The optical thin film 1 in Example 12 had a design wavelength $\lambda_D$ of 645 nm.

The optical thin film 1 in Example 12 had a film structure represented by $(1H1L)^{3}(1T1L)^{7}$1T2L. The number of the films of the optical thin film 1 in Example 12 was 22. The optical thin film 1 in Example 12 had a first pair number ratio $p_T$ expressed as $p_T$=8/(8+3)=0.73. In Example 12, Examples 12-B, 12-Q, and 12-C were simulated.

An optical thin film 1 in Example 13 included $TiO_2$-$La_2O_3$ films, $Ta_2O_5$ films, and $SiO_2$ films. The optical thin film 1 in Example 13 had a design wavelength $\lambda_D$ of 645 nm.

The optical thin film 1 in Example 13 had a film structure represented by $(1H1L)^{11}(1A1L)^{5}$1A2L. The number of the films of the optical thin film 1 in Example 13 was 34. The optical thin film 1 in Example 13 had a second pair number ratio $p_A$ expressed as $p_A$=6/(6+11)=0.35. In Example 13, Examples 13-B, 13-Q, and 13-C were simulated.

An optical thin film 1 in Example 14 included $TiO_2$-$La_2O_3$ films, $TiO_2$ films, and $SiO_2$ films. The optical thin film 1 in Example 14 had a design wavelength $\lambda_D$ of 645 nm.

The optical thin film 1 in Example 14 had a film structure represented by $(1H1L)^{4}(1T1L)^{6}$1T2L. The number of the films of the optical thin film 1 in Example 14 was 22. The optical thin film 1 in Example 14 had a first pair number ratio $p_T$ expressed as $p_T$=7/(7+4)=0.64. In Example 14, Examples 14-B, 14-Q, and 14-C were simulated.

An optical thin film 1 in Example 15 included $TiO_2$-$La_2O_3$ films, $Nb_2O_5$ films, and $SiO_2$ films. The optical thin film 1 in Example 15 had a design wavelength $\lambda_D$ of 645 nm.

The optical thin film 1 in Example 15 had a film structure represented by $(1H1L)^{11}(1B1L)^{5}$1B2L. The number of the films of the optical thin film 1 in Example 15 was 34. The optical thin film 1 in Example 15 had a third pair number ratio $p_B$ expressed as $p_B$=6/(6+11)=0.35. In Example 15, Examples 15-B, 15-Q, and 15-C were simulated.

The $TiO_2$-$La_2O_3$ films of each of the optical thin films 1 in respective Examples 1 to 15 and Comparative Examples 2 to 6 were formed or simulated by using "Substance H4" available from Merck KGaA. Hereinafter, $TiO_2$-$La_2O_3$ is sometimes simply referred to as "H4".

A surface flatness change in each of Examples 1-Q to 15-Q and Comparative Examples 1-Q to 7-Q having been formed or simulated was measured or calculated.

The surface flatness change is a change in surface flatness.

The surface flatness is the difference in a height direction between the highest position and the lowest position on an uneven portion of the film-formation-target surface U of the base member 2. The height direction is a direction perpendicular to a film-formation-target surface U obtained without considering the uneven portion or a film-formation-target surface U obtained through averaging with respect to the uneven portion. The surface flatness may also be referred to as peak-to-valley value, i.e., PV value. In many cases, the surface flatness is measured by using an interferometer of an He-Ne laser. The He-Ne laser has a wavelength $\lambda$ of 632.8 nm. The surface flatness is typically written with the unit thereof being $\lambda$ of 632.8 nm. That is, the surface flatness is typically written according to a value by which $\lambda$ (i.e., 632.8 nm) is multiplied. For example, in the case of 63.28 nm, the surface flatness is written as 0.1 $\lambda$. In the case of a projecting surface, the surface flatness is often written with a negative sign, and, in the case of a recessed surface, the surface flatness is often written with a positive sign. The following description is given according to this rule.

According to the present standard regarding polishing, a surface flatness of 0.25 $\lambda$ or smaller indicates that polishing has been done with high accuracy. The film-formation-target surface U of each of the base members 2 in Examples 1 to 15 and Comparative Examples 1 to 6 was polished to obtain a surface flatness of 0.25 $\lambda$ or smaller in a state where the base member 2 was present alone without forming the corresponding optical thin film 1 thereon.

The surface flatness of the optical thin film 1 of the optical product P is changed from the surface flatness of the film-formation-target surface U on which the optical thin film 1 has not yet been formed by formation of the optical thin film 1 having stresses onto the film-formation-target surface U. Formation of the optical thin film 1 having stresses onto the film-formation-target surface U leads to a warp of the plate-shaped base member 2 such that the surface flatness of the outer surface of the optical thin film 1 differs from the surface flatness of the film-formation-target surface U on which the optical thin film 1 has not yet been formed.

A warp $\delta$ of the plate-shaped base member 2, i.e., substrate, is shown in FIG. 2.

The warp $\delta$ of the substrate can be calculated through the following procedure. Reference can be made to description of a method for predicting a warp of an optical product in JP 7188754 B in which the inventors of the present disclosure are involved.

That is, Stoney's equation is solved with respect to a stress of a thin film as a single layer on a circular substrate on the basis of a curvature radius r, whereby expression (1) presented below is obtained. Here, $\sigma$ represents an internal stress of the thin film, d represents a physical film thickness of the thin film, $E_s$ represents a Young's modulus of the substrate, $v_s$ represents a Poisson's ratio of the substrate, b represents a plate thickness of the substrate, l represents a radius of the substrate, r represents a curvature radius of the substrate, and $\delta_0$ represents a warp of the substrate on which the film has not yet been formed. In the case of tensile stress, the sign of this type of stress is positive, and, in the case of compressive stress, the sign of this type of stress is negative. In the case of tensile stress, the plate-shaped base member 2 protrudes to the optical thin film 1 side as shown in FIG. 2. In the case of compressive stress, the plate-shaped base member 2 protrudes to the side opposite to the optical thin film 1.

[Math. 1]

$$\delta = \frac{3(1-\nu_s)l^2\sigma d}{E_s b^2} + \delta_0 \qquad (1)$$

Furthermore, in order to extensively apply the calculation for such an optical thin film as a single layer to a multilayer optical thin film 1 having high refractive index films and low refractive index films, the internal stress $\sigma$ is ascertained through division into a true stress $\sigma_i$ and a thermal stress as in expression (2) presented below. The thermal stress is proportional to the difference between a linear expansion coefficient $\alpha_f$ of the optical thin film 1 of the optical product P and a linear expansion coefficient $\alpha_s$ of the base member 2 of the optical product P. The true stress $\sigma_i$ is determined according to the materials of the films.

$E_f$ represents a Young's modulus of the multilayer optical thin film 1, $v_f$ represents a Poisson's ratio of the multilayer optical thin film 1, T represents a temperature at which the warp $\delta$ is measured, $\tau_{fit}T_d$ represents a temperature at which the multilayer optical thin film 1 is formed, and $\tau_{fit}$ represents one of fitting parameters defined through fitting performed by using a plurality of sampling values in order to further increase the accuracy of calculating the warp $\delta$.

[Math. 2]

$$\sigma = \sigma_i + (\alpha_s - \alpha_f)\left(\frac{E_f}{1-\nu_f}\right)(T - \tau_{fit}T_d) \qquad (2)$$

The true stress $\sigma_i$ is ascertained as an approximate average true stress, as in expression (3) presented below. $a_{fit}\sigma_H$ represents a true stress in the material of the high refractive index films, $a_{fit}$ represents one of the fitting parameters defined through fitting performed by using the plurality of sampling values in order to further increase the accuracy of calculating the warp $\delta$, $b_{fit}\sigma_L$ represents a true stress in the material of the low refractive index films, $b_{fit}$ represents one of the fitting parameters defined through fitting performed by using the plurality of sampling values in order to further increase the accuracy of calculating the warp $\delta$, $d_H$ represents a total film thickness of the high refractive index films of the multilayer optical thin film 1, and $d_L$ represents a total film thickness of the low refractive index films of the multilayer optical thin film 1.

[Math. 3]

$$\sigma_i = a_{fit}\sigma_H \frac{d_H}{d} + b_{fit}\sigma_L \frac{d_L}{d} \quad (3)$$

$$E_f = E_H \frac{d_H}{d} + E_L \frac{d_L}{d} \quad (4)$$

$$v_f = v_H \frac{d_H}{d} + v_L \frac{d_L}{d} \quad (5)$$

$$\alpha_f = \alpha_H \frac{d_H}{d} + \alpha_L \frac{d_L}{d} \quad (6)$$

The Young's modulus $E_f$ is ascertained as an approximate average Young's modulus, as in the above expression (4). $E_H$ represents a Young's modulus of the high refractive index films, and $E_L$ represents a Young's modulus of the low refractive index films.

Furthermore, the Poisson's ratio $v_f$ is ascertained as an approximate average Poisson's ratio, as in the above expression (5). $v_H$ represents a Poisson's ratio of the high refractive index films, and $v_L$ represents a Poisson's ratio of the low refractive index films.

In addition, the linear expansion coefficient $\alpha_f$ is ascertained as an approximate average linear expansion coefficient, as in the above expression (6). $\alpha_H$ represents a linear expansion coefficient of the high refractive index films, and $\alpha_L$ represents a linear expansion coefficient of the low refractive index films.

The above types of fitting parameters $a_{fit}$, $b_{fit}$, and $\tau_{fit}$ were determined so as to minimize f in expression (7) presented below. N represents the number of the samples, $\delta_{m,j}$ represents a warp measurement value of a $j^{th}$ sample, and $\delta_c$ represents a warp calculation value calculated by using a characteristic value and a conditional value that the $j^{th}$ sample is assumed to have.

When these types of fitting parameters $a_{fit}$, $b_{fit}$, and $\tau_{fit}$ are determined so as to minimize f in expression (7), the warp $\delta$ of the substrate is calculated according to expressions (1) to (6) with sufficient accuracy. Such calculation of the warp $\delta$ is applicable also to a base member 2 other than a circular substrate.

[Math. 4]

$$f = \left[\frac{1}{N}\sum_{j=1}^{N}\left\{\delta_{c,j}\left(a_{fit}, b_{fit}, \tau_{fit}\right) - \delta_{m,j}\right\}^2\right]^{1/2} \quad (7)$$

Measurement or calculation of the warp $\delta$ of the substrate makes it possible to ascertain a surface flatness after formation of the optical thin film 1 and makes it possible to ascertain a surface flatness change after formation of the optical thin film 1.

The various types of data used for calculating the surface flatness change on the basis of the warp $\delta$ of the substrate are as follows and indicated in Table 1 and Table 2.

A linear expansion coefficient (1/°C, the same applies below) of $TiO_2$ is 4.4E-6. "E-6" means that the numeral adjacent to and located leftward of "E-6" is multiplied by $10^{-6}$. Hereinafter, "E-a" where a represents an arbitrarily-selected integer similarly means that the numeral adjacent to and located leftward of "E-a" is multiplied by $10^{-a}$. A linear expansion coefficient of H4 is 4.4E-6. A linear expansion coefficient of $SiO_2$ is 2.1E-6.

A Young's modulus (GPa, the same applies below) of $TiO_2$ is 136. A Young's modulus of H4 is 136. A Young's modulus of $SiO_2$ is 87.

A Poisson's ratio of $TiO_2$ is 0.27. A Poisson's ratio of H4 is 0.27. A Poisson's ratio of $SiO_2$ is 0.11.

A linear expansion coefficient of CLEARCERAM is 0. A linear expansion coefficient of Fused silica glass is 5.9E-7. A linear expansion coefficient of Optical glass BK7 is 9.4E-6.

A Young's modulus of CLEARCERAM is 90.0. A Young's modulus of Fused silica glass is 72.0. A Young's modulus of Optical glass BK7 is 78.6.

A Poisson's ratio of CLEARCERAM is 0.25. A Poisson's ratio of Fused silica glass is 0.17. A Poisson's ratio of Optical glass BK7 is 0.21.

[Table 1]

| | Film | | Substrate | |
|---|---|---|---|---|
| Linear expansion coefficient (1/°C) | $TiO_2$ | 4.4E-6 | CLEARCERAM | 0 |
| | H4 | 4.4E-6 | Fused silica glass | 5.9E-7 |
| | $SiO_2$ | 2.1E-6 | Optical glass BK7 | 9.4E-6 |
| Young's modulus (GPa) | $TiO_2$ | 136 | CLEARCERAM | 90.0 |
| | H4 | 136 | Fused silica glass | 72.0 |
| | $SiO_2$ | 87 | Optical glass BK7 | 78.6 |
| Poisson's ratio | $TiO_2$ | 0.27 | CLEARCERAM | 0.25 |
| | H4 | 0.27 | Fused silica glass | 0.17 |
| | $SiO_2$ | 0.11 | Optical glass BK7 | 0.21 |

Formation and simulation of an optical thin film 1 including H4 films as $TiO_2$-$La_2O_3$ films, $TiO_2$ films, and $SiO_2$ films are performed at a film formation temperature of 81.7°C. In this case, a true stress (MPa, the same applies below) of the $TiO_2$ films is -14.7. The sign of the true stress is similar to the sign of the warp $\delta$. That is, in the case of tensile stress, the sign of the true stress is positive, and, in the case of compressive stress, the sign of the true stress is negative. Also, in this case, a true stress of the H4 films is 277.9, and a true stress of the $SiO_2$ films is -173.6.

Formation and simulation of an optical thin film 1 including H4 films, $Ta_2O_5$ films, and $SiO_2$ films are performed at a film formation temperature of 190°C. In this case, a true stress of the $TiO_2$ films is -145.4, a true stress of the H4 films is 252.8, and a true stress of the $SiO_2$ films is -207.0.

Formation and simulation of an optical thin film 1 including H4 films, $Nb_2O_5$ films, and $SiO_2$ films are performed at a film formation temperature of 146°C. In this case, a true stress of the $TiO_2$ films is -171.3, a true stress of the H4 films is 252.8, and a true stress of the $SiO_2$ films is -192.2.

[Table 2]

| Film formation temperature | Material | True stress (MPa) |
|---|---|---|
| 81.7°C | $TiO_2$ | -14.7 |
| | H4 | 277.9 |
| | $SiO_2$ | -173.6 |
| 190°C | $Ta_2O_5$ | -145.4 |
| | H4 | 252.8 |
| | $SiO_2$ | -207.0 |
| 146°C | $Nb_2O_5$ | -171.3 |
| | H4 | 252.8 |
| | $SiO_2$ | -192.2 |

Example 1-Q had a surface flatness change of 0.036 $\lambda$. Example 2-Q had a surface flatness change of -0.011 $\lambda$. Example 3-Q had a surface flatness change of -0.052 $\lambda$. Example 4-Q had a surface flatness change of -0.104 $\lambda$. Example 5-Q had a surface flatness change of -0.062 $\lambda$. Example 6-Q had a surface flatness change of -0.062 $\lambda$.

Example 7-Q had a surface flatness change of -0.075 $\lambda$. Example 8-Q had a surface flatness change of -0.011 $\lambda$. Example 9-Q had a surface flatness change of 0.047 $\lambda$. Example 10-Q had a surface flatness change of -0.081 $\lambda$. Example 11-Q had a surface flatness change of -0.012 $\lambda$.

Example 12-Q had a surface flatness change of -0.170 $\lambda$. Example 13-Q had a surface flatness change of -0.172 $\lambda$. Example 14-Q had a surface flatness change of -0.143 $\lambda$. Example 15-Q had a surface flatness change of -0.185 $\lambda$.

Comparative Example 1-Q had a surface flatness change of -0.215 $\lambda$. Comparative Example 2-Q had a surface flatness change of 0.127 $\lambda$. Comparative Example 3-Q had a surface flatness change of 0.472 $\lambda$. Comparative Example 4-Q had a surface flatness change of -0.308 $\lambda$. Comparative Example 5-Q had a surface flatness change of 0.052 $\lambda$. Comparative Example 6-Q had a surface flatness change of -0.002 $\lambda$. Comparative Example 7-Q had a surface flatness change of -0.527 $\lambda$.

These surface flatness changes are indicated on the left side of the following Table 3.

[Table 3]

| | Surface flatness change | $R_p$ width ratio | $GDD_{rp}$ width ratio |
|---|---|---|---|
| Example 1 | 0.036 λ | 0.212 | 0.147 |
| Example 2 | -0.011 λ | 0.212 | 0.142 |
| Example 3 | -0.052 λ | 0.250 | 0.146 |
| Example 4 | -0.104 λ | 0.269 | 0.162 |
| Example 5 | -0.062 λ | 0.222 | 0.140 |
| Example 6 | -0.062 λ | 0.225 | 0.177 |
| Example 7 | -0.075 λ | 0.185 | 0.133 |
| Example 8 | -0.011 λ | 0.184 | 0.124 |
| Example 9 | 0.047 λ | 0.202 | 0.143 |
| Example 10 | -0.081 λ | 0.188 | 0.141 |
| Example 11 | -0.012 λ | 0.184 | 0.126 |
| Example 12 | -0.170 λ | 0.264 | 0.204 |
| Example 13 | -0.172 λ | 0.193 | 0.145 |
| Example 14 | -0.143 λ | 0.257 | 0.202 |
| Example 15 | -0.185 λ | 0.207 | 0.163 |
| Comparative Example 1 | -0.215 λ | 0.287 | 0.224 |
| Comparative Example 2 | 0.127 λ | 0.198 | 0.134 |
| Comparative Example 3 | 0.472 λ | 0.143 | 0.078 |
| Comparative Example 4 | -0.308 λ | 0.146 | 0.081 |
| Comparative Example 5 | 0.052 λ | 0.144 | 0.081 |
| Comparative Example 6 | -0.002 λ | 0.146 | 0.081 |
| Comparative Example 7 | -0.527 λ | 0.219 | 0.158 |

Also, in each of Examples 1 to 15 and Comparative Examples 1 to 7 in which formation or simulation was performed, a distribution of s-polarized light reflectance $R_s$ and a distribution of p-polarized light reflectance $R_p$ within the wavelength range including the corresponding design wavelength $\lambda_D$ were measured or calculated.

FIGS. 3 to 17 each show reflectance distributions in the corresponding one of Examples 1 to 15. FIGS. 18 to 24 each show reflectance distributions in the corresponding one of Comparative Examples 1 to 7. The wavelength range shown in each of FIGS. 3 to 24 is 540 nm or longer and 760 nm or shorter.

Reflection, in a high-reflection band, of light incident on the optical products P is occurred not on the base members 2 but on the optical thin films 1. Therefore, each of the optical thin films 1 in respective Examples 1 to 15 and Comparative Examples 1 to 7 exhibited the same reflectance distributions regardless of the materials of the base members 2.

Furthermore, an $R_p$ width was ascertained from the distribution of the p-polarized light reflectance $R_p$ of each of the optical thin films 1 in respective Examples 1 to 15 and Comparative Examples 1 to 7. The $R_p$ width is the size of a wavelength range within which the reflectance is 50% or higher.

Also, an $R_p$ width ratio corresponding to a quotient obtained by dividing the $R_p$ width by the corresponding design wavelength $\lambda_D$ was ascertained. The $R_p$ width ratio is expressed as $R_p$ width ratio=$R_p$ width/design wavelength $\lambda_D$.

The $R_p$ width ratios are indicated at the center portion of the above Table 3.

Example 1 had an $R_p$ width ratio of 0.212. Example 2 had an $R_p$ width ratio of 0.212. Example 3 had an $R_p$ width ratio of 0.250. Example 4 had an $R_p$ width ratio of 0.269. Example 5 had an $R_p$ width ratio of 0.222. Example 6 had an $R_p$ width ratio of 0.225.

Example 7 had an $R_p$ width ratio of 0.185. Example 8 had an $R_p$ width ratio of 0.184. Example 9 had an $R_p$ width ratio of 0.202. Example 10 had an $R_p$ width ratio of 0.188. Example 11 had an $R_p$ width ratio of 0.184.

Example 12 had an $R_p$ width ratio of 0.264. Example 13 had an $R_p$ width ratio of 0.193. Example 14 had an $R_p$ width ratio of 0.257. Example 15 had an $R_p$ width ratio of 0.207.

Comparative Example 1 had an $R_p$ width ratio of 0.287. Comparative Example 2 had an $R_p$ width ratio of 0.198. Comparative Example 3 had an $R_p$ width ratio of 0.143. Comparative Example 4 had an $R_p$ width ratio of 0.146. Comparative Example 5 had an $R_p$ width ratio of 0.144. Comparative Example 6 had an $R_p$ width ratio of 0.146. Comparative Example 7 had an $R_p$ width ratio of 0.219.

In addition, in each of Examples 1 to 15 and Comparative Examples 1 to 7 in which simulation was performed, a $GDD_{rs}$ and a $GDD_{rp}$ within the wavelength range including the corresponding design wavelength $\lambda_D$ were calculated. Regarding each of the above actually formed optical products P as well, the $GDD_{rs}$ and the $GDD_{rp}$ were calculated through simulation.

The GDD serves as an index for a shift of a phase after reflection of pulsed light of a femtosecond order relative to a phase before the reflection. The GDD is expressed as $GDD=-\partial^2\varphi/\partial\omega^2$. Here, $\omega$ represents an angular frequency, and $\varphi$ represents a reflection phase. $\varphi$ represents a function of $\omega$. The unit of the GDD is $fs^2$. A GDD having a smaller absolute value leads to further suppression of the shift of the phase. Reference can be made to description of GDD in JP 7195022 B in which the inventors of the present disclosure are involved.

The $GDD_r$ represents a GDD at the time of reflection. In the Examples and the Comparative Examples of the present application, a GDD at the time of transmission is not considered, and thus the GDD and the $GDD_r$ may be interpreted as being synonymous with each other.

The $GDD_{rs}$ represents a GDD of s-polarized light at the time of reflection. The $GDD_{rp}$ represents a GDD of p-polarized light at the time of reflection.

FIGS. 25 to 39 each show a $GDD_{rs}$ and a $GDD_{rp}$ in the corresponding one of Examples 1 to 15. FIGS. 40 to 46 each show a $GDD_{rs}$ and a $GDD_{rp}$ in the corresponding one of Comparative Examples 1 to 7. The wavelength range shown in each of FIGS. 25 to 46 is 540 nm or longer and 760 nm or shorter.

Reflection, in a high-reflection band, of light incident on the optical products P was achieved not by the base members 2 but by the optical thin films 1. Therefore, each of the optical thin films 1 in respective Examples 1 to 15 and Comparative Examples 1 to 7 exhibited the same $GDD_{rs}$ and $GDD_{rp}$ distributions regardless of the materials of the base members 2.

Furthermore, a $GDD_{rp}$ width was ascertained from the $GDD_{rp}$ distribution of each of the optical thin films 1 in respective Examples 1 to 15 and Comparative Examples 1 to 7. The $GDD_{rp}$ width is the size of a wavelength range within which the $GDD_{rp}$ width has an absolute value of 50 or smaller.

Also, a $GDD_{rp}$ width ratio corresponding to a quotient obtained by dividing the $GDD_{rp}$ width by the corresponding design wavelength $\lambda_D$ was ascertained. The $GDD_{rp}$ width ratio is expressed as $GDD_{rp}$ width ratio=$GDD_{rp}$ width/design wavelength $\lambda_D$.

The $GDD_{rp}$ width ratios are indicated at the light portion of the above Table 3.

Example 1 had a $GDD_{rp}$ width ratio of 0.147. Example 2 had a $GDD_{rp}$ width ratio of 0.142. Example 3 had a $GDD_{rp}$ width ratio of 0.146. Example 4 had a $GDD_{rp}$ width ratio of 0.162. Example 5 had a $GDD_{rp}$ width ratio of 0.140. Example 6 had a $GDD_{rp}$ width ratio of 0.177.

Example 7 had a $GDD_{rp}$ width ratio of 0.133. Example 8 had a $GDD_{rp}$ width ratio of 0.124. Example 9 had a $GDD_{rp}$ width ratio of 0.143. Example 10 had a $GDD_{rp}$ width ratio of 0.141. Example 11 had a $GDD_{rp}$ width ratio of 0.126.

Example 12 had a $GDD_{rp}$ width ratio of 0.204. Example 13 had a $GDD_{rp}$ width ratio of 0.145. Example 14 had a $GDD_{rp}$ width ratio of 0.202. Example 15 had a $GDD_{rp}$ width ratio of 0.163.

Comparative Example 1 had a $GDD_{rp}$ width ratio of 0.224. Comparative Example 2 had a $GDD_{rp}$ width ratio of 0.134. Comparative Example 3 had a $GDD_{rp}$ width ratio of 0.078. Comparative Example 4 had a $GDD_{rp}$ width ratio of 0.081. Comparative Example 5 had a $GDD_{rp}$ width ratio of 0.081. Comparative Example 6 had a $GDD_{rp}$ width ratio of 0.081. Comparative Example 7 had a $GDD_{rp}$ width ratio of 0.158.

Hereinafter, characteristics of respective Examples 1 to 15 and respective Comparative Examples 1 to 7 will be described.

FIG. 47 shows a graph indicating values obtained by dividing surface flatness changes by $\lambda$, i.e., change amounts, $R_p$ width ratios, and $GDD_{rp}$ width ratios in Examples 1 to 6 and Comparative Examples 1 to 6 each of which corresponds to an optical thin film 1 including at least either of H4 films as $TiO_2$-$La_2O_3$ films and $TiO_2$ films. In FIG. 47, the change amounts of the surface flatness in the base members 2 formed from materials other than quartz are also shown together. The arrangement order in the horizontal axis direction in FIG. 47 is set substantially such that arrangement from the left side is made in descending order of the change amount of surface flatness. A positive change amount of surface flatness corresponds to a tensile stress, and a negative change amount of surface flatness corresponds to a compressive stress. Along the vertical axis on the right side of the graph in FIG. 47, magnitudes of $R_p$ width ratio and $GDD_{rp}$ width ratio are collectively written as "BANDWIDTH/CENTER WAVELENGTH". The bandwidth corresponds to the width of the wavelength range, and the center wavelength corresponds to the design wavelength $\lambda_D$.

In FIG. 47, the first pair number ratio $p_T$ and the values of t, h, and c of the physical film thickness ratio in each of the optical thin films 1 are shown together.

The optical thin film 1 in Comparative Example 1 alternately included $TiO_2$ films and $SiO_2$ films, i.e., films formed from two types of materials. In the optical thin film 1 in Comparative Example 1, both the $R_p$ width ratio and the $GDD_{rp}$ width ratio are sufficiently high, and the wavelength range within which incident light is sufficiently reflected and the wavelength range within which chirp is suppressed are sufficiently wide. However, the surface flatness change due to a compressive stress is large.

Here, examples of one criterion for a preferable surface flatness change include the absolute value of the surface flatness change being 0.125 λ or smaller. This criterion, i.e., the absolute value of the surface flatness change being 0.125 λ or smaller, is referred to as a first surface flatness change criterion below. Also, examples of one criterion that is for a preferable surface flatness change and that is more moderate than the first surface flatness change criterion include the absolute value of the surface flatness change being 0.2 λ or smaller. This criterion, i.e., the absolute value of the surface flatness change being 0.2 λ or smaller, is referred to as a second surface flatness change criterion below.

Furthermore, examples of one criterion for a preferable $R_p$ width ratio include the $R_p$ width ratio being 0.15 or higher. Also, examples of one criterion for a preferable $GDD_{rp}$ width ratio include the $GDD_{rp}$ width ratio being 0.10 or higher.

All of the first surface flatness change criterion and the criteria for the $R_p$ width ratio and the $GDD_{rp}$ width ratio do not necessarily have to be satisfied. At the time of ascertaining the characteristics of each of Examples 1 to 15 and Comparative Examples 1 to 7, the following issue was also considered, as appropriate. That is, when the corresponding optical thin film 1 fell short of any of the criteria, the extent to which the corresponding optical thin film 1 was close to satisfying this criterion was also considered, as appropriate. In addition, factors other than these criteria were also considered, as appropriate.

The optical thin film 1 in Comparative Example 1 sufficiently satisfied both the criteria for the $R_p$ width ratio and the $GDD_{rp}$ width ratio but significantly fell short of the first surface flatness change criterion. The optical thin film 1 in Comparative Example 1 also fell short of the second surface flatness change criterion.

Each of the optical thin films 1 in respective Comparative Examples 2 to 6 alternately included H4 films and $SiO_2$ films, i.e., films formed from two types of materials.

The optical thin film 1 in Comparative Example 2 satisfied both the criteria for the $R_p$ width ratio and the $GDD_{rp}$ width ratio. Meanwhile, the optical thin film 1 in Comparative Example 2 slightly fell short of the first surface flatness change criterion. The optical thin film 1 in Comparative Example 2 satisfied the second surface flatness change criterion.

The optical thin film 1 in Comparative Example 3 fell short of the criteria for the $R_p$ width ratio and the $GDD_{rp}$ width ratio, and the respective wavelength ranges for the $R_p$ and the $GDD_{rp}$ were narrow. Also, the optical thin film 1 in Comparative Example 3 significantly fell short of the first surface flatness change criterion and the second surface flatness change criterion.

The optical thin film 1 in Comparative Example 4 fell short of the criteria for the $R_p$ width ratio and the $GDD_{rp}$ width ratio, and the respective wavelength ranges for the $R_p$ and the $GDD_{rp}$ were narrow. Also, the optical thin film 1 in Comparative Example 4 significantly fell short of the first surface flatness change criterion and the second surface flatness change criterion.

The optical thin film 1 in Comparative Example 5 sufficiently satisfied the first surface flatness change criterion but fell short of the criteria for the $R_p$ width ratio and the $GDD_{rp}$ width ratio, and the respective wavelength ranges for the $R_p$ and the $GDD_{rp}$ were narrow.

The optical thin film 1 in Comparative Example 6 significantly sufficiently satisfied the first surface flatness change criterion but fell short of the criteria for the $R_p$ width ratio and the $GDD_{rp}$ width ratio, and the respective wavelength ranges for the $R_p$ and the $GDD_{rp}$ were narrow.

In contrast with the above optical thin films, each of the optical thin films 1 in respective Examples 1 to 6, 9, 12, and 14 alternately included $TiO_2$ films, H4 films, and $SiO_2$ films, i.e., films formed from three types of materials.

The optical thin film 1 in Example 1 sufficiently satisfied the first surface flatness change criterion, and the surface flatness thereof was kept approximately equal to the surface flatness of a polished surface. Also, the optical thin film 1 in Example 1 sufficiently satisfied each of the criteria for the $R_p$ width ratio and the $GDD_{rp}$ width ratio, and the respective wavelength ranges for the $R_p$ and the $GDD_{rp}$ were sufficiently wide.

The optical thin film 1 in Example 2 sufficiently satisfied the first surface flatness change criterion. Also, the optical thin film 1 in Example 2 sufficiently satisfied each of the criteria for the $R_p$ width ratio and the $GDD_{rp}$ width ratio.

The optical thin film 1 in Example 3 sufficiently satisfied the first surface flatness change criterion. Also, the optical thin film 1 in Example 3 sufficiently satisfied each of the criteria for the $R_p$ width ratio and the $GDD_{rp}$ width ratio.

The optical thin film 1 in Example 4 satisfied the first surface flatness change criterion. Also, the optical thin film 1 in Example 4 sufficiently satisfied each of the criteria for the $R_p$ width ratio and the $GDD_{rp}$ width ratio. In particular, the optical thin film 1 in Example 4 had the highest $R_p$ width ratio among Examples 1 to 6.

The optical thin film 1 in Example 5 sufficiently satisfied the first surface flatness change criterion. Also, the optical thin film 1 in Example 5 sufficiently satisfied each of the criteria for the $R_p$ width ratio and the $GDD_{rp}$ width ratio.

The optical thin film 1 in Example 6 sufficiently satisfied the first surface flatness change criterion. Also, the optical thin film 1 in Example 6 sufficiently satisfied each of the criteria for the $R_p$ width ratio and the $GDD_{rp}$ width ratio. In particular, the optical thin film 1 in Example 6 had the highest $GDD_{rp}$ width ratio among Examples 1 to 6.

The optical thin film 1 in Example 9 sufficiently satisfied the first surface flatness change criterion. Also, the optical thin film 1 in Example 9 sufficiently satisfied each of the criteria for the $R_p$ width ratio and the $GDD_{rp}$ width ratio. The first pair number ratio $p_T$ in Example 9 had the smallest value among the first pair number ratios $p_T$ in Examples 1 to 6, 9, 12, and 14 and was 0.09.

The optical thin film 1 in Example 12 sufficiently satisfied the criteria for the $R_p$ width ratio and the $GDD_{rp}$ width ratio. The optical thin film 1 in Example 12 slightly fell short of the first surface flatness change criterion. The optical thin film 1 in Example 12 satisfied the second surface flatness change criterion. The absolute value of the surface flatness change of the optical thin film 1 in Example 12 was similar to the absolute value of the surface flatness change of the optical thin film 1 in Comparative Example 2, whereas the $R_p$ width ratio and the $GDD_{rp}$ width ratio of the optical thin film 1 in Example 12 were higher than the $R_p$ width ratio and the $GDD_{rp}$ width ratio of the optical thin film 1 in Comparative Example 2.

The optical thin film 1 in Example 14 sufficiently satisfied the criteria for the $R_p$ width ratio and the $GDD_{rp}$ width ratio. The optical thin film 1 in Example 14 slightly fell short of the first surface flatness change criterion. The optical thin film 1 in Example 14 satisfied the second surface flatness change criterion. The absolute value of the surface flatness change of the optical thin film 1 in Example 14 was similar to the absolute value of the surface flatness change of the optical thin film 1 in Comparative Example 2, whereas the $R_p$ width ratio and the $GDD_{rp}$ width ratio of the optical thin film 1 in Example 14 were higher than the $R_p$ width ratio and the $GDD_{rp}$ width ratio of the optical thin film 1 in Comparative Example 2. Example 14 had a first pair number ratio $p_T$ of 0.64.

In the optical thin films 1 in respective Examples 1 to 6, 9, 12, and 14, a higher first pair number ratio $p_T$ tended to lead to a larger absolute value of the surface flatness change.

From the viewpoint of decreasing the surface flatness change, the first pair number ratio $p_T$ is preferably 0.55 or lower with the threshold value, i.e., 0.55, being the value in Example 4. The first pair number ratios $p_T$ of the optical thin films 1 in respective Examples 1 to 6 and 9 fell within this preferable range of the first pair number ratio $p_T$, but the first pair number ratios $p_T$ of the optical thin films 1 in respective Examples 12 and 14 did not fall within this preferable range.

Meanwhile, if the first pair number ratio $p_T$ is excessively low, approximation to Comparative Example 1 including no H4 film occurs so that the surface flatness change increases, and the performance improving effect of the high-density H4 films is hardly obtained. Considering this, the first pair number ratio $p_T$ is preferably 0.09 or higher with the threshold value, i.e., 0.09, being the value in Example 9.

Also, each of the optical thin films 1 in respective Examples 2 to 6 in which the surface flatness changes and each of the $R_p$ width ratios and the $GDD_{rp}$ width ratios were further balanced with each other had a physical film thickness ratio t:h:c within a range of t:h:c=0.12 to 0.19:0.17 to 0.28:0.63 to 0.64.

Therefore, the physical film thickness ratio t:h:c of the optical thin film 1 is more preferably within the range of t:h:c=0.12 to 0.19:0.17 to 0.28:0.63 to 0.64.

Each of the optical thin films 1 in respective Examples 7, 8, and 13 alternately included $Ta_2O_5$ films, H4 films, and $SiO_2$ films, i.e., films formed from three types of materials. The optical thin films 1 in respective Examples 7, 8, and 13 allowed use of $Ta_2O_5$ films.

The optical thin film 1 in Example 7 sufficiently satisfied the first surface flatness change criterion, and the surface flatness thereof was kept approximately equal to the surface flatness of a polished surface. Also, the optical thin film 1 in Example 7 satisfied each of the criteria for the $R_p$ width ratio and the $GDD_{rp}$ width ratio, and the respective wavelength ranges for the $R_p$ and the $GDD_{rp}$ were wide. The optical thin film 1 in Example 7 had a second pair number ratio $p_A$ of 0.18.

The optical thin film 1 in Example 8 sufficiently satisfied the first surface flatness change criterion. Also, the optical thin film 1 in Example 8 satisfied each of the criteria for the $R_p$ width ratio and the $GDD_{rp}$ width ratio. The optical thin film 1 in Example 8 had a second pair number ratio $p_A$ of 0.06.

The optical thin film 1 in Example 13 slightly fell short of the first surface flatness change criterion. The optical thin film 1 in Example 13 satisfied the second surface flatness change criterion. Meanwhile, the optical thin film 1 in Example 13 satisfied each of the criteria for the $R_p$ width ratio and the $GDD_{rp}$ width ratio. The optical thin film 1 in Example 13 had a second pair number ratio $p_A$ of 0.35. The surface flatness change, the $R_p$ width ratio, and the $GDD_{rp}$ width ratio of the optical thin film 1 in Example 13 were similar to those in Comparative Example 2, whereas Example 13 allowed use of $Ta_2O_5$ unlike in Comparative Example 2.

In the optical thin films 1 in respective Examples 7, 8, and 13, a higher second pair number ratio $p_A$ tended to lead to a larger absolute value of the surface flatness change.

From the viewpoint of decreasing the surface flatness change, the second pair number ratio $p_A$ is preferably 0.20 or lower with the threshold value, i.e., 0.20, being a value obtained by adding 0.02 to 0.18 which is the value in Example 7. The second pair number ratios $p_A$ of the optical thin films 1 in respective Examples 7 and 8 fell within this preferable range of the second pair number ratio $p_A$, and the second pair number ratio $p_A$ of the optical thin film 1 in Example 13 did not fall within this preferable range.

Meanwhile, if the second pair number ratio $p_A$ is excessively low, the surface flatness change increases, and the performance improving effect of the high-density H4 films is hardly obtained. Considering this, the second pair number ratio $p_A$ is preferably 0.05 or higher with the threshold value, i.e., 0.05, being a value obtained by subtracting 0.01 from 0.06 which is the value in Example 8.

Adjustment from the values in the Examples based on the above threshold values was performed in consideration of the tendency of the surface flatness change to increase according to increase in the second pair number ratio $p_A$ and the tendency of the performance to change according to decrease in the second pair number ratio $p_A$.

Each of the optical thin films 1 in respective Examples 10, 11, and 15 alternately included $Nb_2O_5$ films, H4 films, and $SiO_2$ films, i.e., films formed from three types of materials. The optical thin films 1 in respective Examples 7, 8, and 13 allowed use of $Nb_2O_5$ films.

The optical thin film 1 in Example 10 sufficiently satisfied the first surface flatness change criterion, and the surface flatness thereof was kept approximately equal to the surface flatness of a polished surface. Also, the optical thin film 1 in Example 10 satisfied each of the criteria for the $R_p$ width ratio and the $GDD_{rp}$ width ratio, and the respective wavelength ranges for the $R_p$ and the $GDD_{rp}$ were wide. The optical thin film 1 in Example 10 had a third pair number ratio $p_B$ of 0.18.

The optical thin film 1 in Example 11 sufficiently satisfied the first surface flatness change criterion. Also, the optical thin film 1 in Example 11 satisfied each of the criteria for the $R_p$ width ratio and the $GDD_{rp}$ width ratio. The optical thin film 1 in Example 11 had a third pair number ratio $p_B$ of 0.06.

The optical thin film 1 in Example 15 slightly fell short of the first surface flatness change criterion. The optical thin film 1 in Example 15 satisfied the second surface flatness change criterion. Meanwhile, the optical thin film 1 in Example 15 satisfied each of the criteria for the $R_p$ width ratio and the $GDD_{rp}$ width ratio. The optical thin film 1 in Example 15 had a third pair number ratio $p_B$ of 0.35. The surface flatness change, the $R_p$ width ratio, and the $GDD_{rp}$ width ratio of the optical thin film 1 in Example 15 were similar to those in Comparative Example 2, whereas Example 15 allowed use of $Nb_2O_5$ unlike in Comparative Example 2.

In the optical thin films 1 in respective Examples 10, 11, and 15, a higher third pair number ratio $p_B$ tended to lead to a larger absolute value of the surface flatness change.

From the viewpoint of decreasing the surface flatness change, the third pair number ratio $p_B$ is preferably 0.20 or lower with the threshold value, i.e., 0.20, being a value obtained by adding 0.02 to 0.18 which is the value in Example 11. The third pair number ratios $p_B$ of the optical thin films 1 in respective Examples 10 and 11 fell within this preferable range of the third pair number ratio $p_B$, and the third pair number ratio $p_B$ of the optical thin film 1 in Example 15 did not fall within this preferable range.

Meanwhile, if the third pair number ratio $p_B$ is excessively low, the surface flatness change increases, and the performance improving effect of the high-density H4 films is hardly obtained. Considering this, the third pair number ratio $p_B$ is preferably 0.05 or higher with the threshold value, i.e., 0.05, being a value obtained by subtracting 0.01 from 0.06 which is the value in Example 11.

Adjustment from the values in the Examples based on the above threshold values was performed in consideration of the tendency of the surface flatness change to increase according to increase in the third pair number ratio $p_B$ and the tendency of the performance to change according to decrease in the third pair number ratio $p_B$.

Furthermore, in each of the optical thin films 1 in respective Examples 1 to 4 and 6 to 15, the $TiO_2$ films, the $Ta_2O_5$ films, or the $Nb_2O_5$ films having higher refractive indexes than the H4 films were disposed on the outer side relative to the outermost H4 films. Therefore, in each of the optical thin films 1 in respective Examples 1 to 4 and 6 to 15, films that were located on the nearer side than the H4 films and that had higher refractive indexes than the H4 films were able to receive incident light, whereby performances (e.g., reflection performance) of the optical product P were improved.

## DESCRIPTION OF THE REFERENCE CHARACTERS

- 1 optical thin film
- 2 base member
- P optical product
- U film-formation-target surface

## Claims

**1.** An optical thin film comprising:

one or more first films having a first material;
one or more second films having a second material; and

one or more third films having a third material, wherein
the first material is an oxidized compound containing Ti and La,
each of the first films has a tensile stress,
a refractive index of the first film and a refractive index of each of the second films are higher than a refractive index of each of the third films, and
the third film has a compressive stress.

2. The optical thin film according to claim 1, wherein

the optical thin film is formed on a base member, and
the base member has a linear expansion coefficient smaller than $2\times10^{-6}$/°C.

3. The optical thin film according to claim 1, wherein, in a case where the optical thin film is formed on one surface of a substrate that is formed from Fused silica glass having a diameter of 30 mm and a thickness of 3 mm, a surface flatness change of the one surface is 0.2 $\lambda$ or smaller where $\lambda$ is 632.8 nm.

4. The optical thin film according to claim 1, wherein

the second material is Ti oxide, and
the third material is Si oxide.

5. The optical thin film according to claim 4, wherein

the first films or the second films, and the third films, are alternately arranged, and
the optical thin film has a first pair number ratio of 0.09 or higher and 0.55 or lower, the first pair number ratio being a ratio of a first pair number to a total of the first pair number and a second pair number, the first pair number being the number of pairs of the second films and the third films, the second pair number being the number of pairs of the first films and the third films.

6. The optical thin film according to claim 4, wherein the optical thin film has a physical film thickness ratio t:h:c expressed as t:h:c=0.12 to 0.19:0.17 to 0.28:0.63 to 0.64, the physical film thickness ratio t:h:c being a ratio between a first subtotal physical film thickness has a total physical film thickness of the first films, a second subtotal physical film thickness t as a total physical film thickness of the second films, and a third subtotal physical film thickness c as a total physical film thickness of the third films.

7. The optical thin film according to claim 1, wherein

the optical thin film is formed on a base member,
the base member has a linear expansion coefficient smaller than $2\times10^{-6}$/°C,
the second material is Ti oxide,
the third material is Si oxide,
the first films or the second films, and the third films, are alternately arranged, and
the optical thin film has a first pair number ratio of 0.09 or higher and 0.55 or lower, the first pair number ratio being a ratio of a first pair number to a total of the first pair number and a second pair number, the first pair number being the number of pairs of the second films and the third films, the second pair number being the number of pairs of the first films and the third films.

8. The optical thin film according to claim 1, wherein

the second material is Ta oxide, and
the third material is Si oxide.

9. The optical thin film according to claim 8, wherein

the first films or the second films, and the third films, are alternately arranged, and
the optical thin film has a second pair number ratio of 0.05 or higher and 0.20 or lower, the second pair number ratio being a ratio of a third pair number to a total of the third pair number and a second pair number, the third pair number being the number of pairs of the second films and the third films, the second pair number being the number of pairs of the first films and the third films.

**10.** The optical thin film according to claim 1, wherein

the second material is Nb oxide, and
the third material is Si oxide.

**11.** The optical thin film according to claim 10, wherein

the first films or the second films, and the third films, are alternately arranged, and
the optical thin film has a third pair number ratio of 0.05 or higher and 0.20 or lower, the third pair number ratio being a ratio of a fourth pair number to a total of the fourth pair number and a second pair number, the fourth pair number being the number of pairs of the second films and the third films, the second pair number being the number of pairs of the first films and the third films.

**12.** The optical thin film according to claim 1, wherein

the optical thin film is formed on a base member, and
the second films are disposed on an outer side relative to the first films disposed closest to the base member.

FIG.1

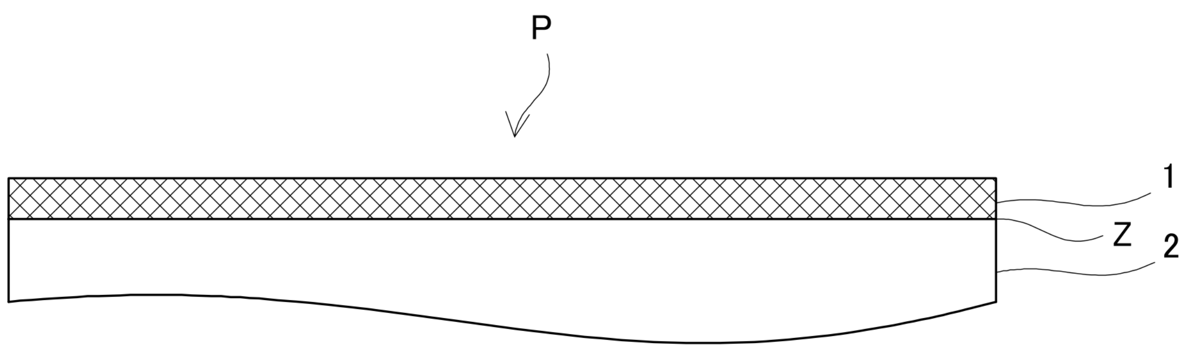

FIG.2

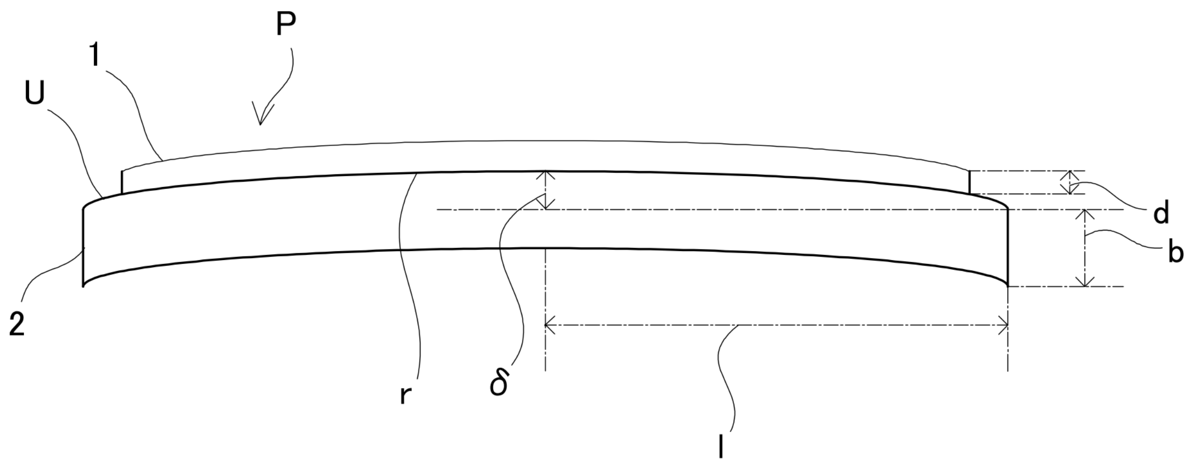

FIG.3

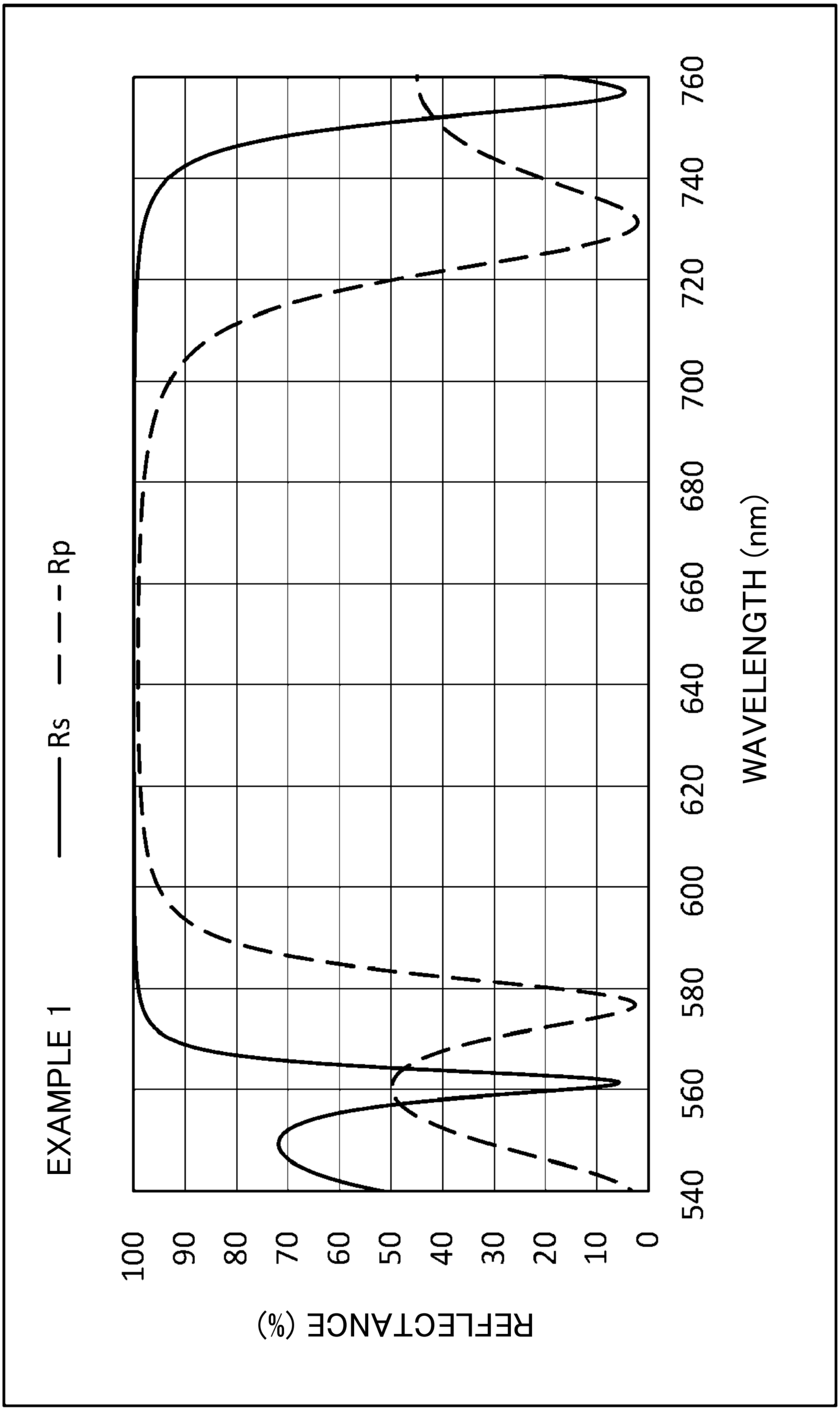
EXAMPLE 1
Rs
Rp
REFLECTANCE (%)
100
90
80
70
60
50
40
30
20
10
0
540
560
580
600
620
640
660
680
700
720
740
760
WAVELENGTH (nm)

FIG.4

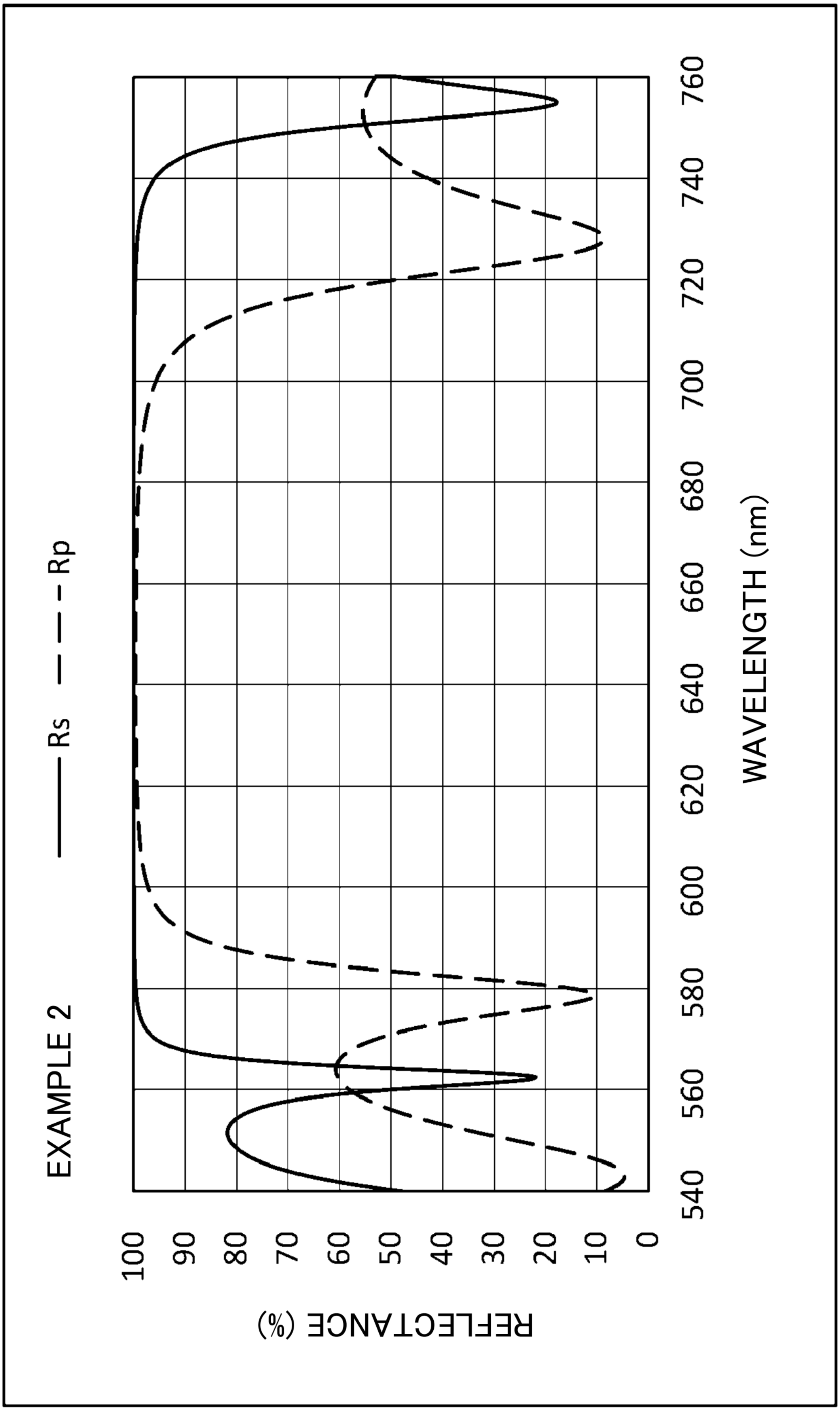
EXAMPLE 2
Rs
Rp
REFLECTANCE (%)
100
90
80
70
60
50
40
30
20
10
0
540
560
580
600
620
640
660
680
700
720
740
760
WAVELENGTH (nm)

FIG.5

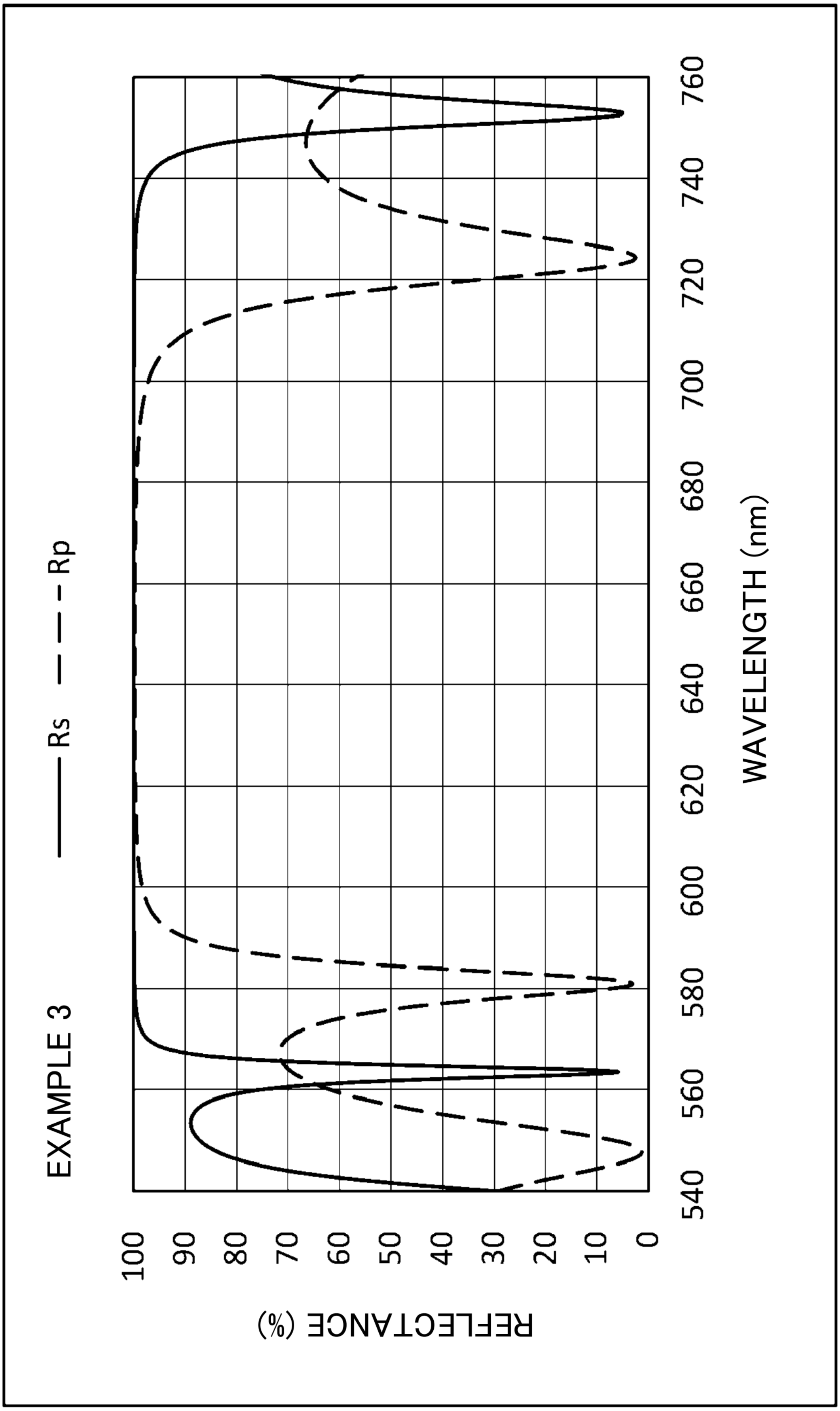
EXAMPLE 3
Rs
Rp
REFLECTANCE (%)
100
90
80
70
60
50
40
30
20
10
0
540
560
580
600
620
640
660
680
700
720
740
760
WAVELENGTH (nm)

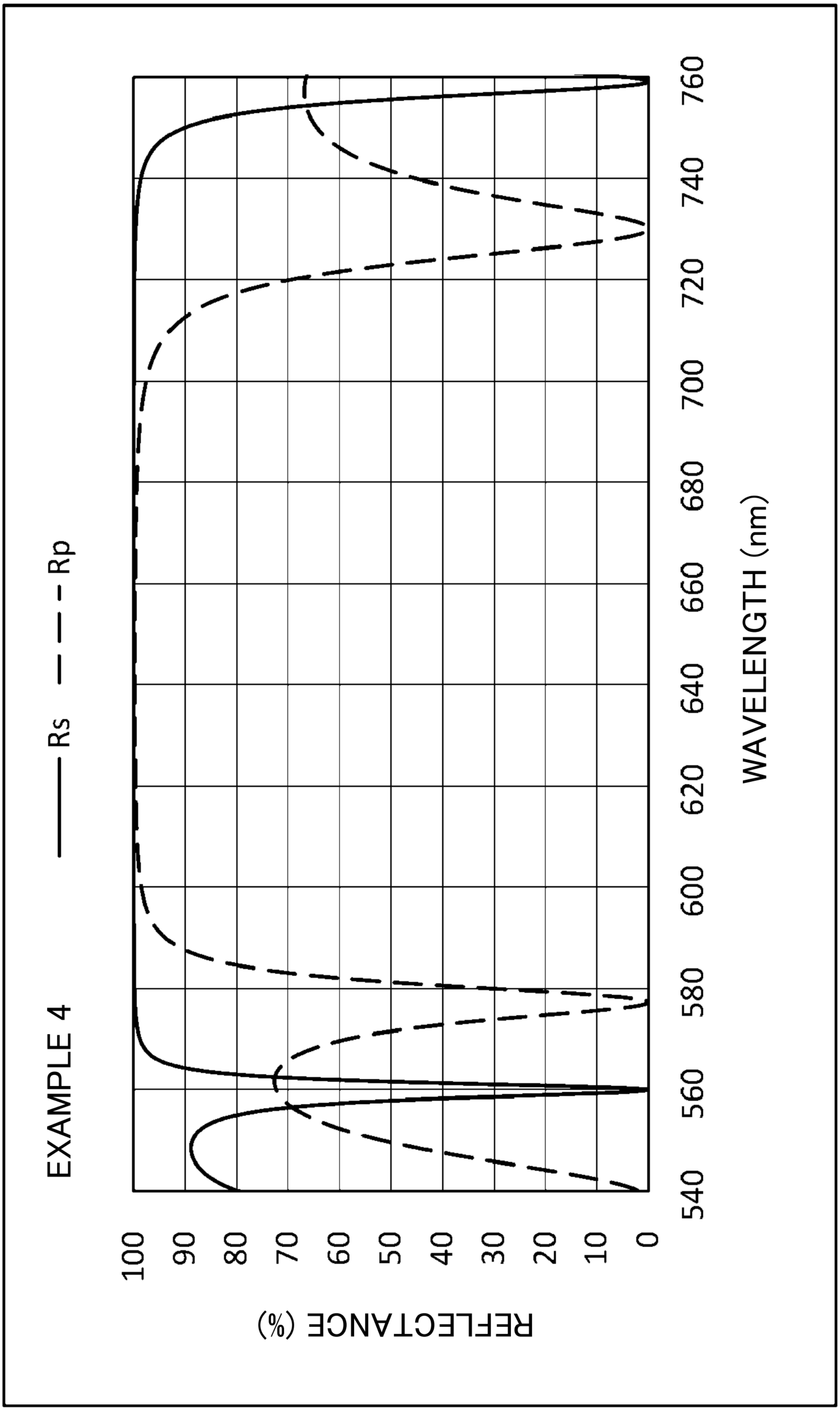
EXAMPLE 4
Rs
Rp
REFLECTANCE (%)
WAVELENGTH (nm)
100 90 80 70 60 50 40 30 20 10 0
540 560 580 600 620 640 660 680 700 720 740 760

FIG.6

FIG.7

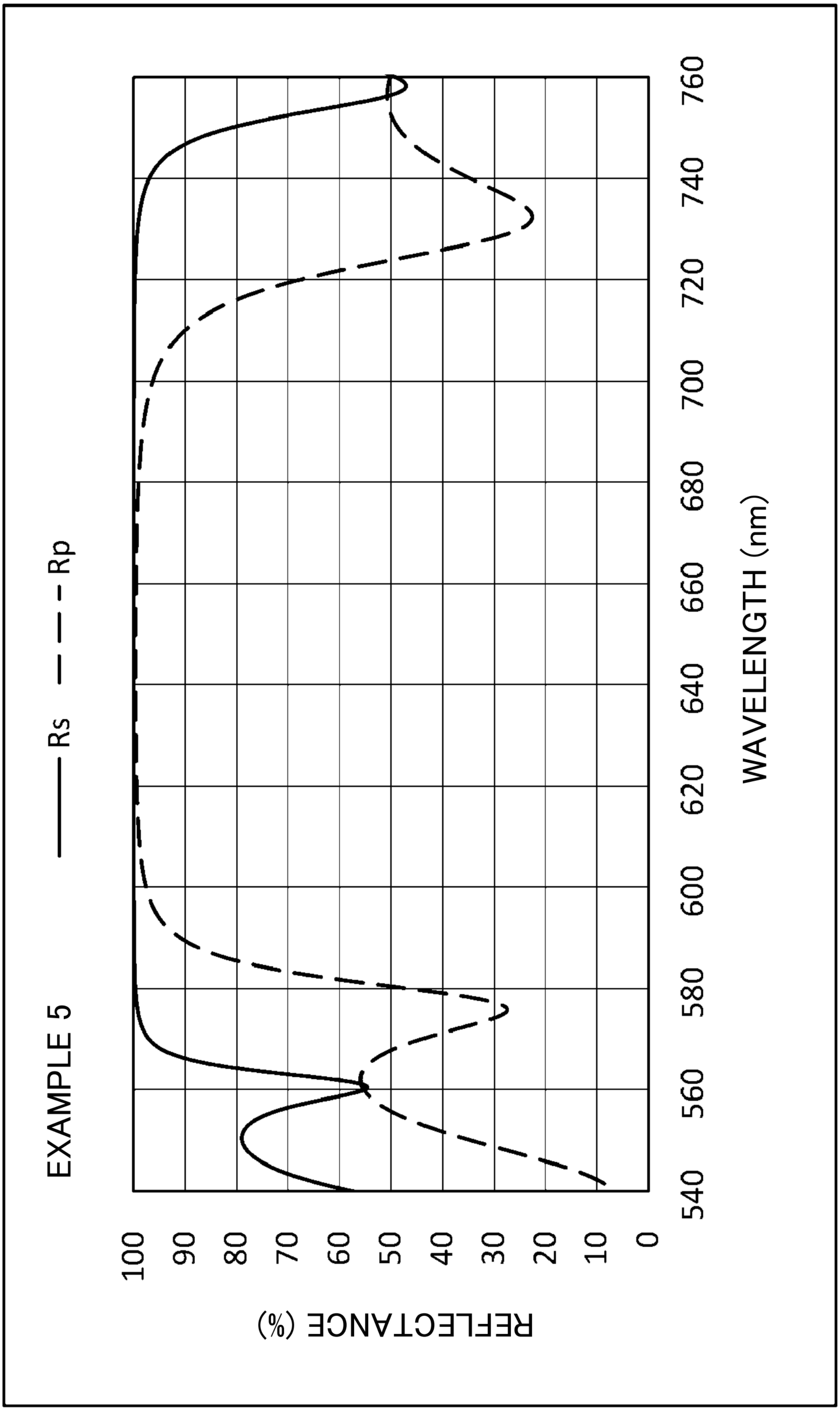
EXAMPLE 5
Rs
Rp
REFLECTANCE (%)
100
90
80
70
60
50
40
30
20
10
0
540
560
580
600
620
640
660
680
700
720
740
760
WAVELENGTH (nm)

FIG.8

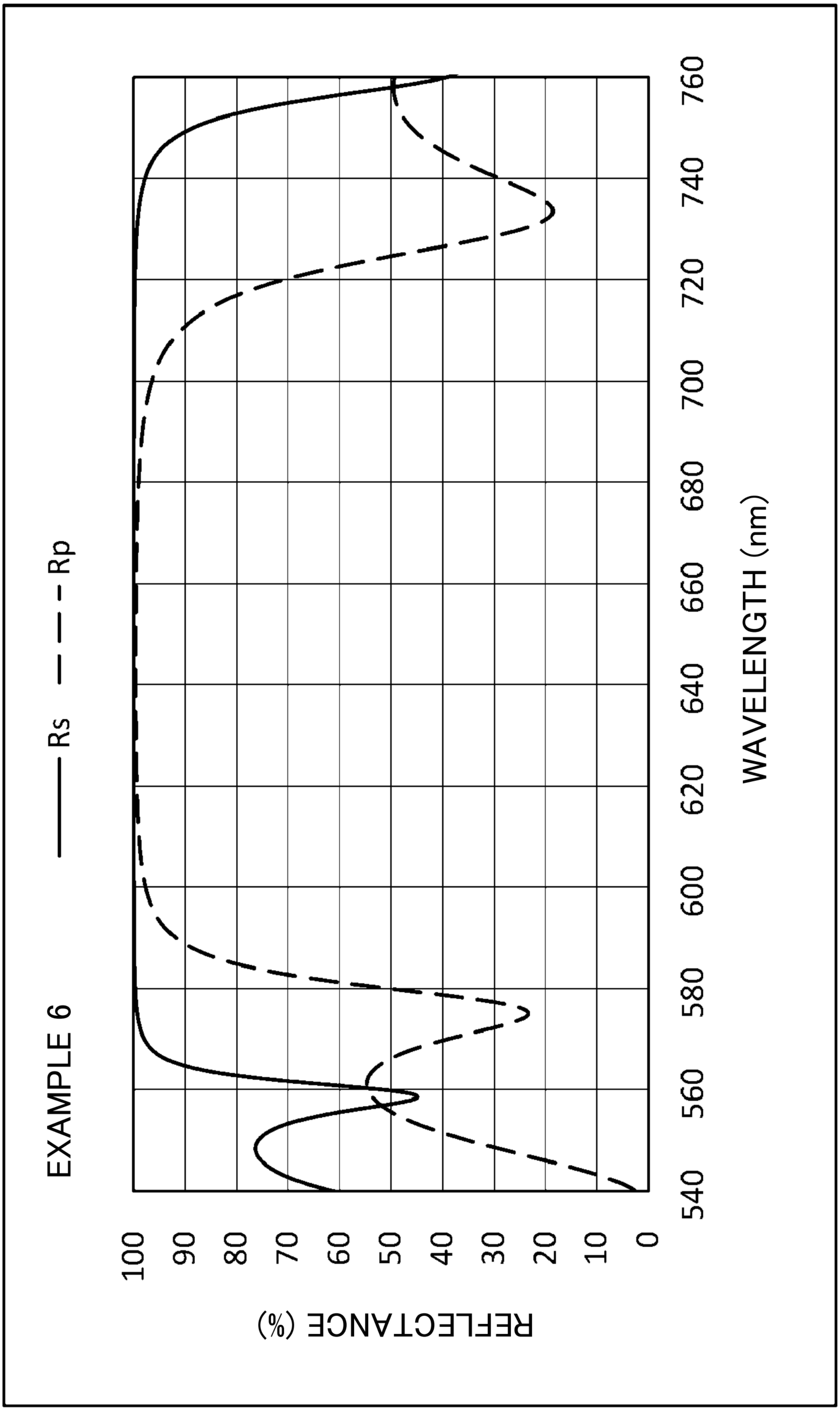
EXAMPLE 6
Rs
Rp
REFLECTANCE (%)
100
90
80
70
60
50
40
30
20
10
0
540
560
580
600
620
640
660
680
700
720
740
760
WAVELENGTH (nm)

FIG.9

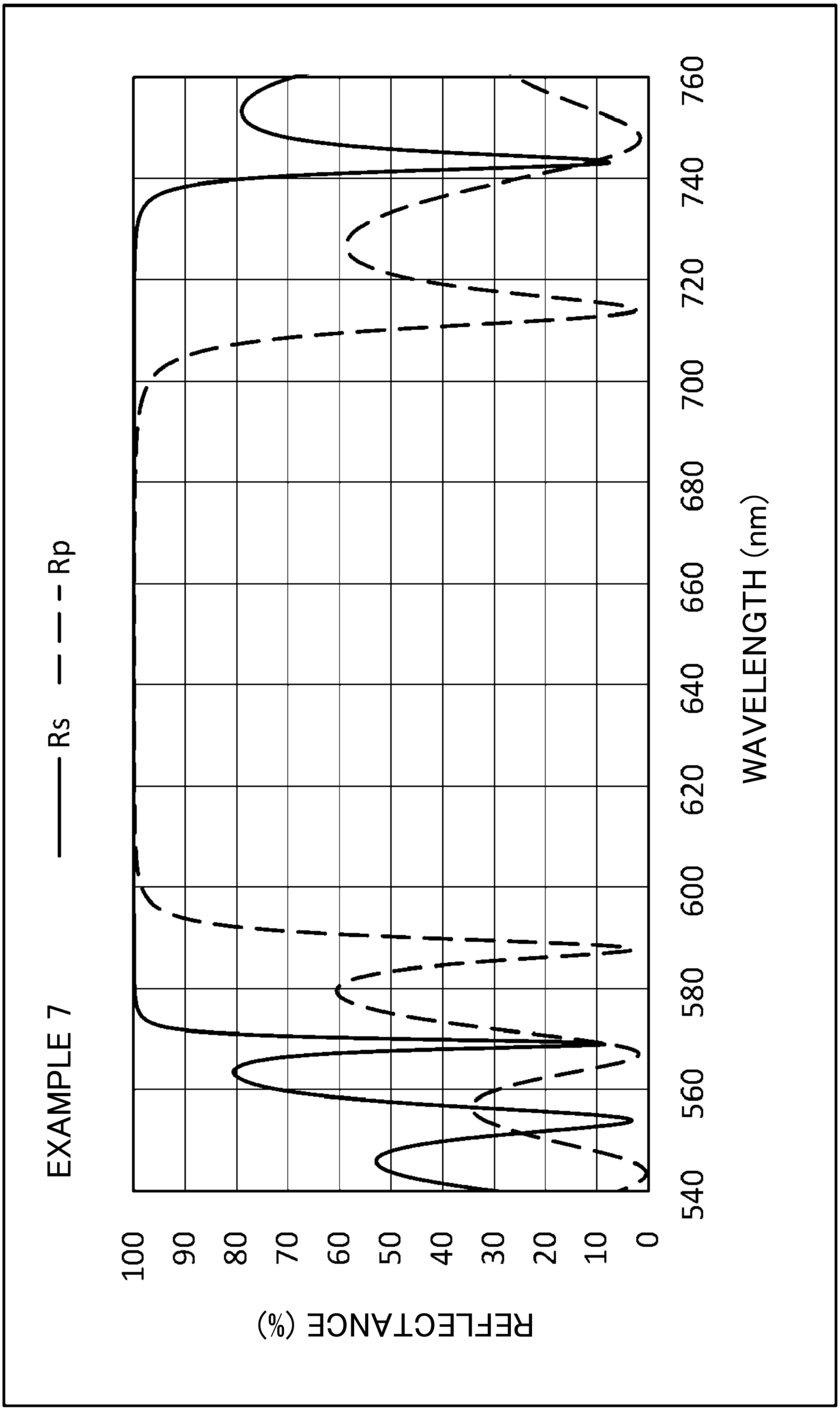
EXAMPLE 7
Rs
Rp
WAVELENGTH (nm)
REFLECTANCE (%)
540
560
580
600
620
640
660
680
700
720
740
760
100
90
80
70
60
50
40
30
20
10
0

FIG.10

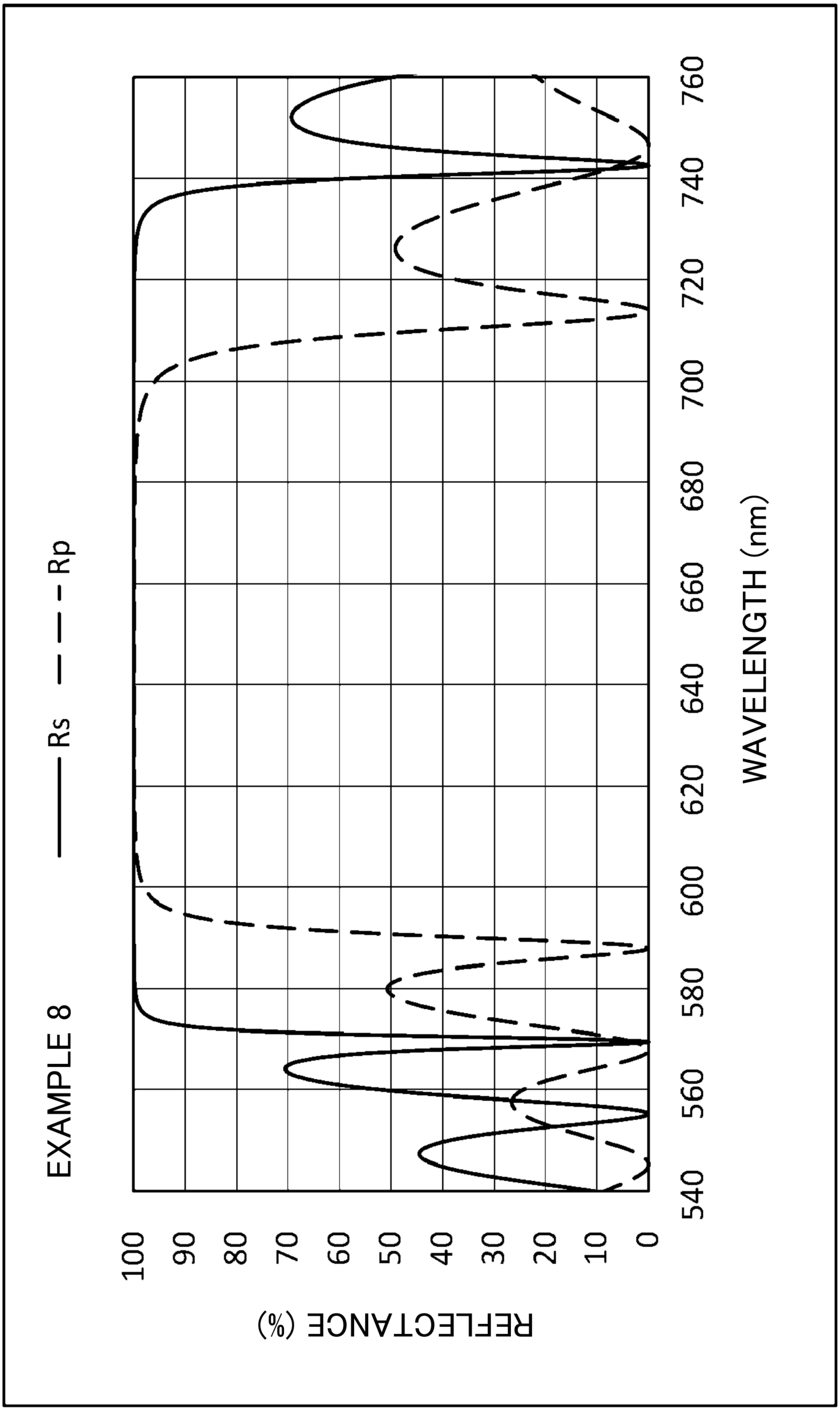
EXAMPLE 8
Rs
Rp
REFLECTANCE (%)
100
90
80
70
60
50
40
30
20
10
0
540
560
580
600
620
640
660
680
700
720
740
760
WAVELENGTH (nm)

FIG.11

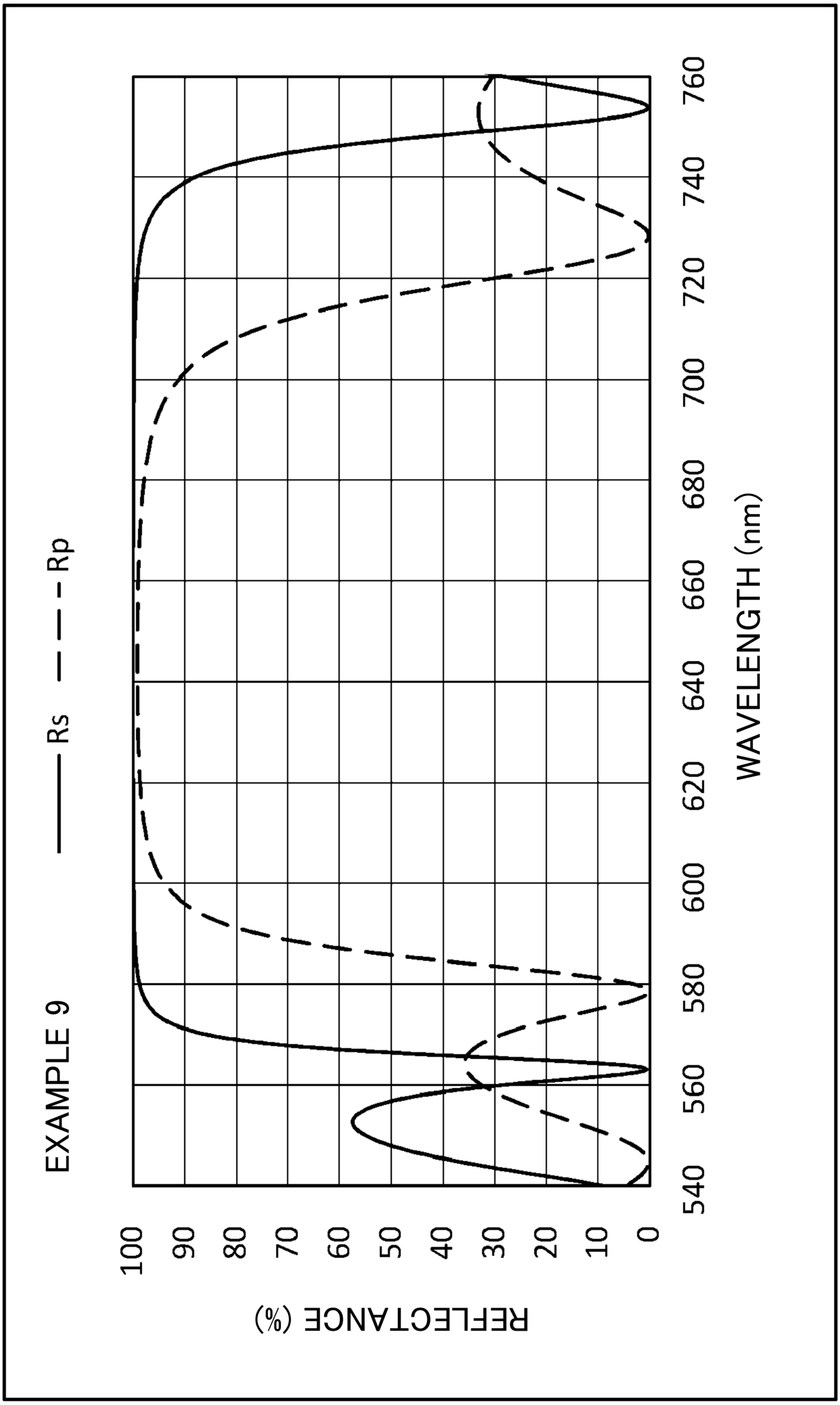
EXAMPLE 9
Rs
Rp
REFLECTANCE (%)
100
90
80
70
60
50
40
30
20
10
0
540
560
580
600
620
640
660
680
700
720
740
760
WAVELENGTH (nm)

FIG.12

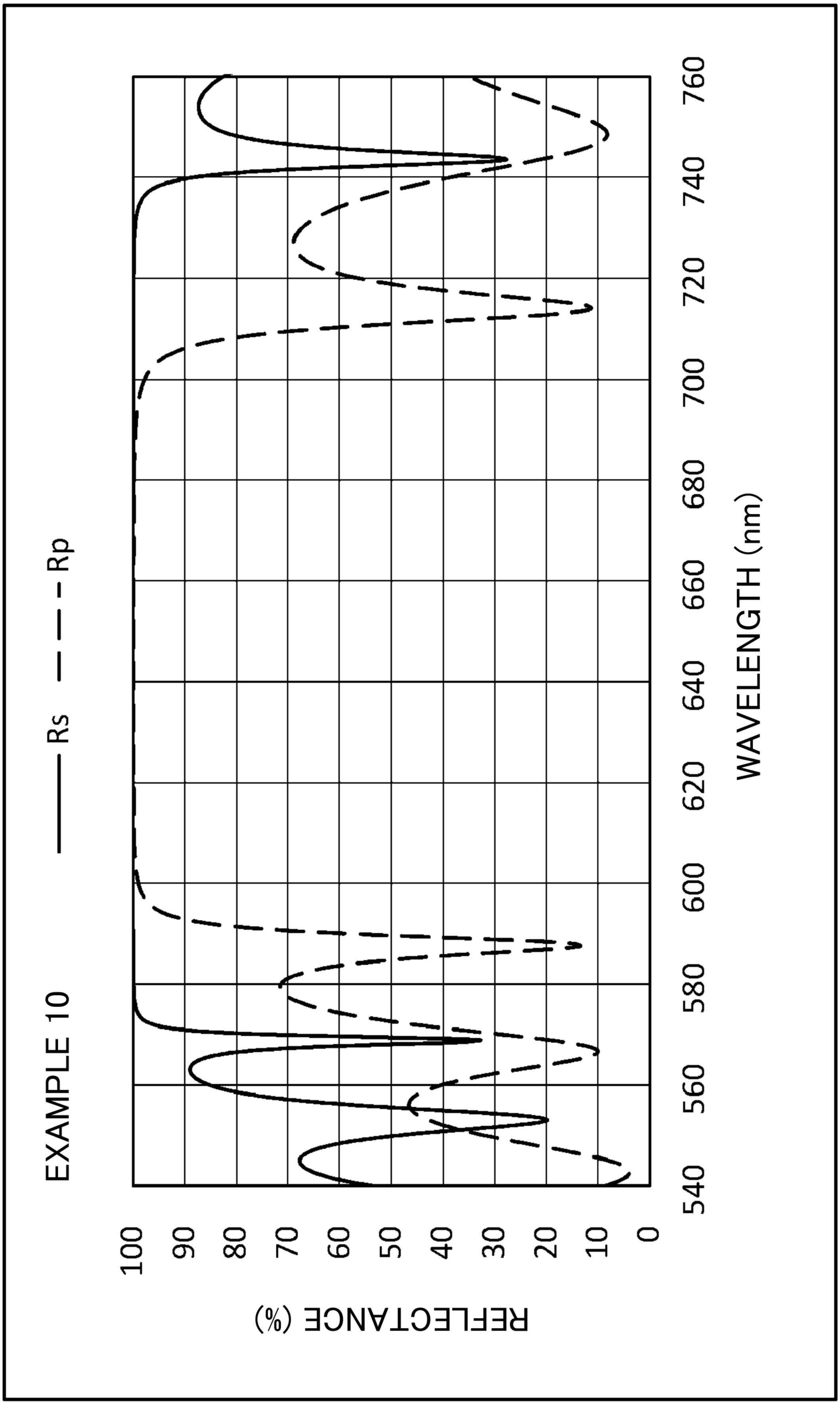
EXAMPLE 10
Rs
Rp
REFLECTANCE (%)
100
90
80
70
60
50
40
30
20
10
0
540
560
580
600
620
640
660
680
700
720
740
760
WAVELENGTH (nm)

FIG.13

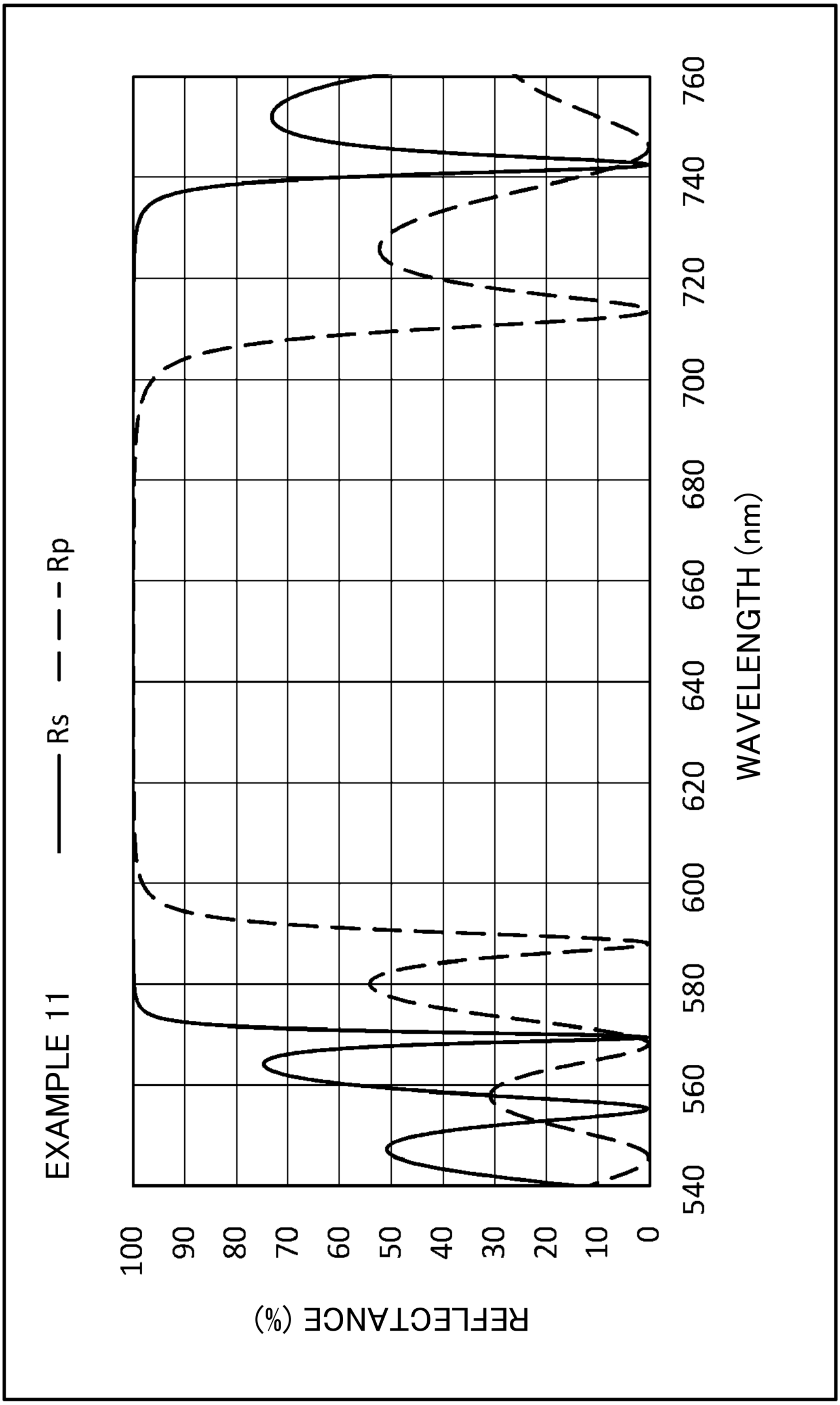
EXAMPLE 11
Rs
Rp
REFLECTANCE (%)
100
90
80
70
60
50
40
30
20
10
0
540
560
580
600
620
640
660
680
700
720
740
760
WAVELENGTH (nm)

FIG.14

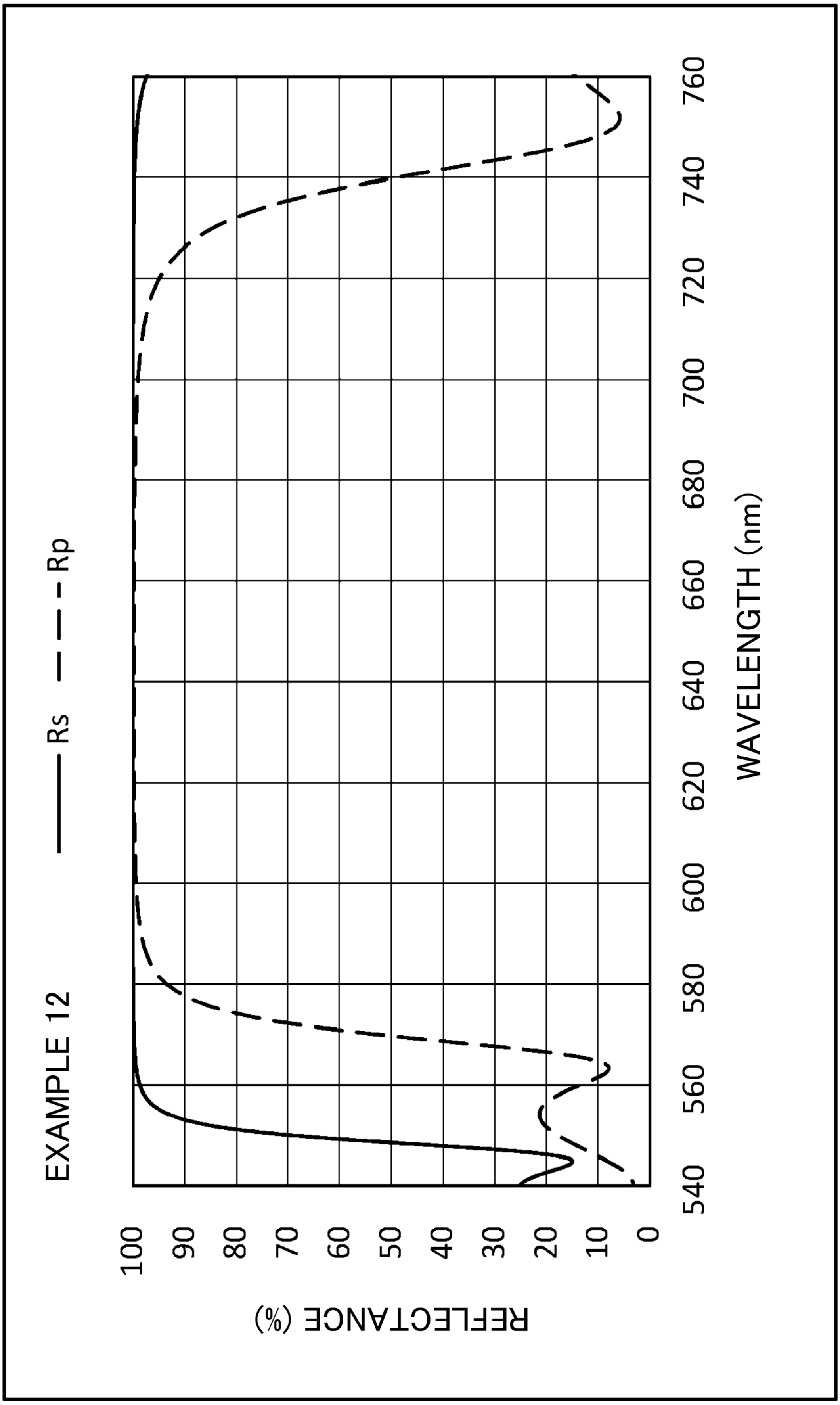
EXAMPLE 12
Rs
Rp
REFLECTANCE (%)
100
90
80
70
60
50
40
30
20
10
0
540
560
580
600
620
640
660
680
700
720
740
760
WAVELENGTH (nm)

FIG.15

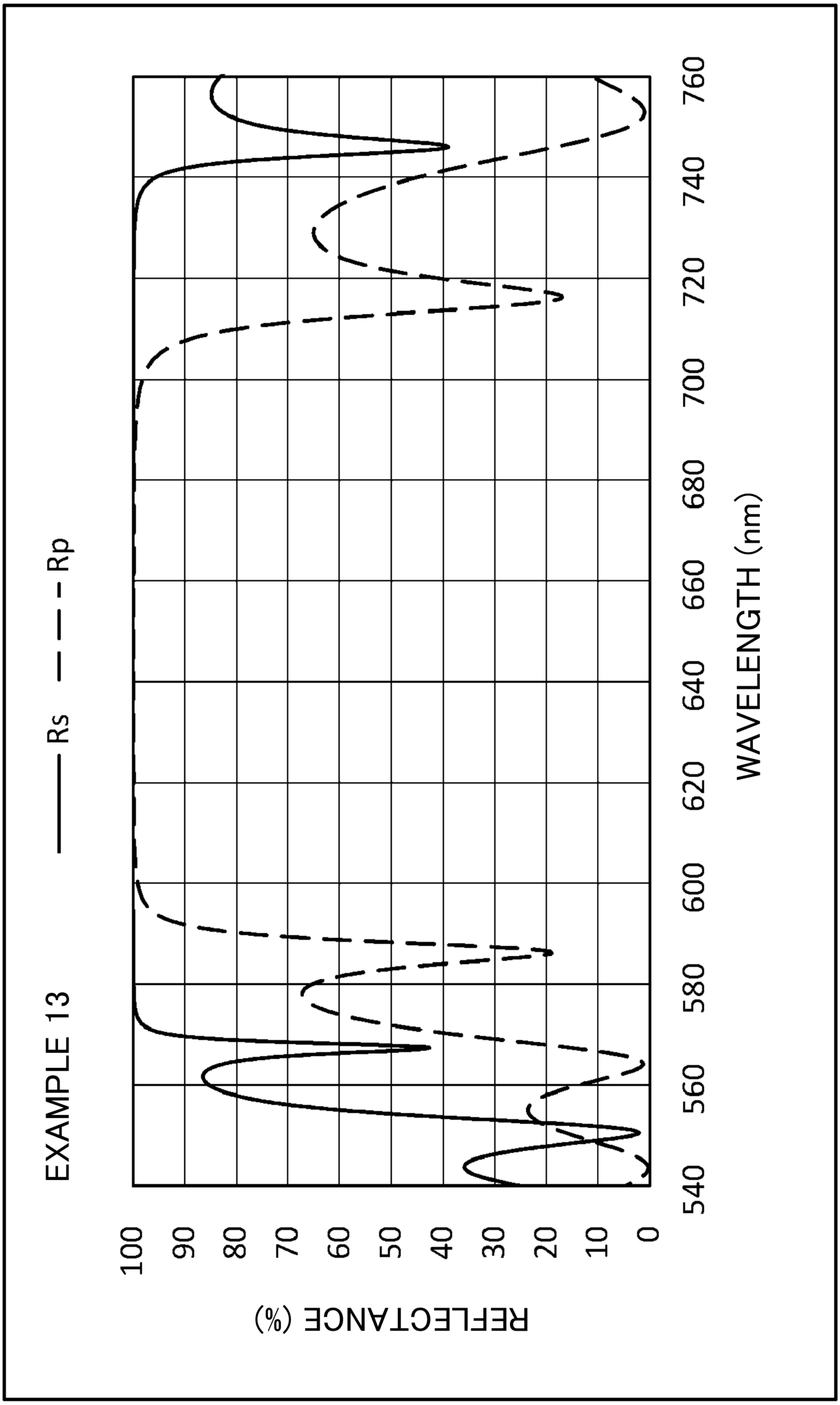
EXAMPLE 13
Rs
Rp
REFLECTANCE (%)
100
90
80
70
60
50
40
30
20
10
0
540
560
580
600
620
640
660
680
700
720
740
760
WAVELENGTH (nm)

FIG.16

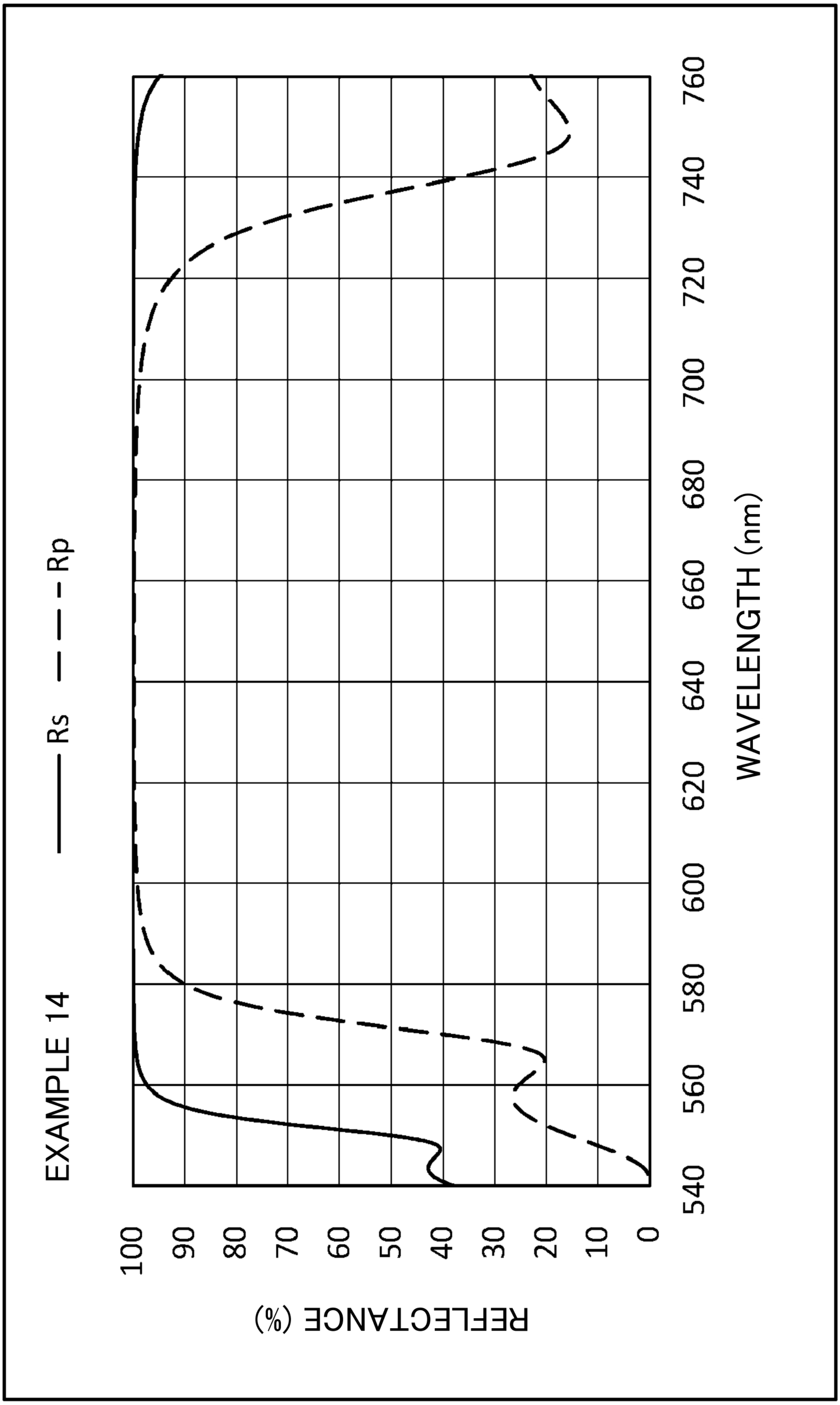
EXAMPLE 14
Rs
Rp
REFLECTANCE (%)
100
90
80
70
60
50
40
30
20
10
0
540
560
580
600
620
640
660
680
700
720
740
760
WAVELENGTH (nm)

FIG.17

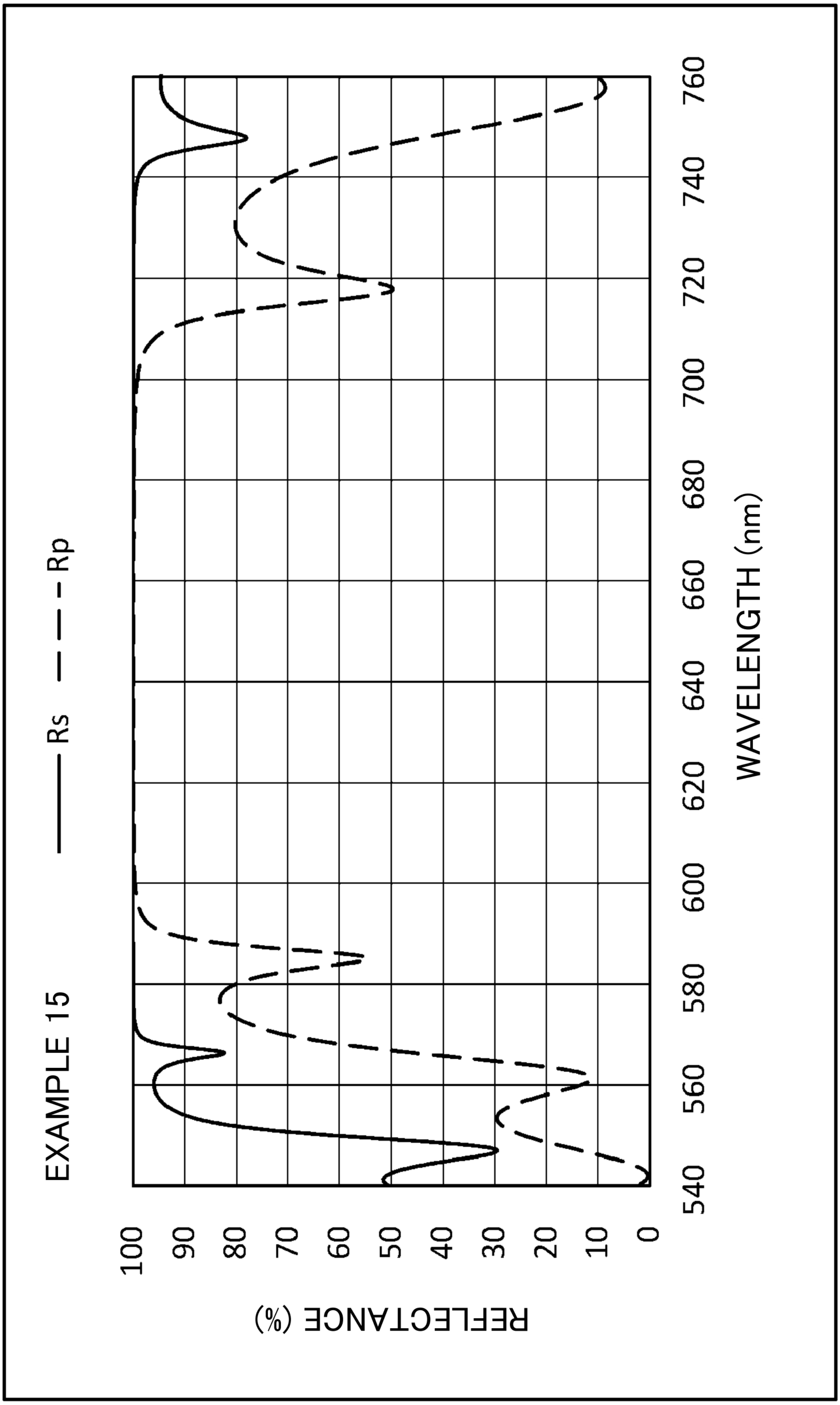
EXAMPLE 15
Rs
Rp
REFLECTANCE (%)
100
90
80
70
60
50
40
30
20
10
0
540
560
580
600
620
640
660
680
700
720
740
760
WAVELENGTH (nm)

FIG.18

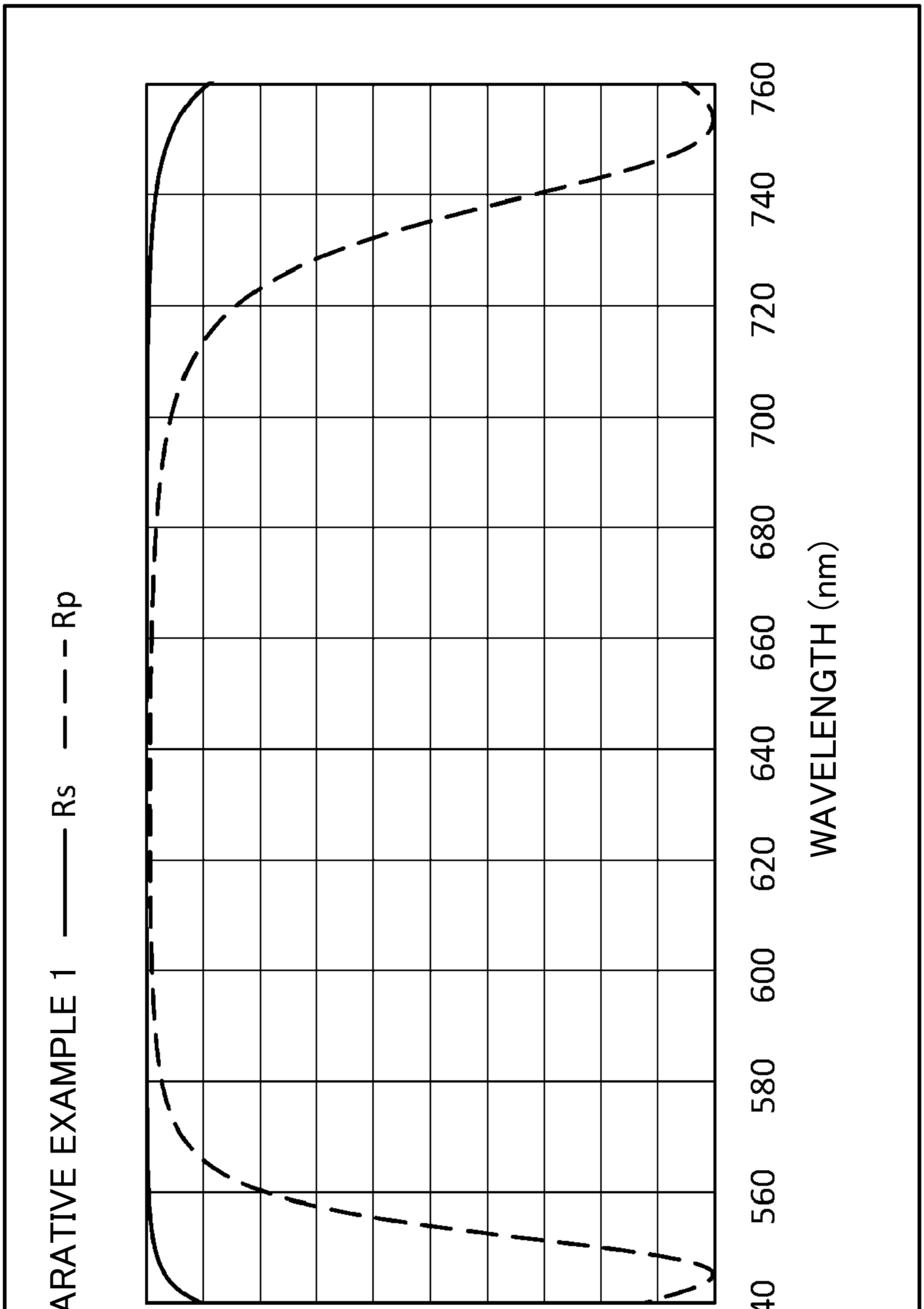
COMPARATIVE EXAMPLE 1
Rs
Rp
REFLECTANCE (%)
100
90
80
70
60
50
40
30
20
10
0
540
560
580
600
620
640
660
680
700
720
740
760
WAVELENGTH (nm)

FIG.19

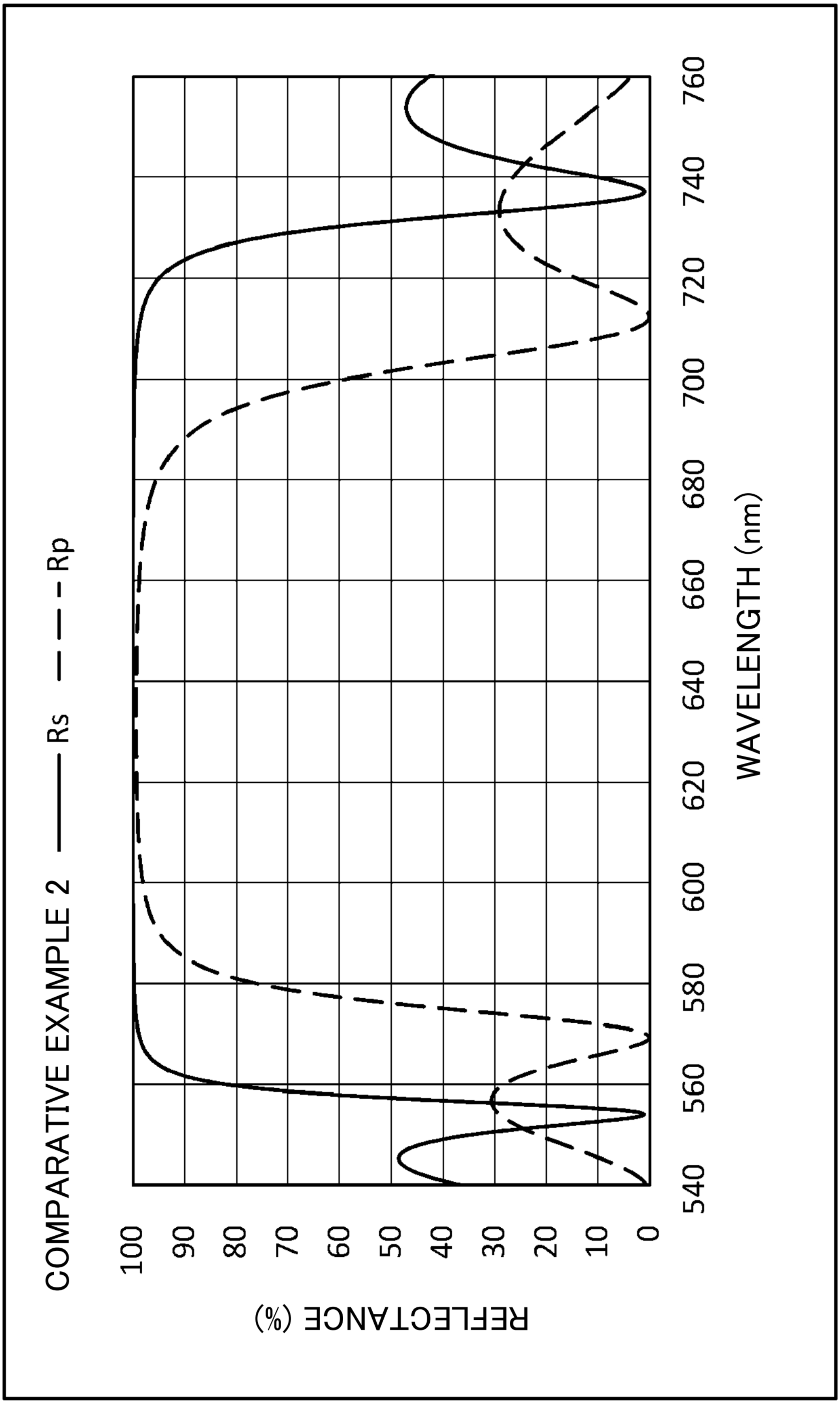
COMPARATIVE EXAMPLE 2
Rs
Rp
REFLECTANCE (%)
100
90
80
70
60
50
40
30
20
10
0
540
560
580
600
620
640
660
680
700
720
740
760
WAVELENGTH (nm)

FIG.20

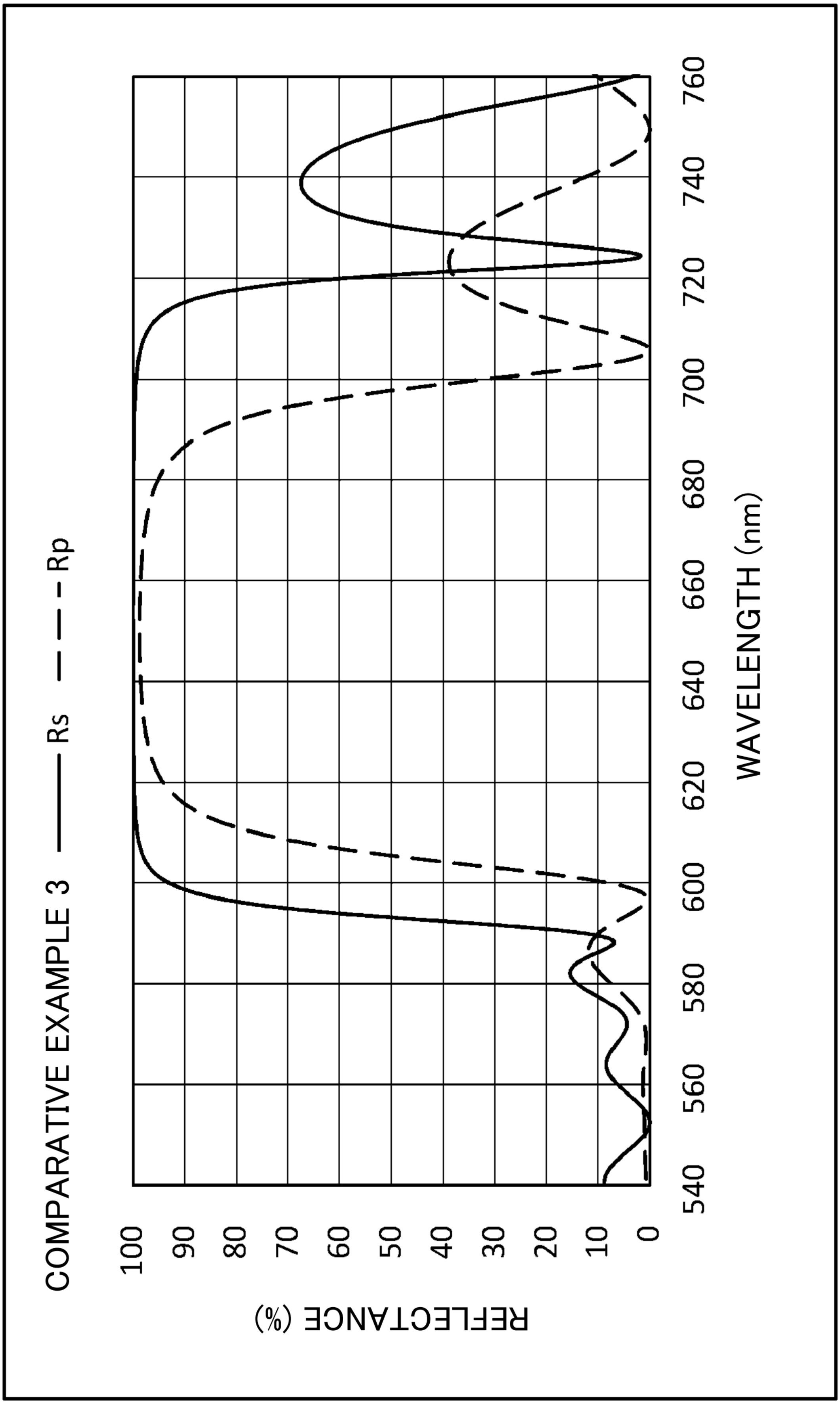
COMPARATIVE EXAMPLE 3
Rs
Rp
REFLECTANCE (%)
100
90
80
70
60
50
40
30
20
10
0
540
560
580
600
620
640
660
680
700
720
740
760
WAVELENGTH (nm)

FIG.21

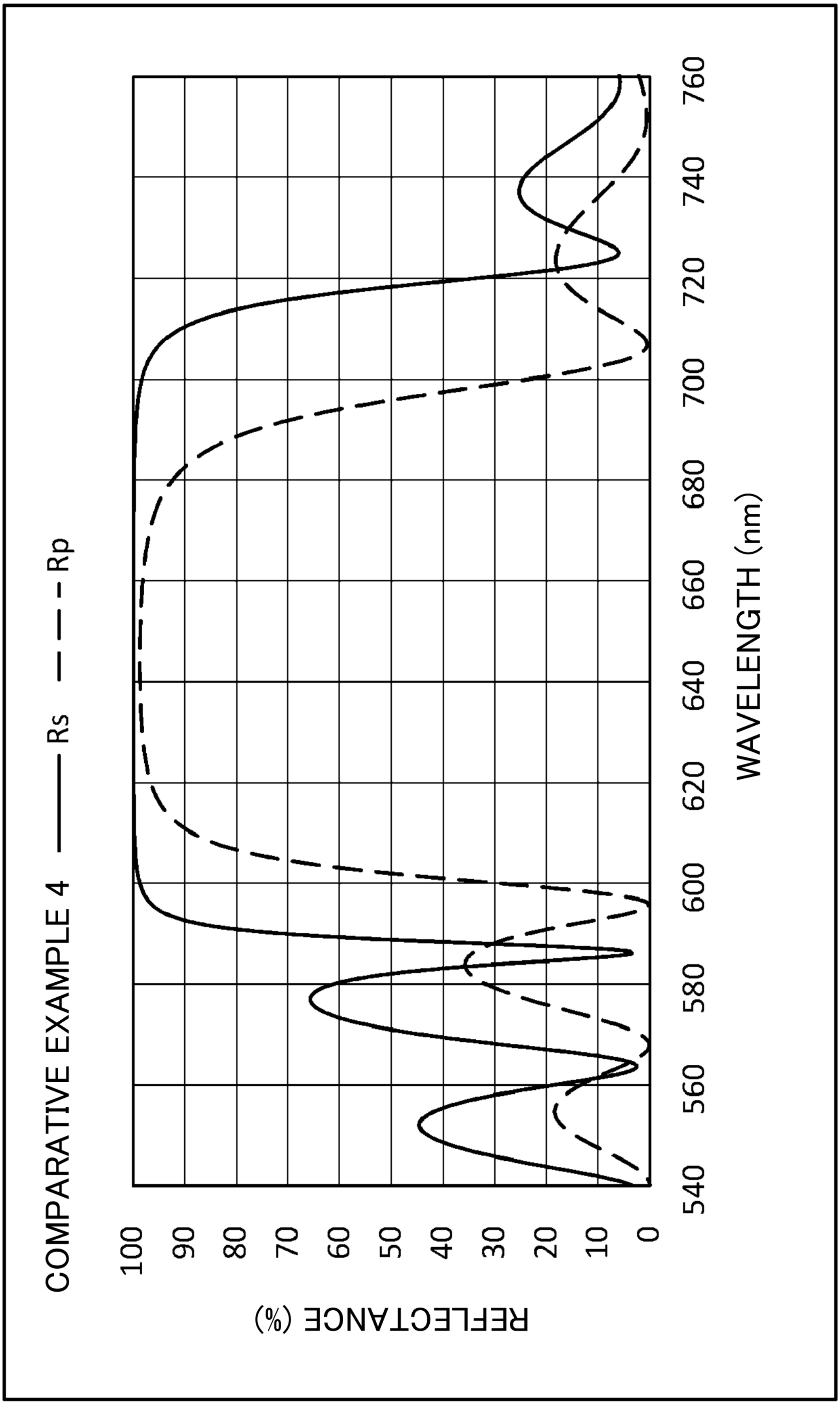
COMPARATIVE EXAMPLE 4
Rs
Rp
REFLECTANCE (%)
100
90
80
70
60
50
40
30
20
10
0
540
560
580
600
620
640
660
680
700
720
740
760
WAVELENGTH (nm)

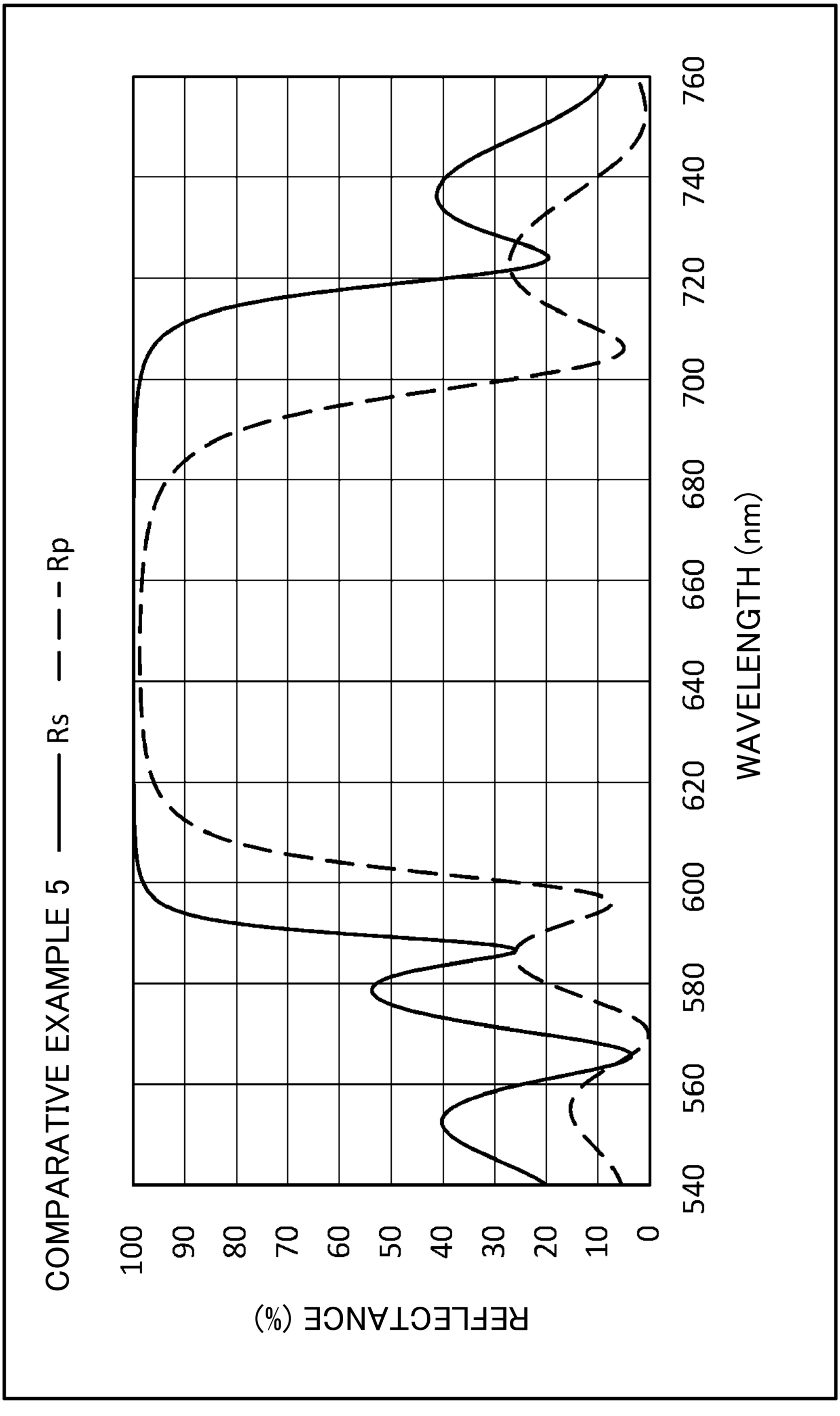
COMPARATIVE EXAMPLE 5
Rs
Rp
REFLECTANCE (%)
100
90
80
70
60
50
40
30
20
10
0
540
560
580
600
620
640
660
680
700
720
740
760
WAVELENGTH (nm)

FIG.22

FIG.23

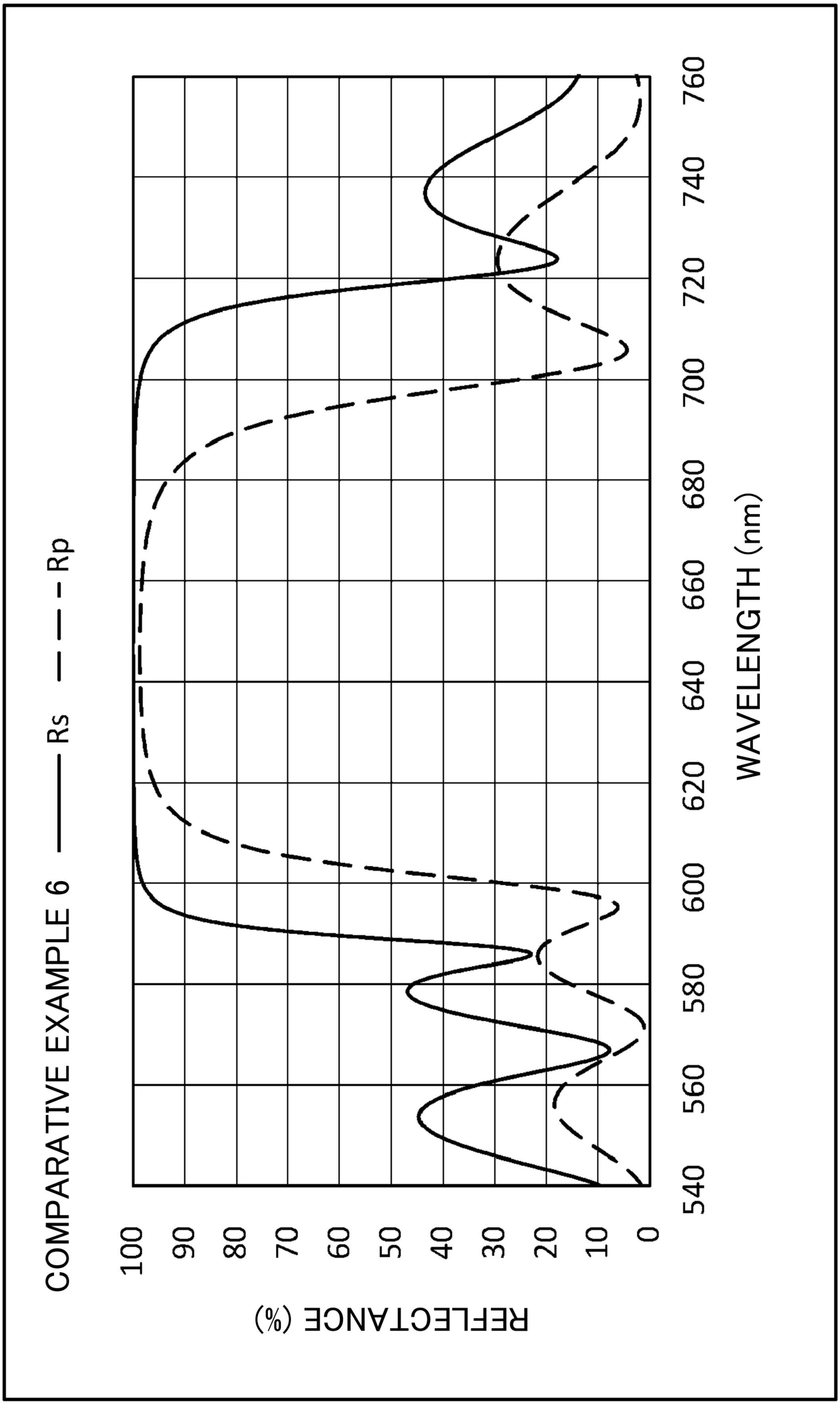
COMPARATIVE EXAMPLE 6
Rs
Rp
REFLECTANCE (%)
100
90
80
70
60
50
40
30
20
10
0
540
560
580
600
620
640
660
680
700
720
740
760
WAVELENGTH (nm)

FIG.24

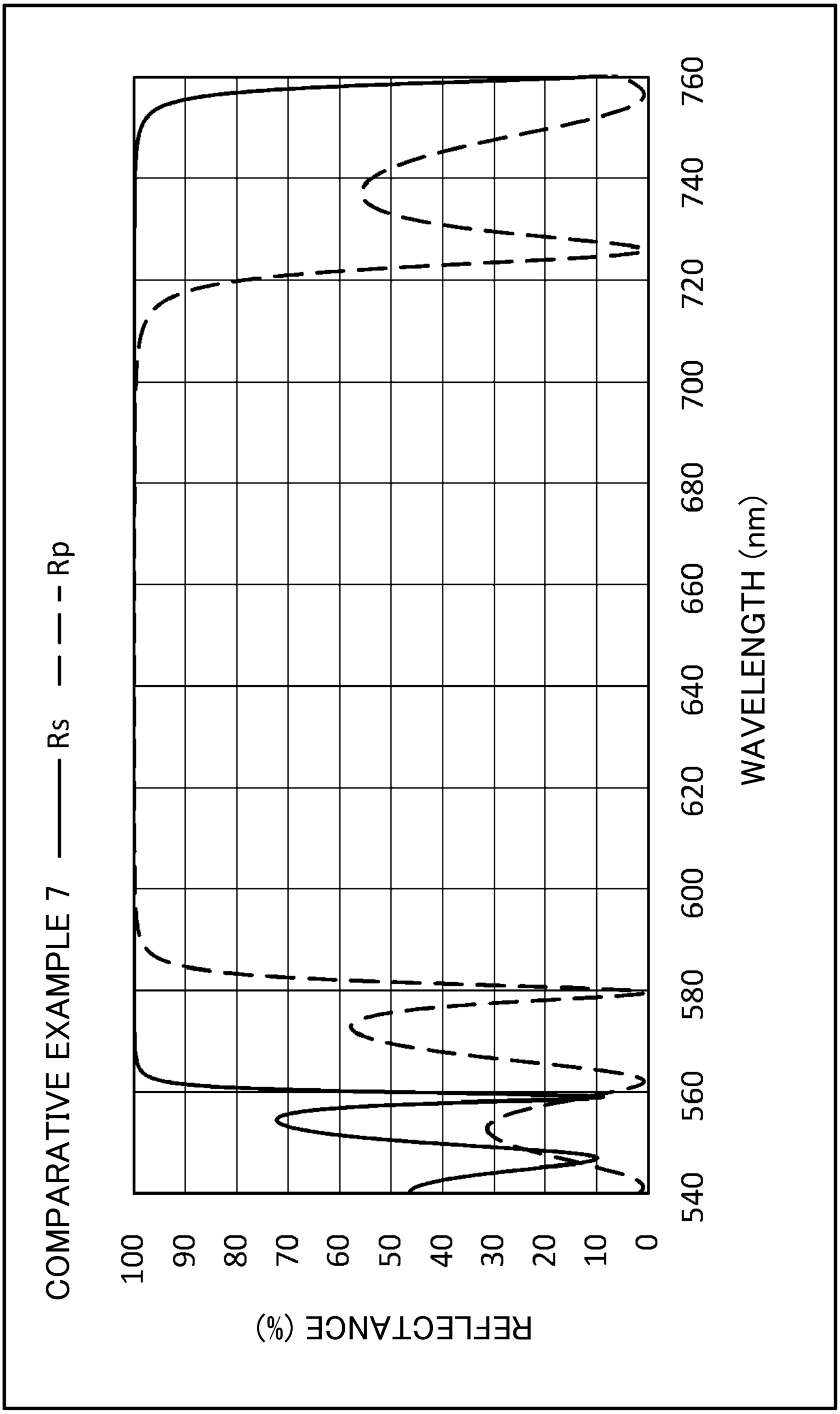
COMPARATIVE EXAMPLE 7
Rs
Rp
REFLECTANCE (%)
100
90
80
70
60
50
40
30
20
10
0
540
560
580
600
620
640
660
680
700
720
740
760
WAVELENGTH (nm)

FIG.25

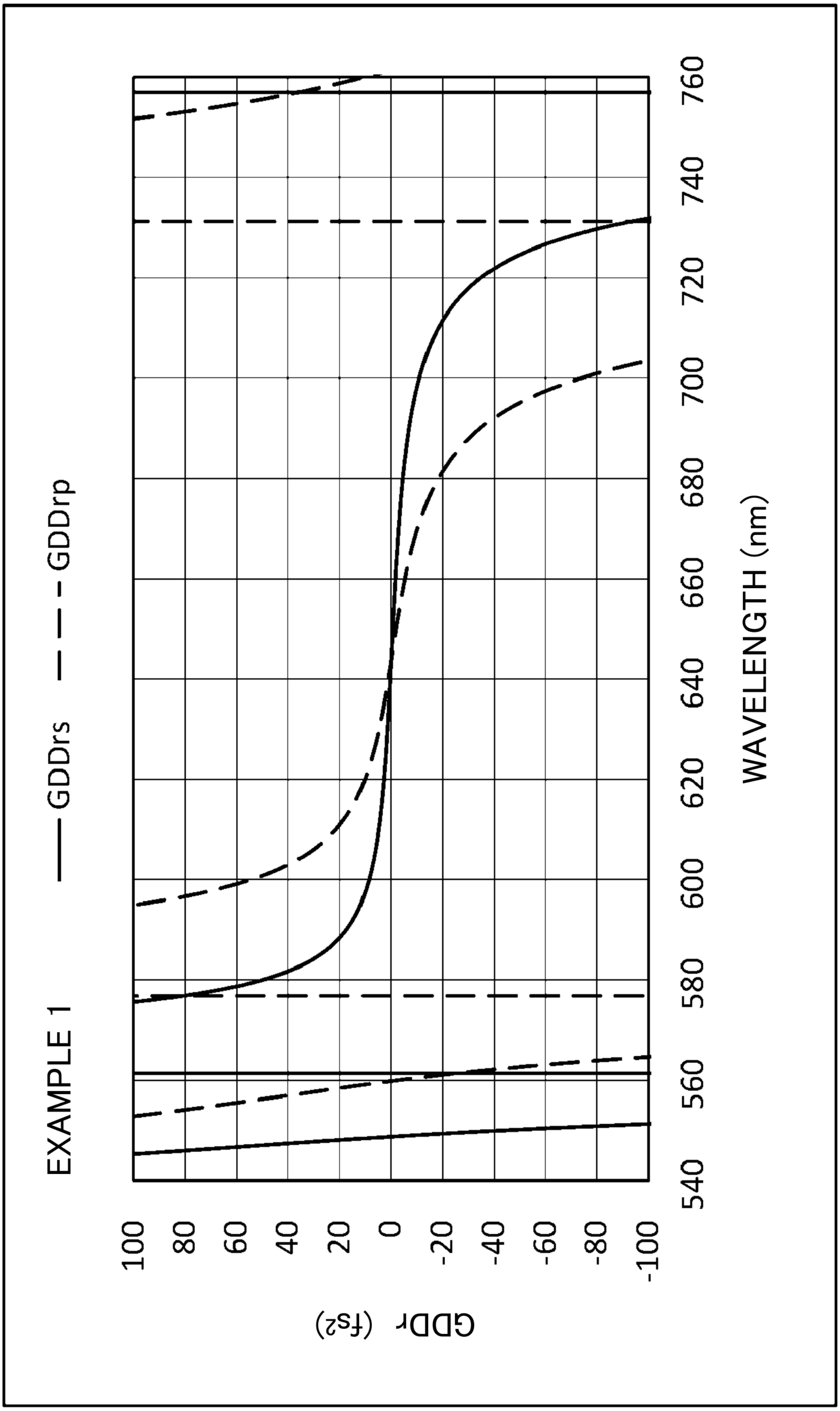
EXAMPLE 1
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.26

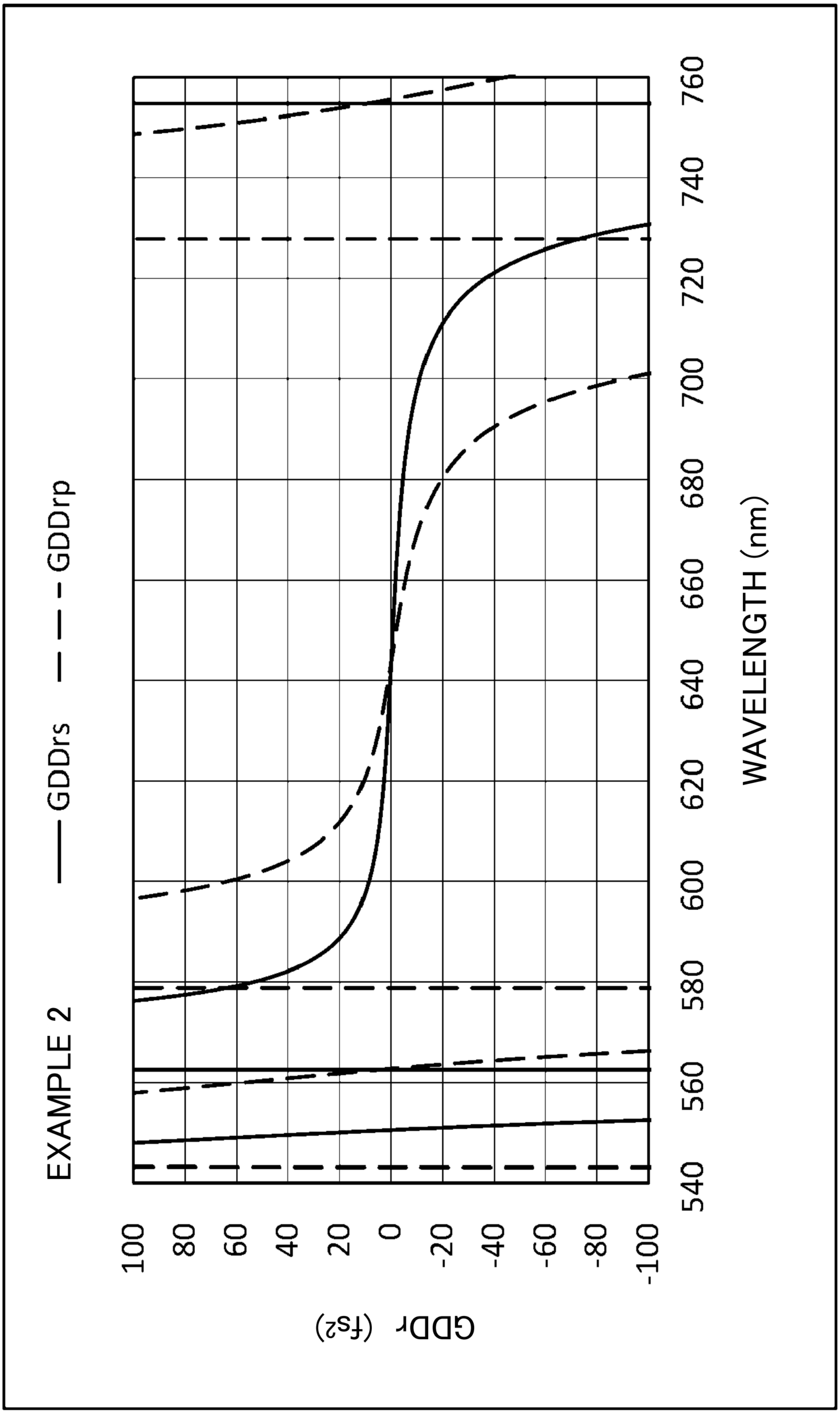
EXAMPLE 2
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.27

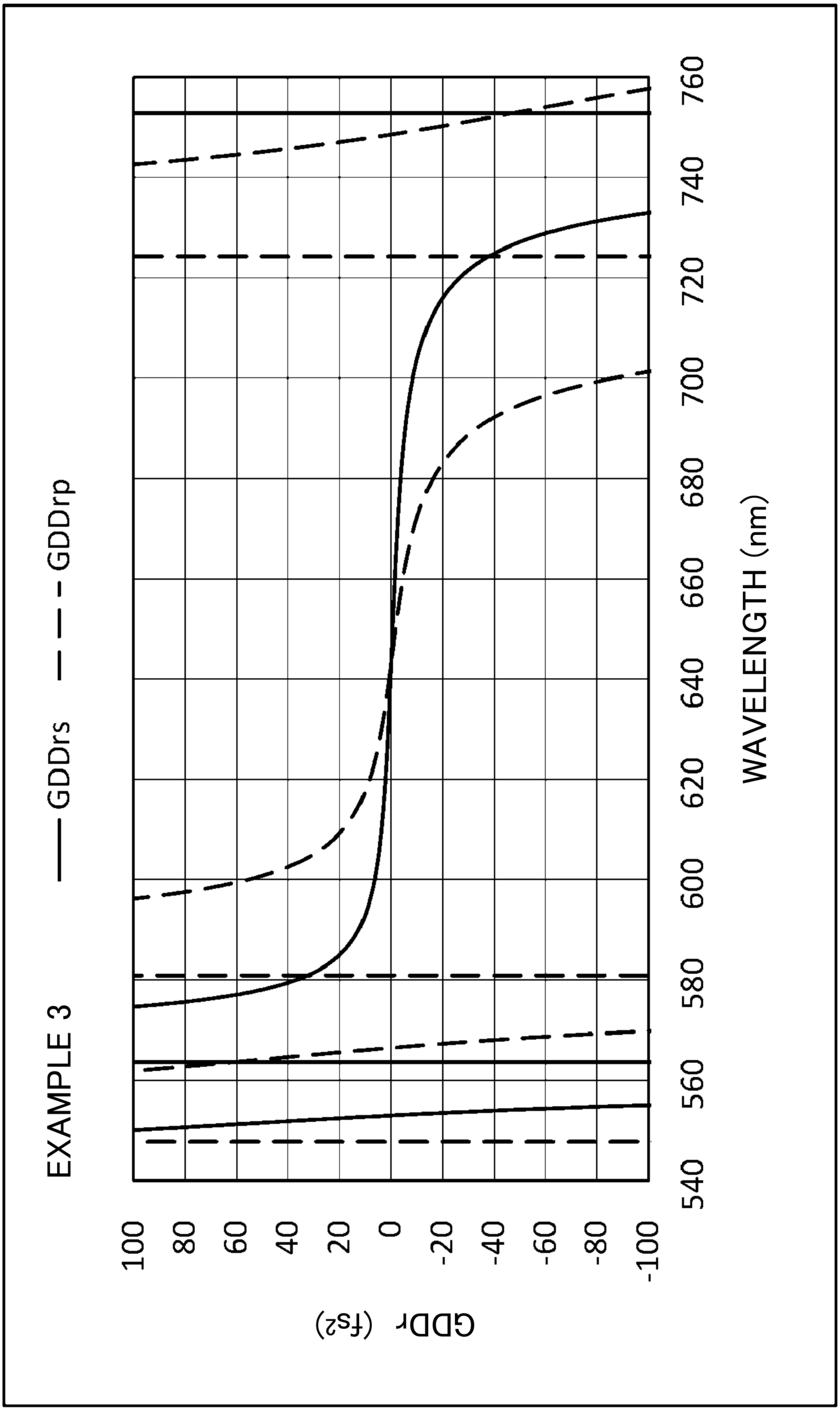
EXAMPLE 3
GDDrs
GDDrp
100
80
60
40
20
0
-20
-40
-60
-80
-100
GDDr (fs2)
540
560
580
600
620
640
660
680
700
720
740
760
WAVELENGTH (nm)

FIG.28

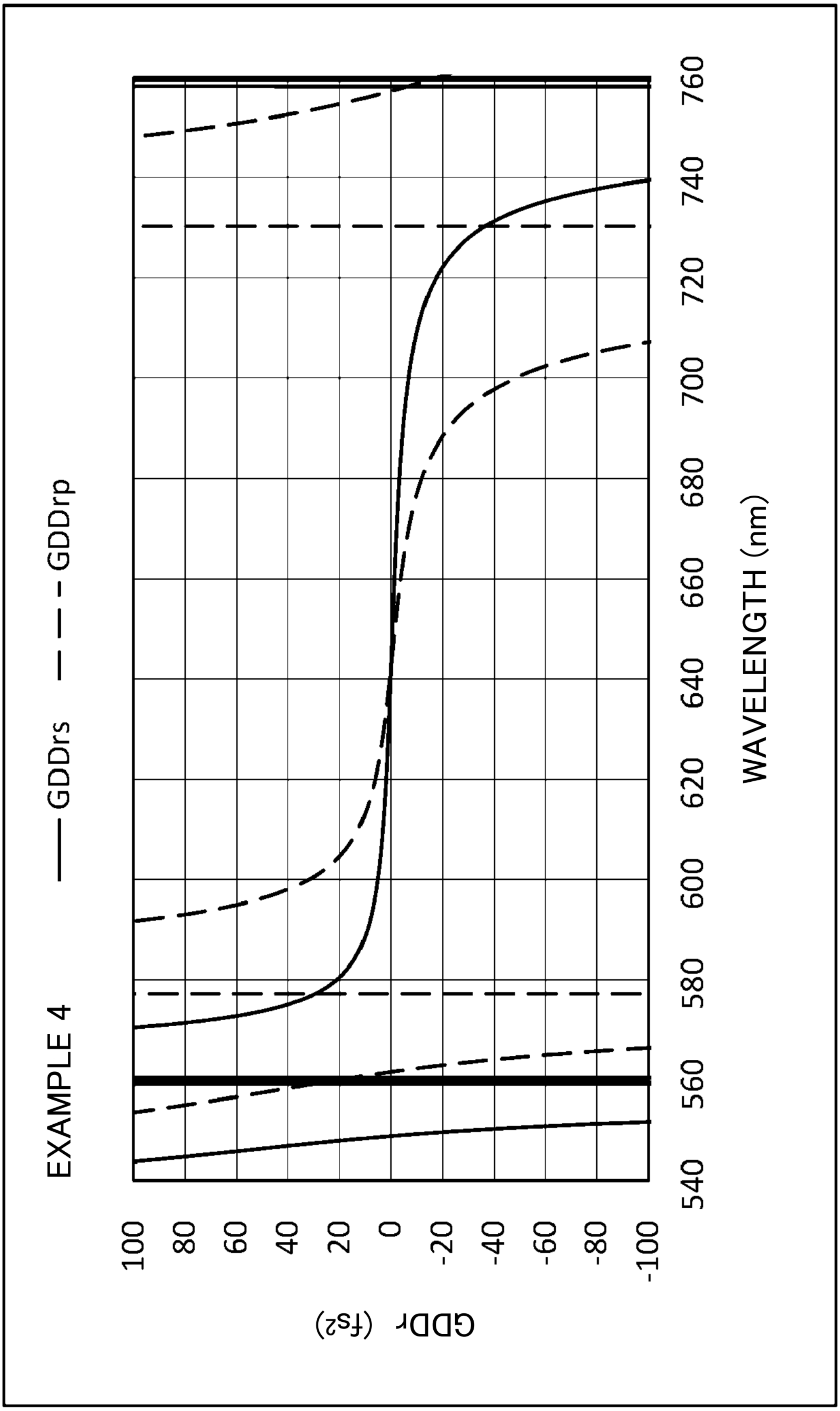
EXAMPLE 4
GDDrs
GDDrp
GDDr (fs2)
WAVELENGTH (nm)
100
80
60
40
20
0
-20
-40
-60
-80
-100
540
560
580
600
620
640
660
680
700
720
740
760

FIG.29

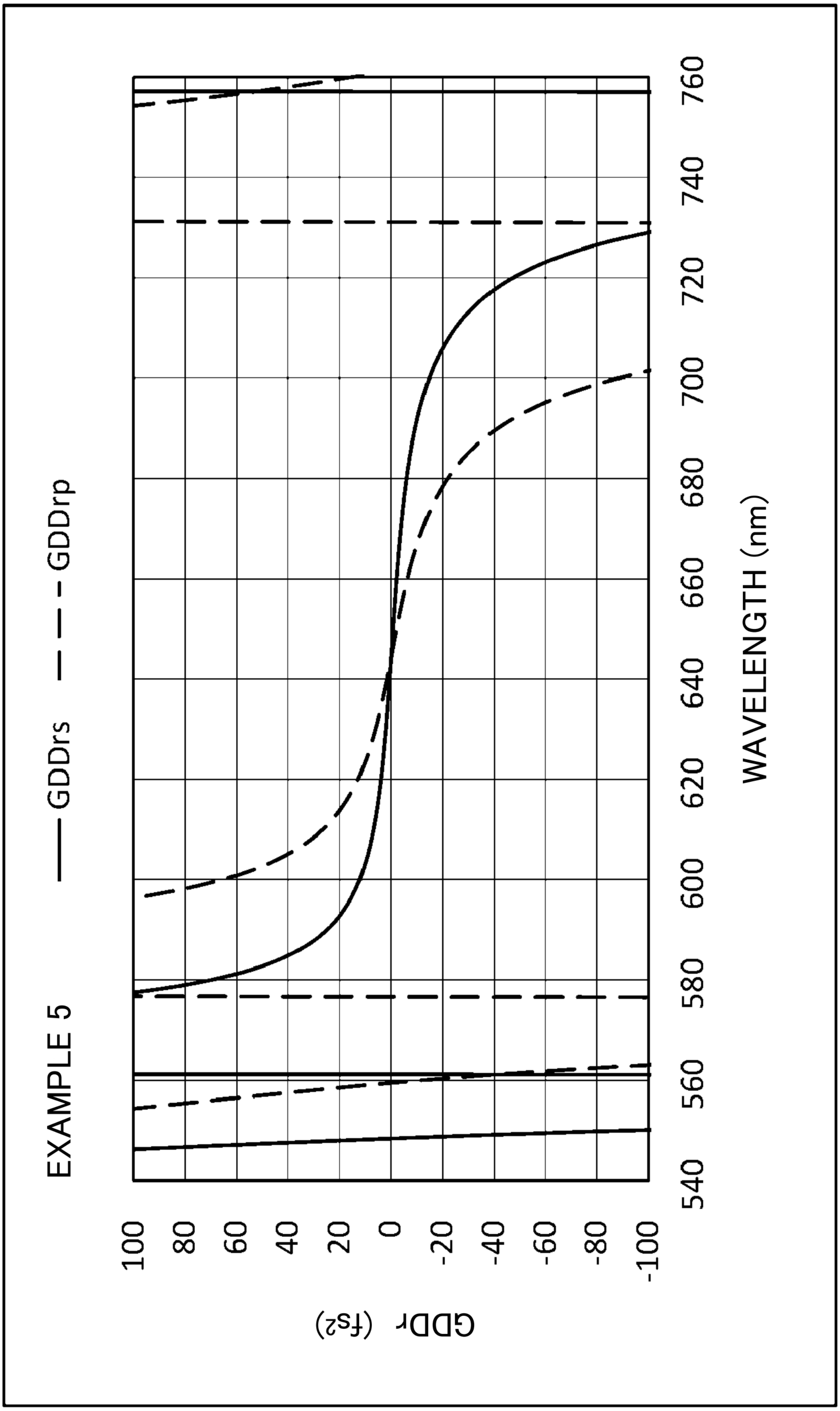
EXAMPLE 5
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.30

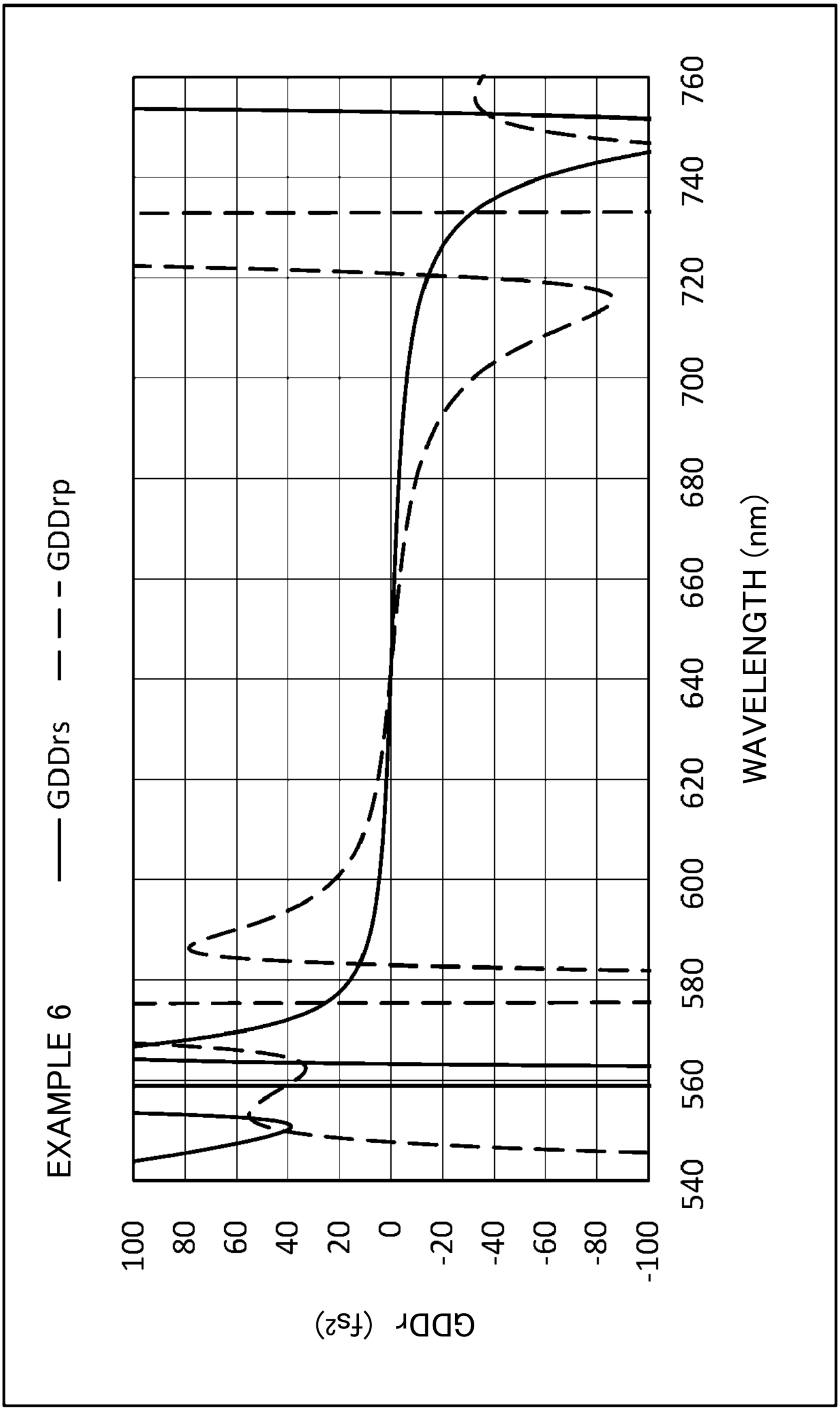
EXAMPLE 6
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.31

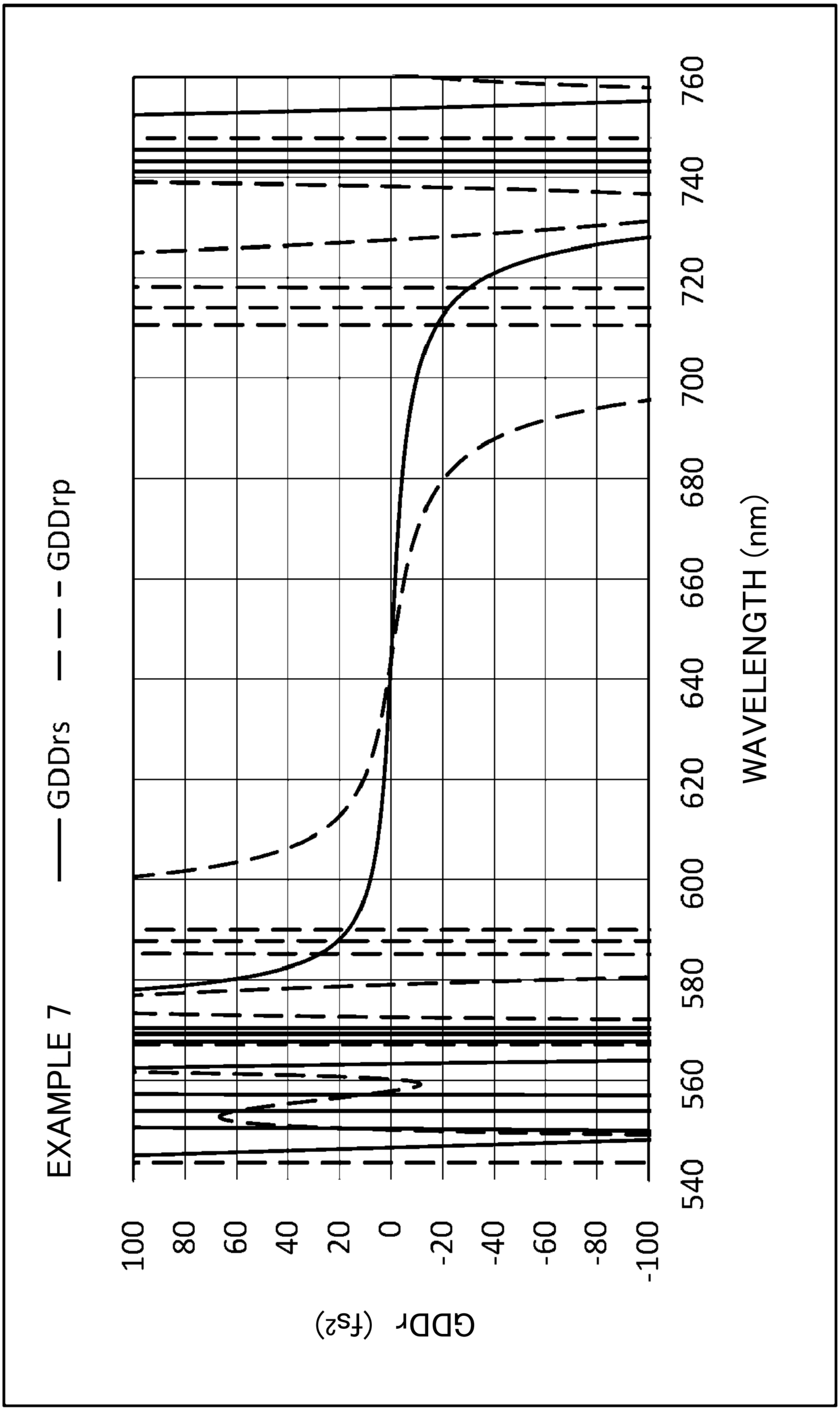
EXAMPLE 7
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.32

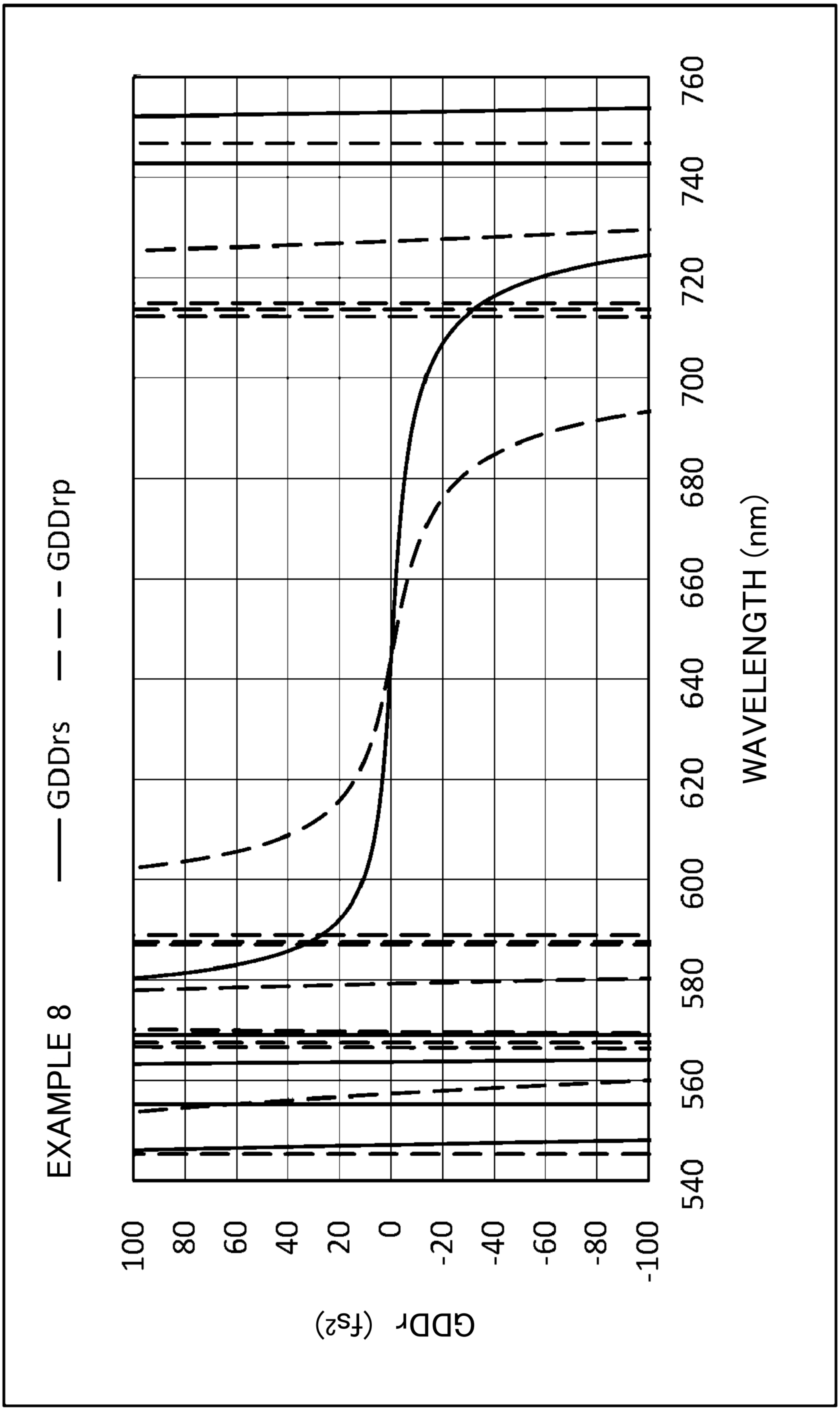
EXAMPLE 8
GDDrs
GDDrp
100
80
60
40
20
0
-20
-40
-60
-80
-100
GDDr (fs2)
540
560
580
600
620
640
660
680
700
720
740
760
WAVELENGTH (nm)

FIG.33

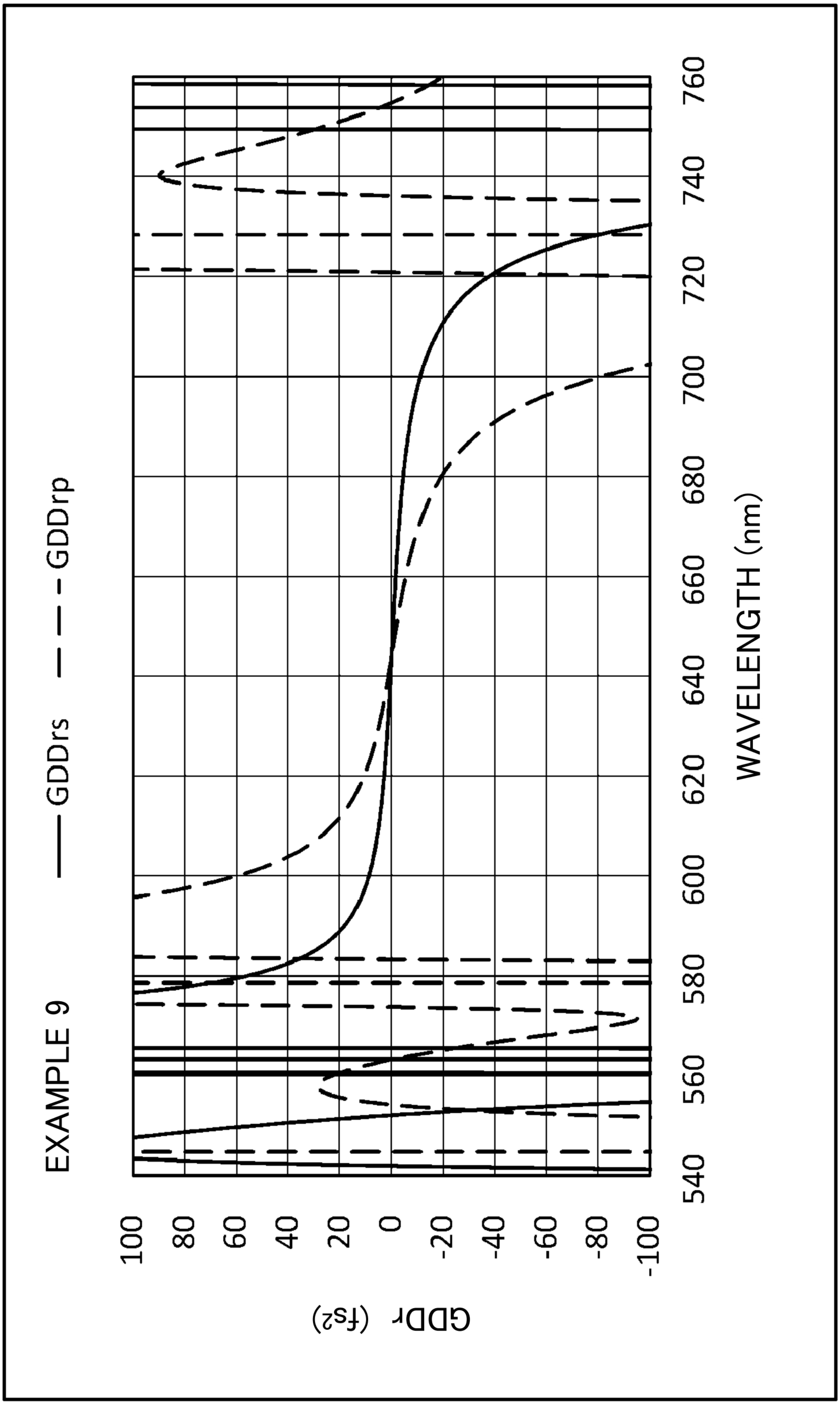
EXAMPLE 9
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.34

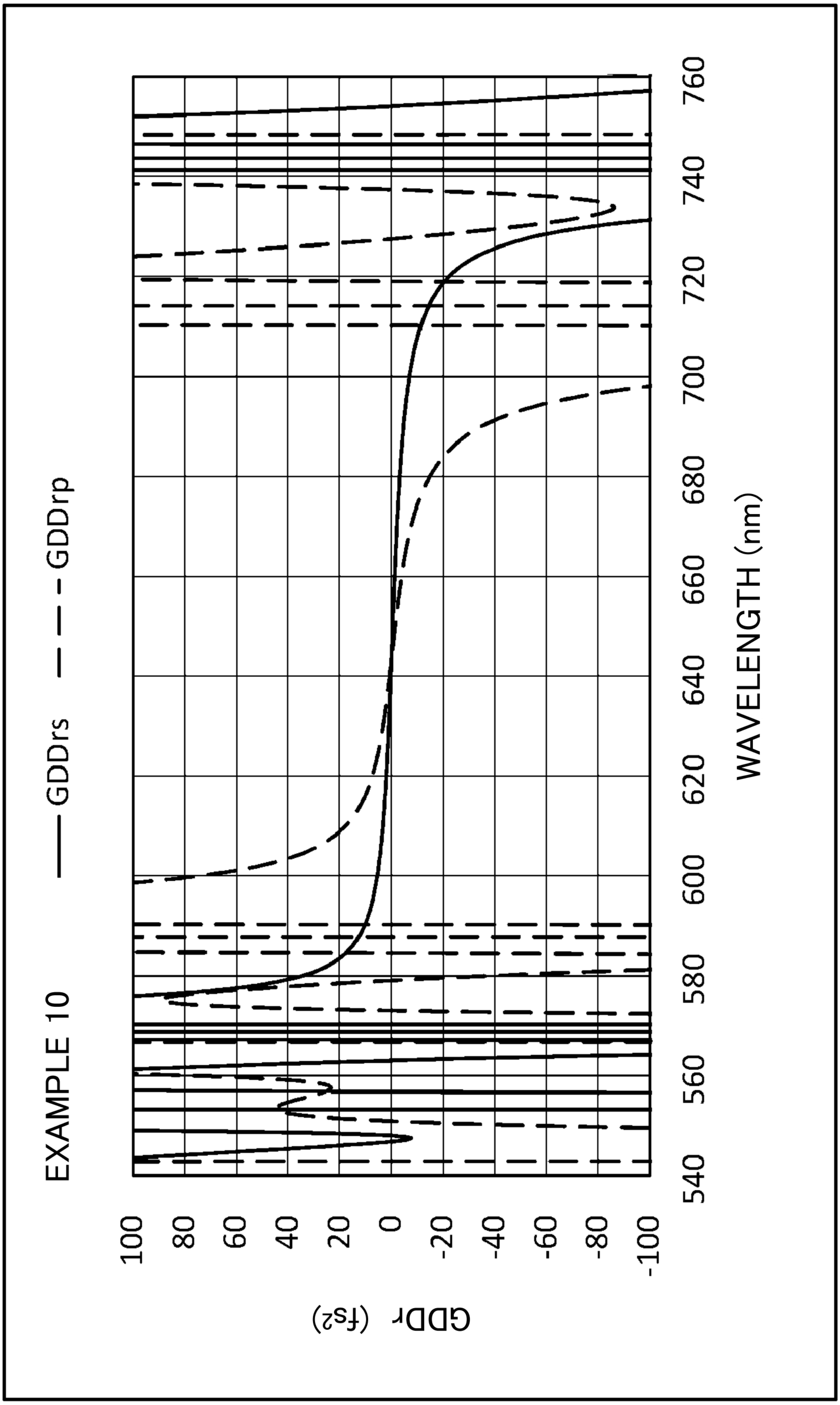
EXAMPLE 10
GDDrs
GDDrp
GDDr (fs²)
100
80
60
40
20
0
-20
-40
-60
-80
-100
540
560
580
600
620
640
660
680
700
720
740
760
WAVELENGTH (nm)

FIG.35

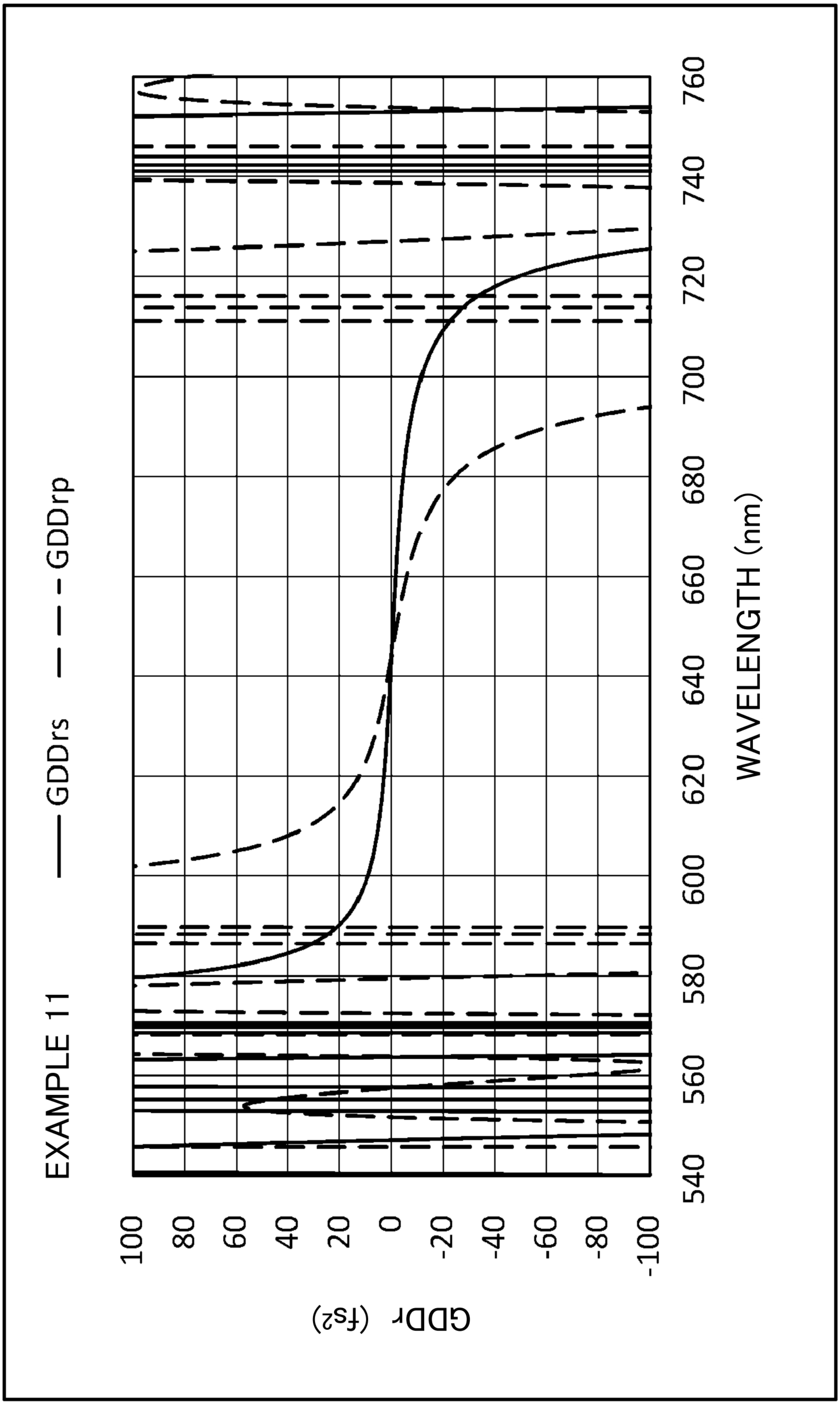
EXAMPLE 11
GDDrs
GDDrp
GDDr (fs2)
WAVELENGTH (nm)
100
80
60
40
20
0
-20
-40
-60
-80
-100
540
560
580
600
620
640
660
680
700
720
740
760

FIG.36

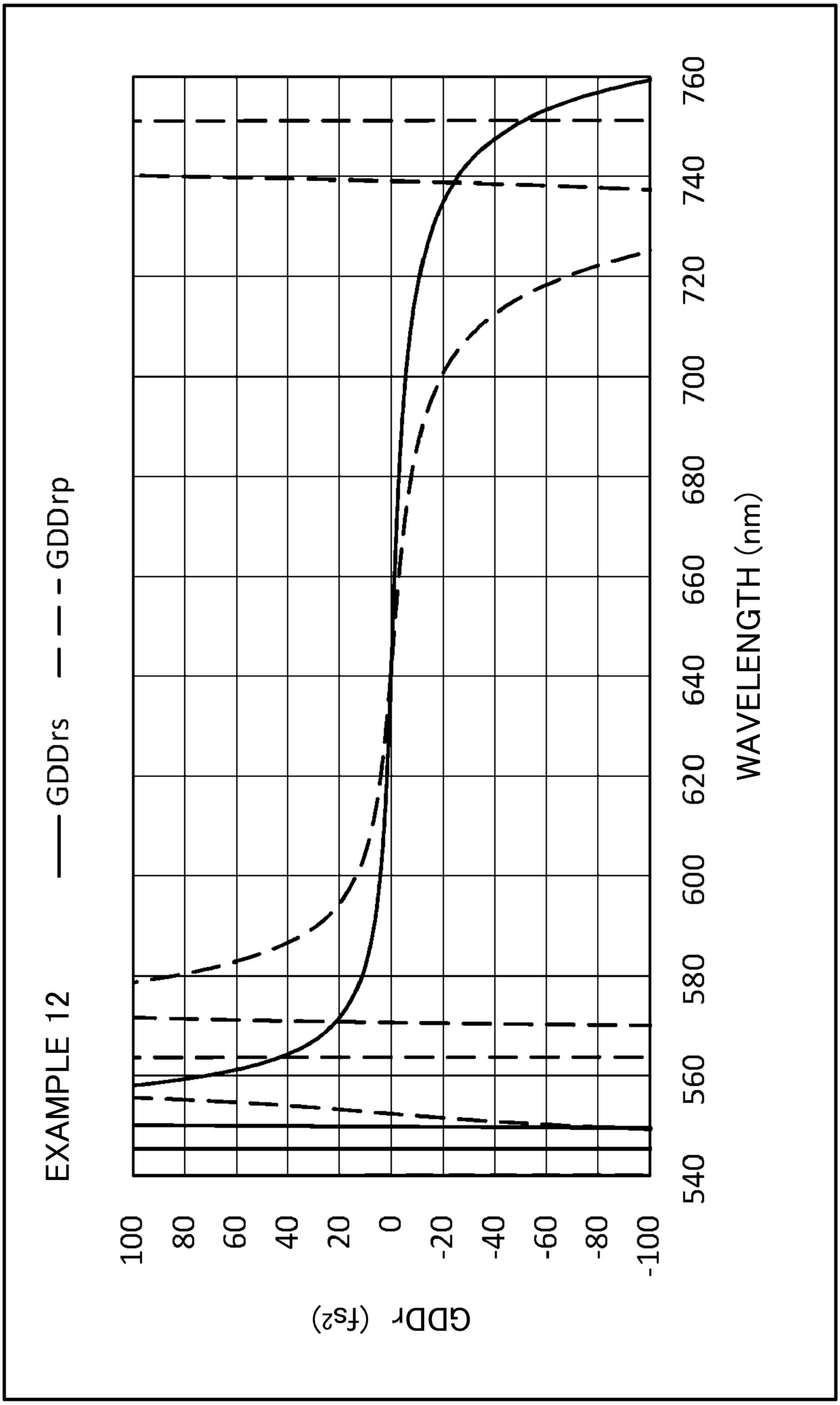
EXAMPLE 12
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.37

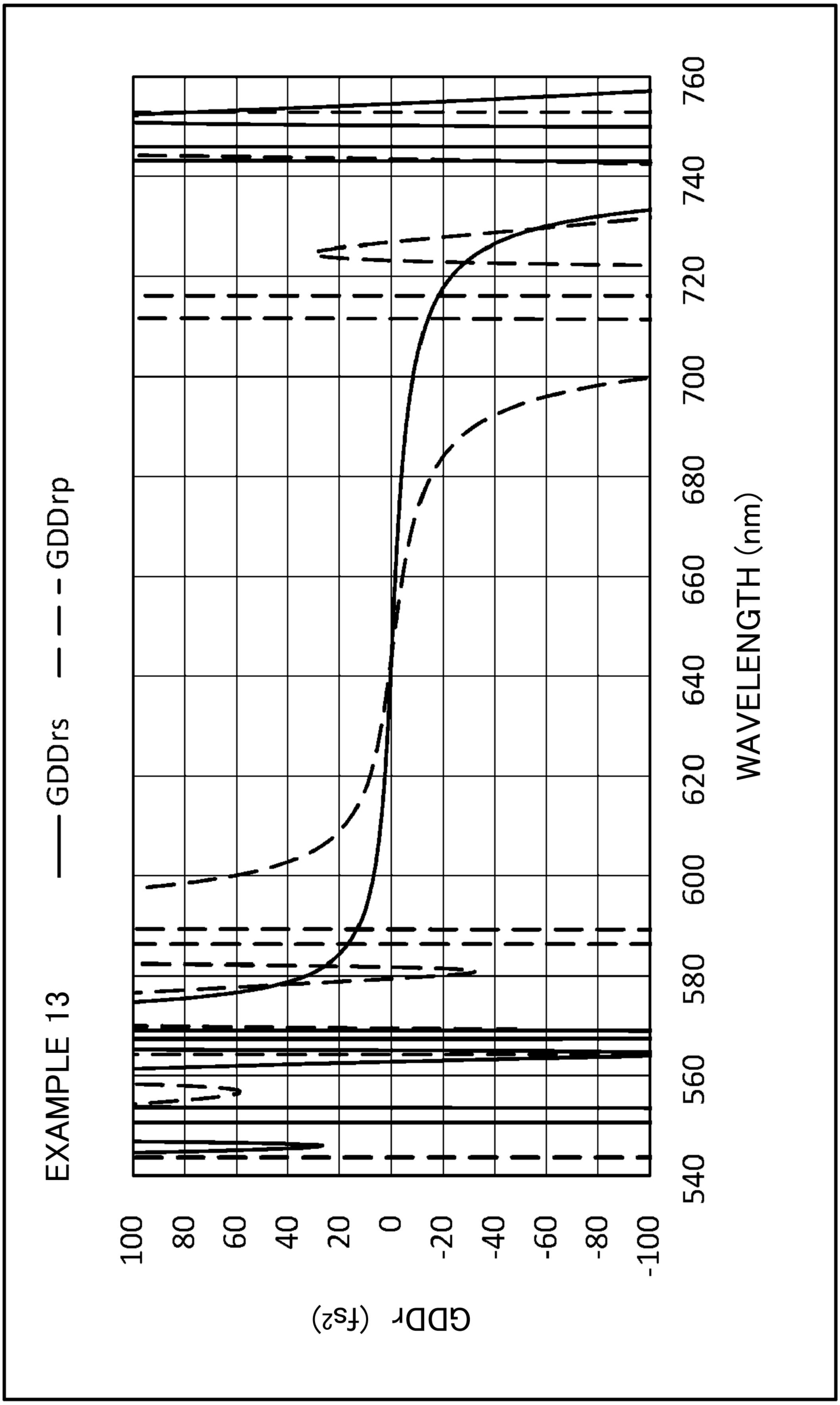
EXAMPLE 13
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.38

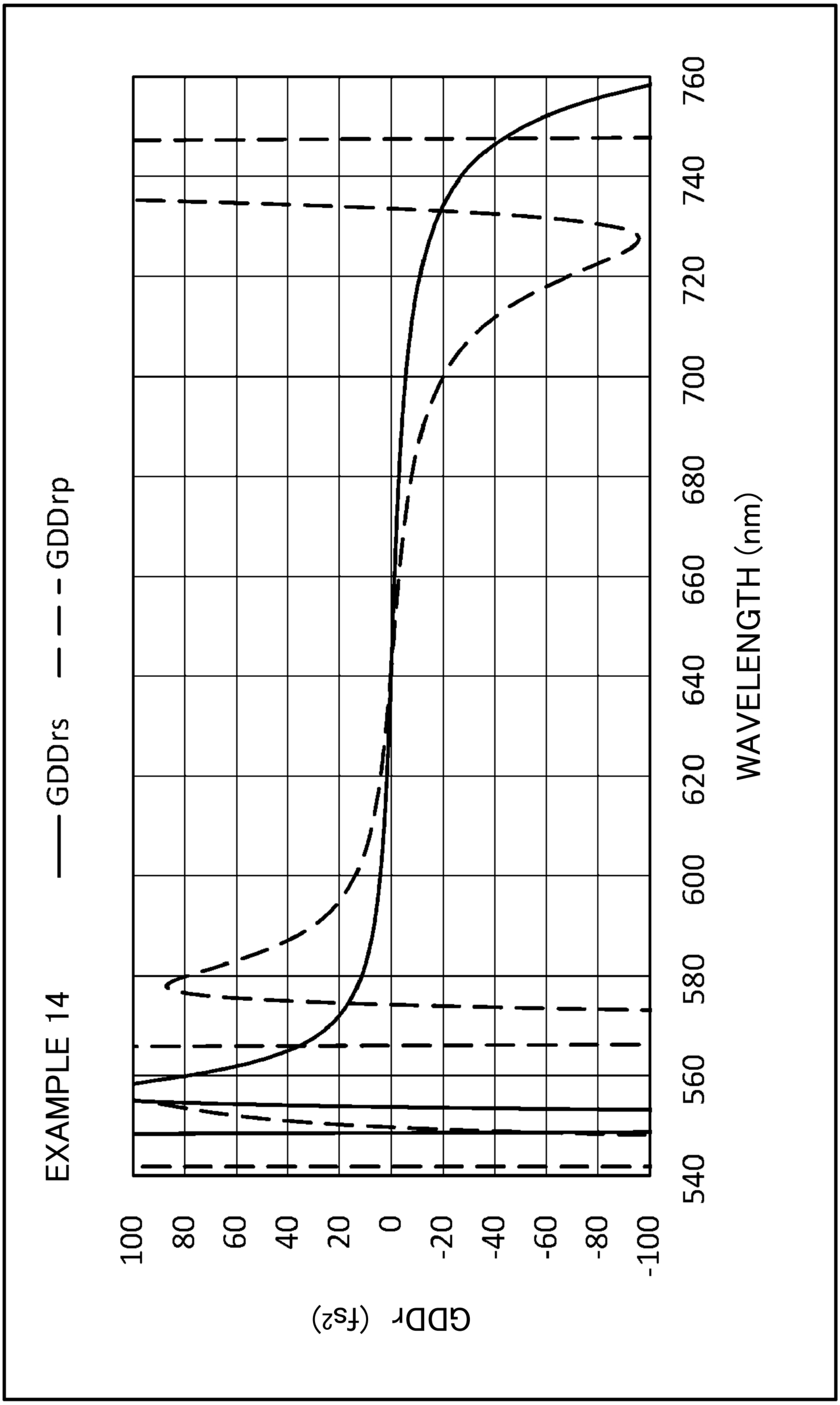
EXAMPLE 14
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.39

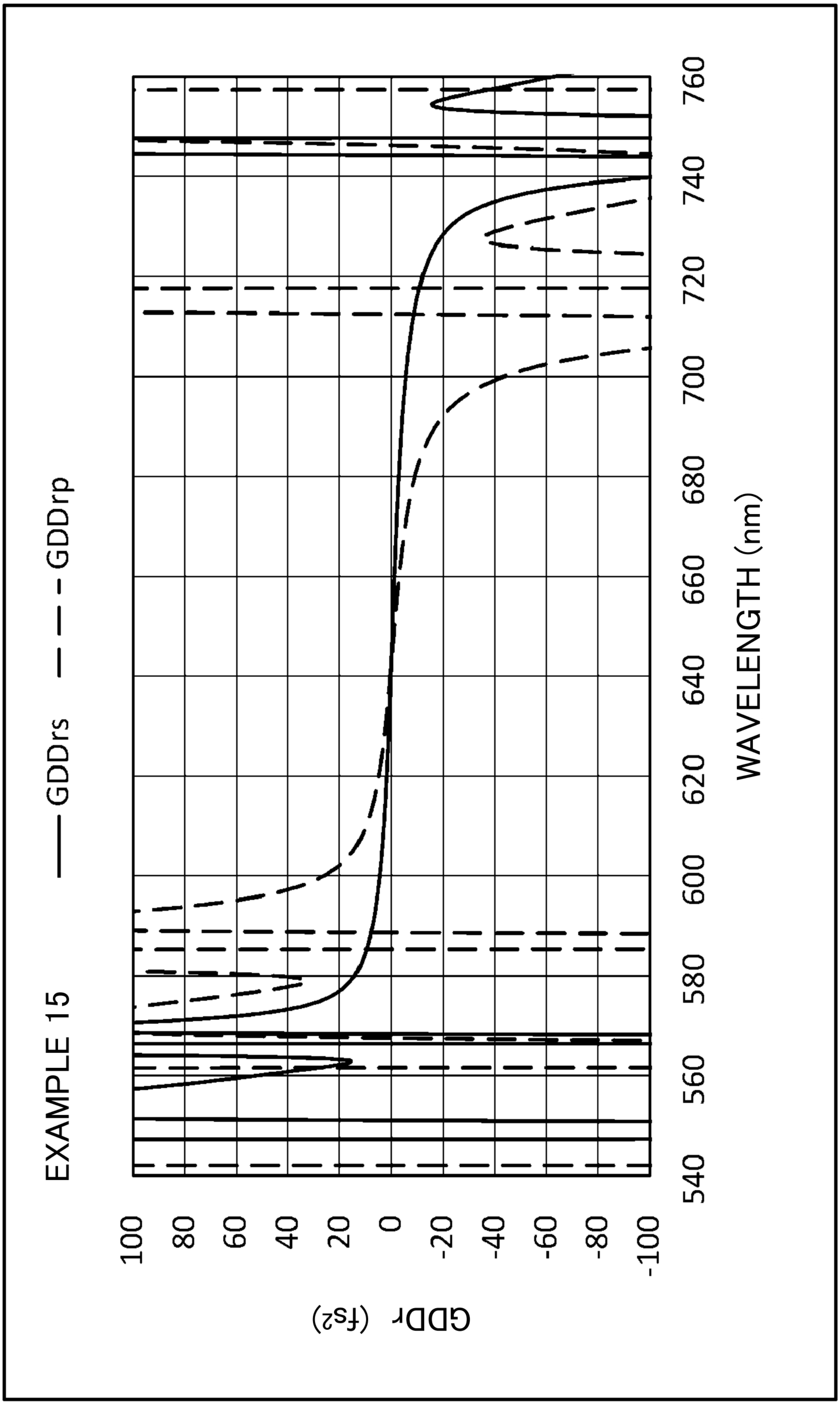
EXAMPLE 15
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.40

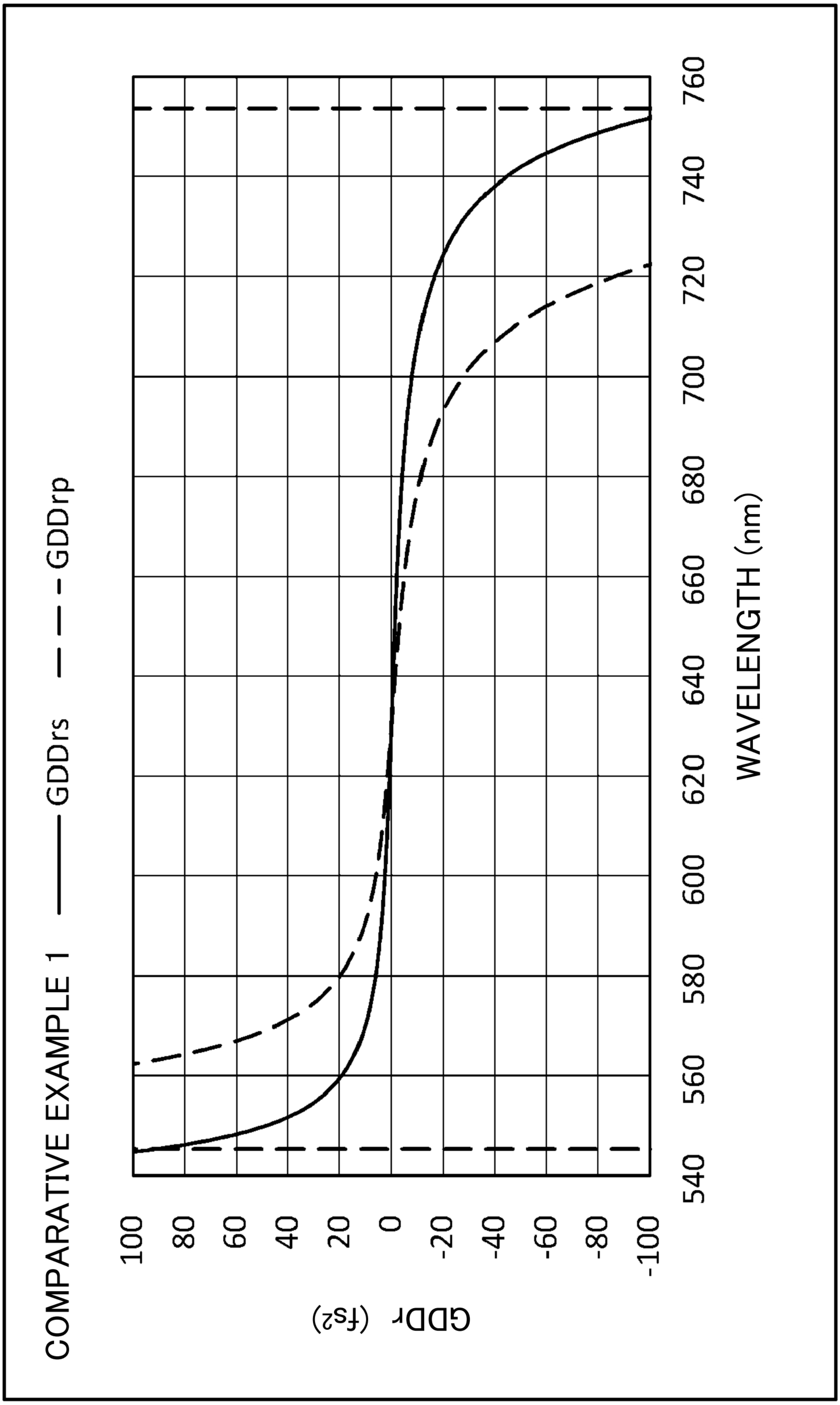
COMPARATIVE EXAMPLE 1
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.41

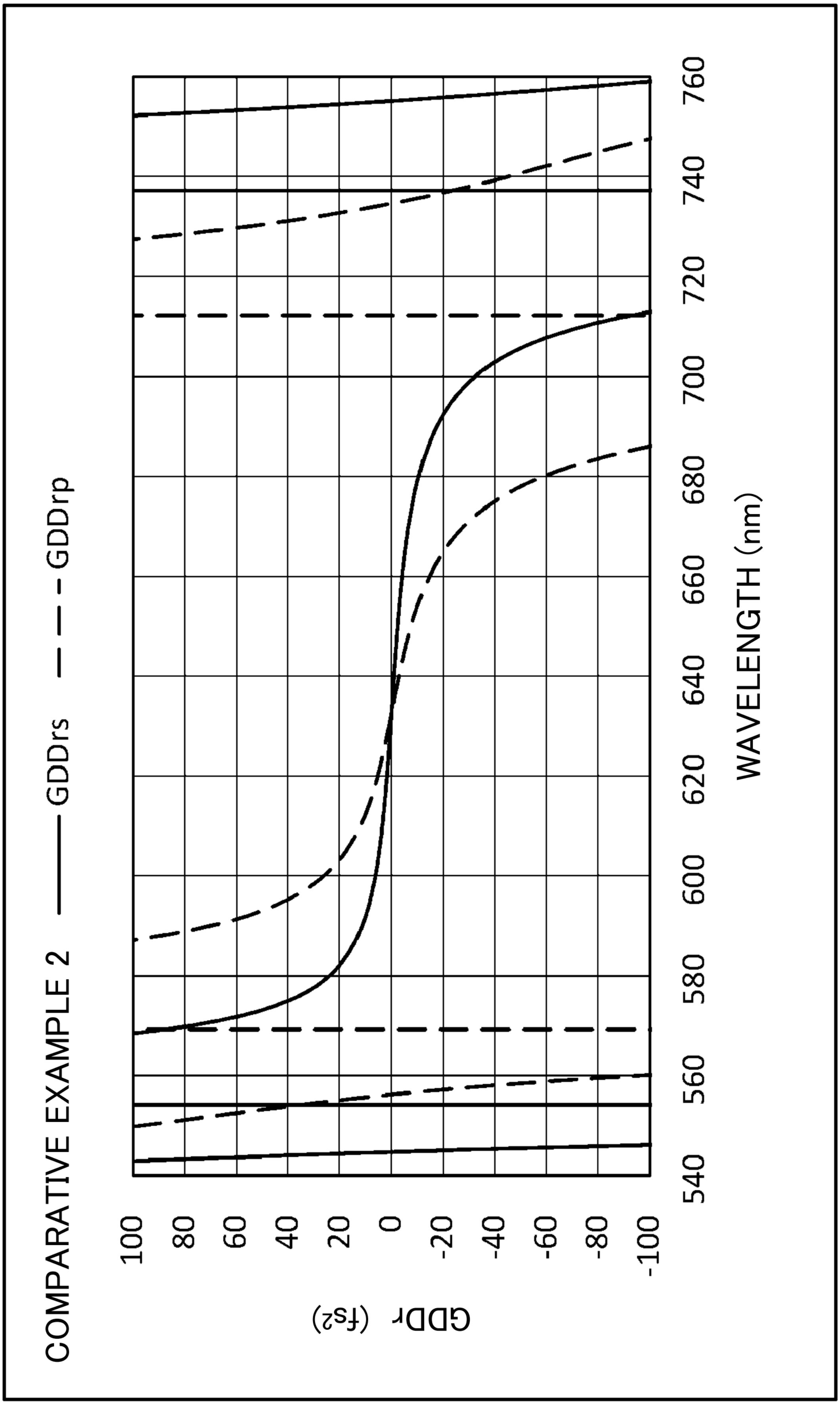
COMPARATIVE EXAMPLE 2
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.42

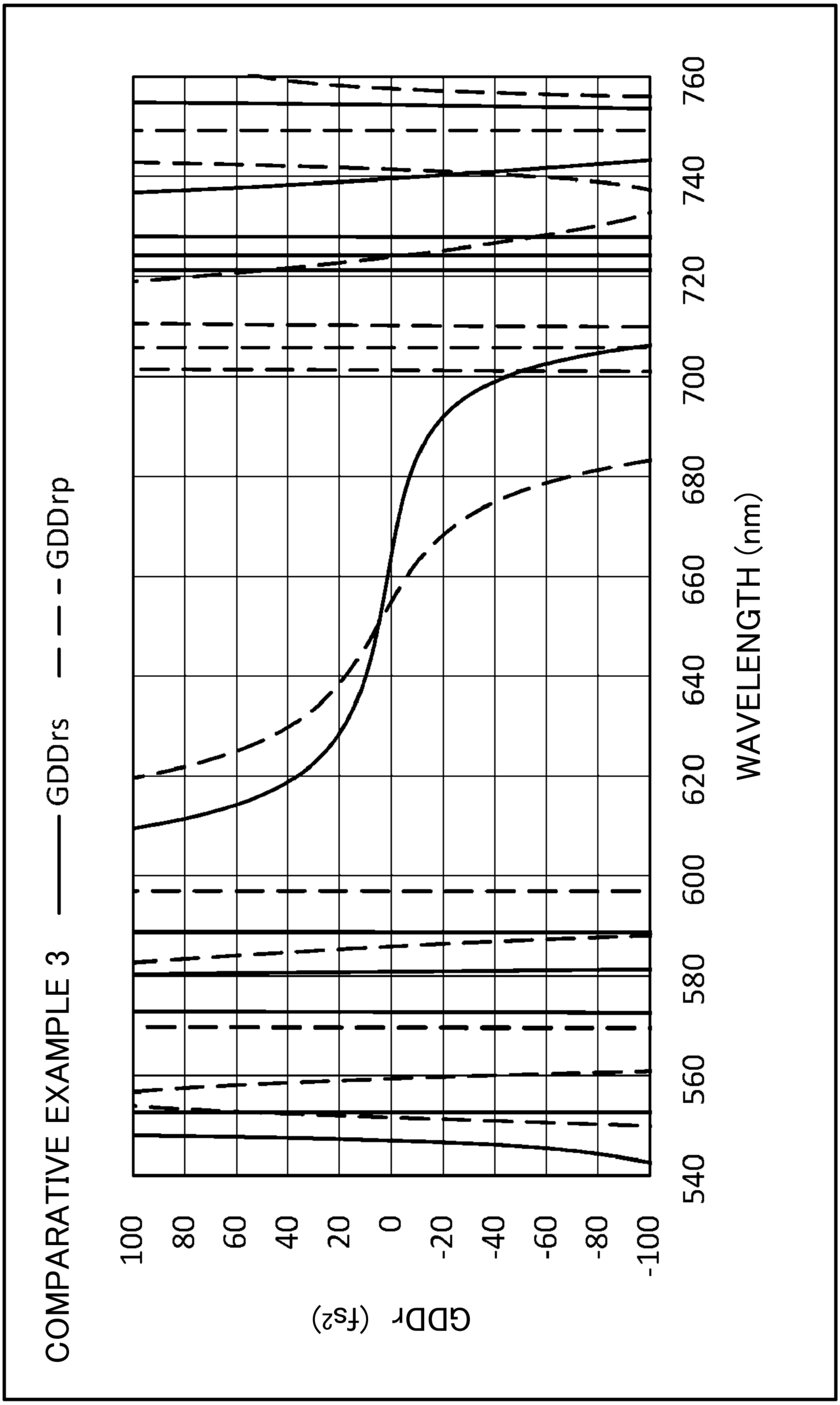
COMPARATIVE EXAMPLE 3
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.43

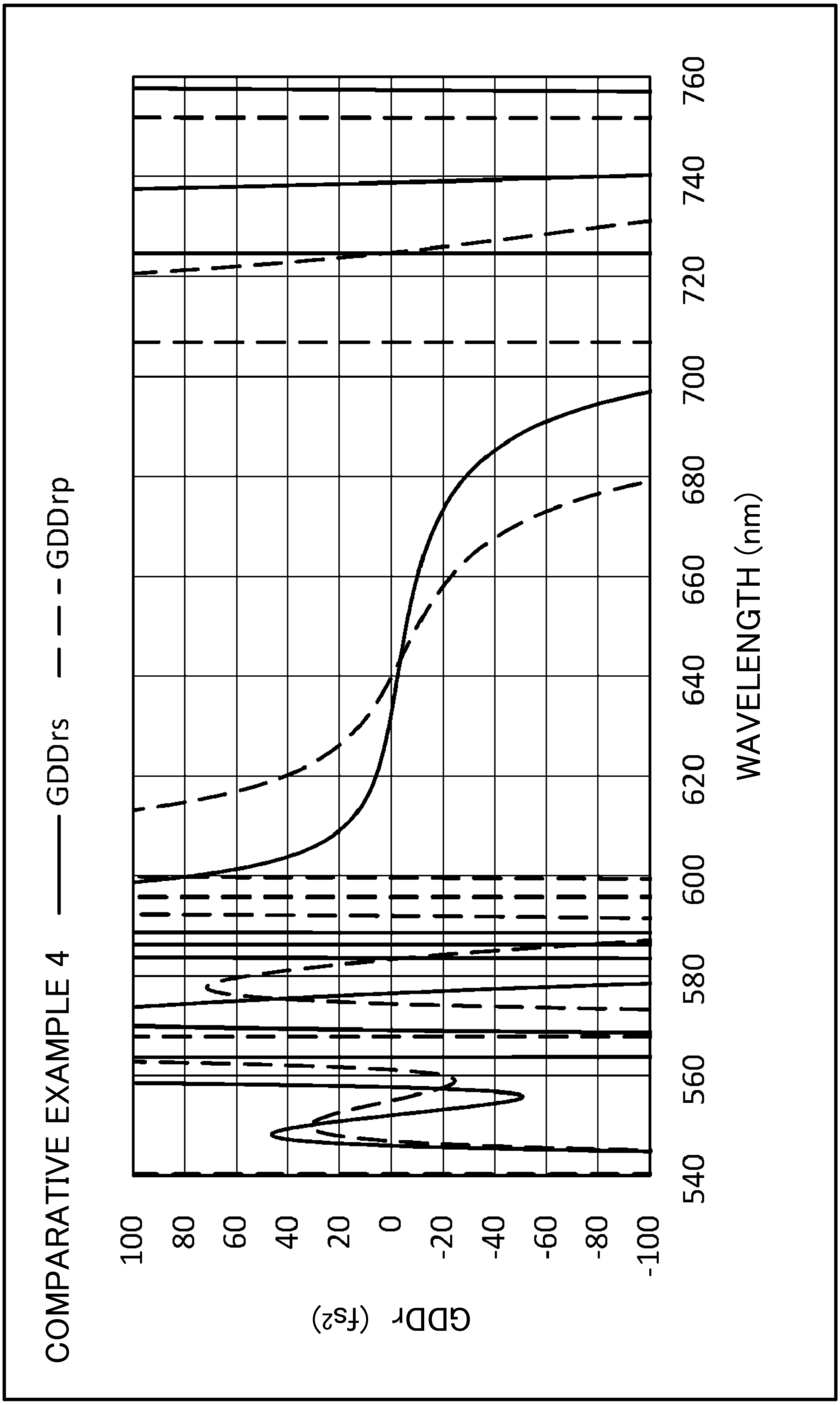
COMPARATIVE EXAMPLE 4
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.44

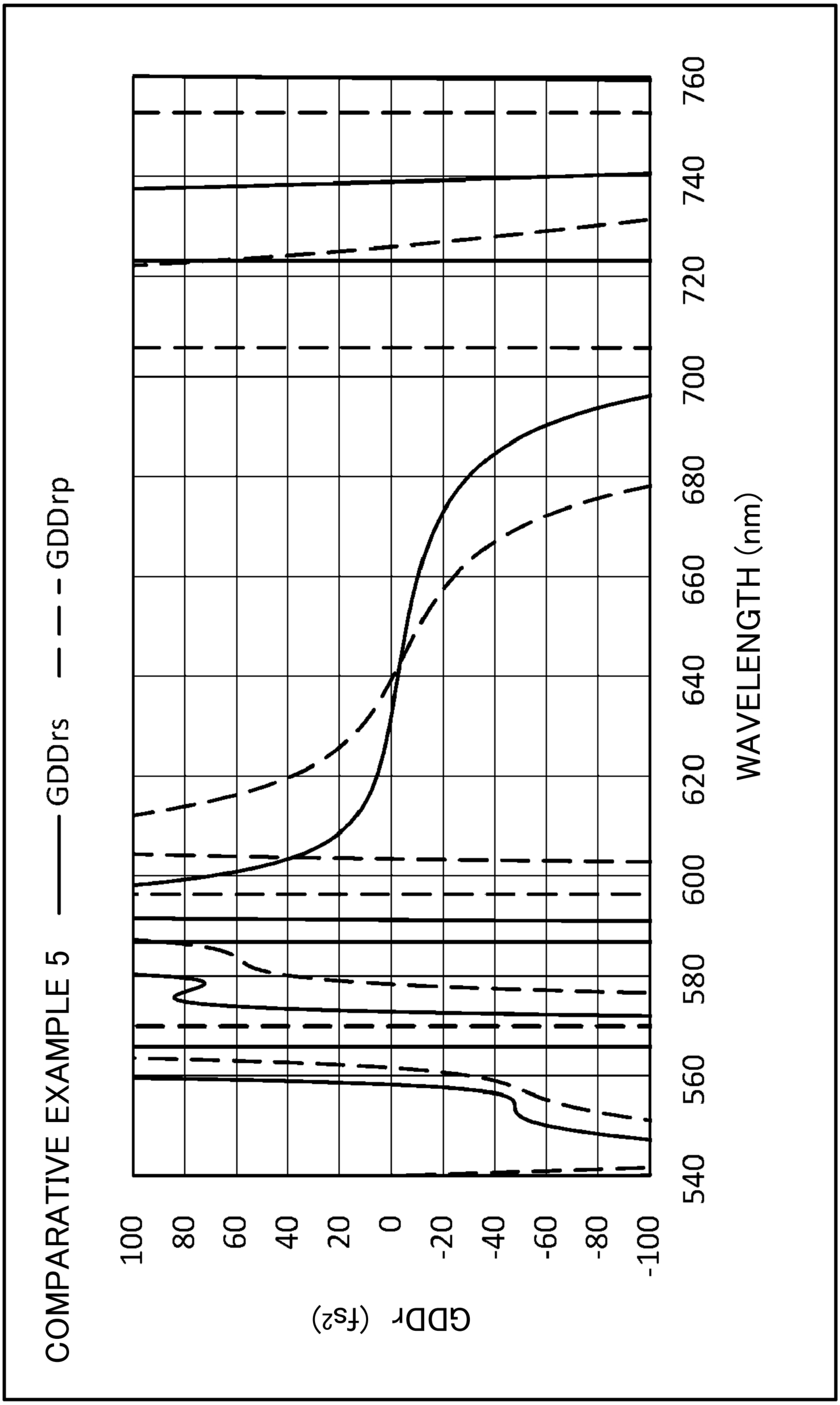
COMPARATIVE EXAMPLE 5
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.45

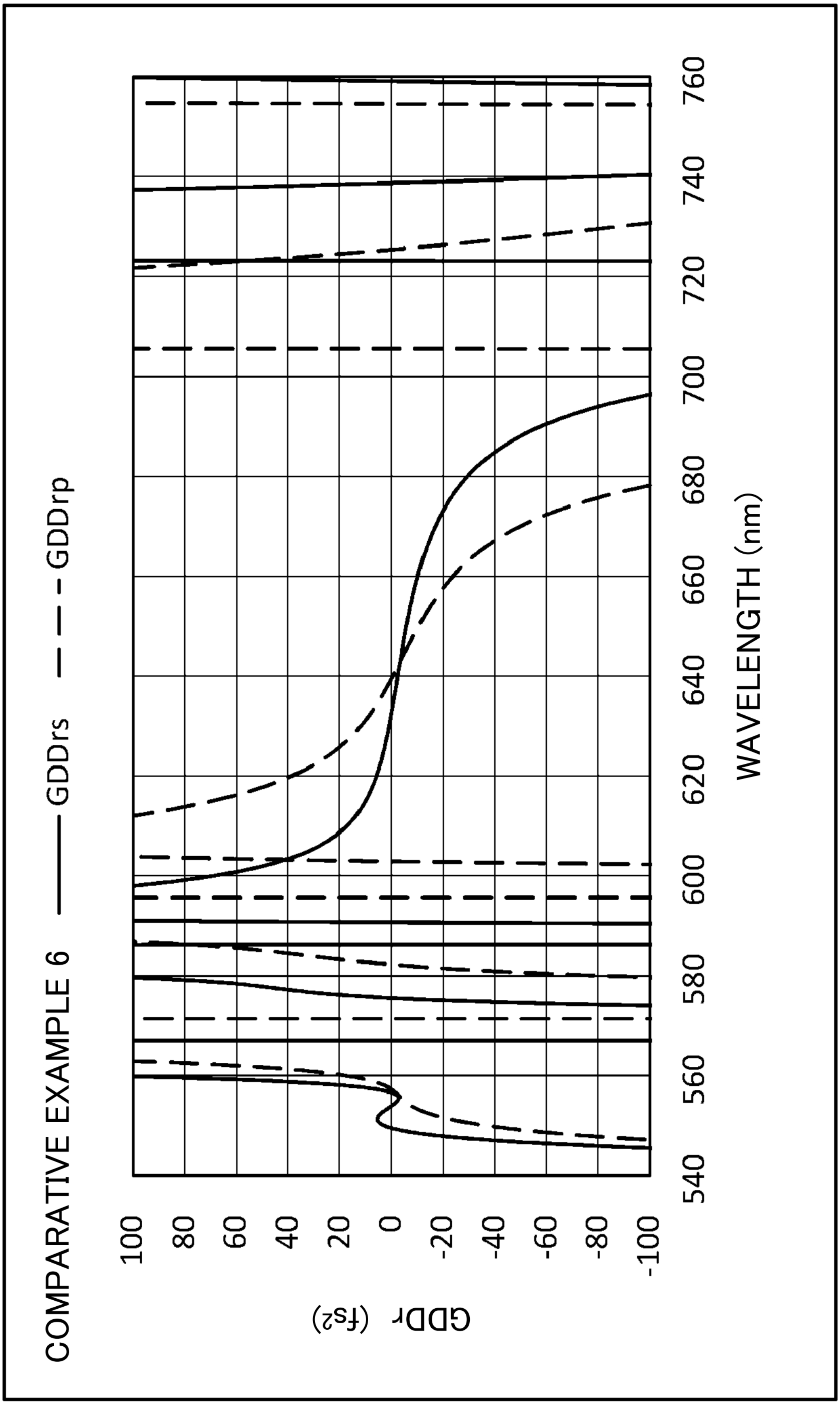
COMPARATIVE EXAMPLE 6
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.46

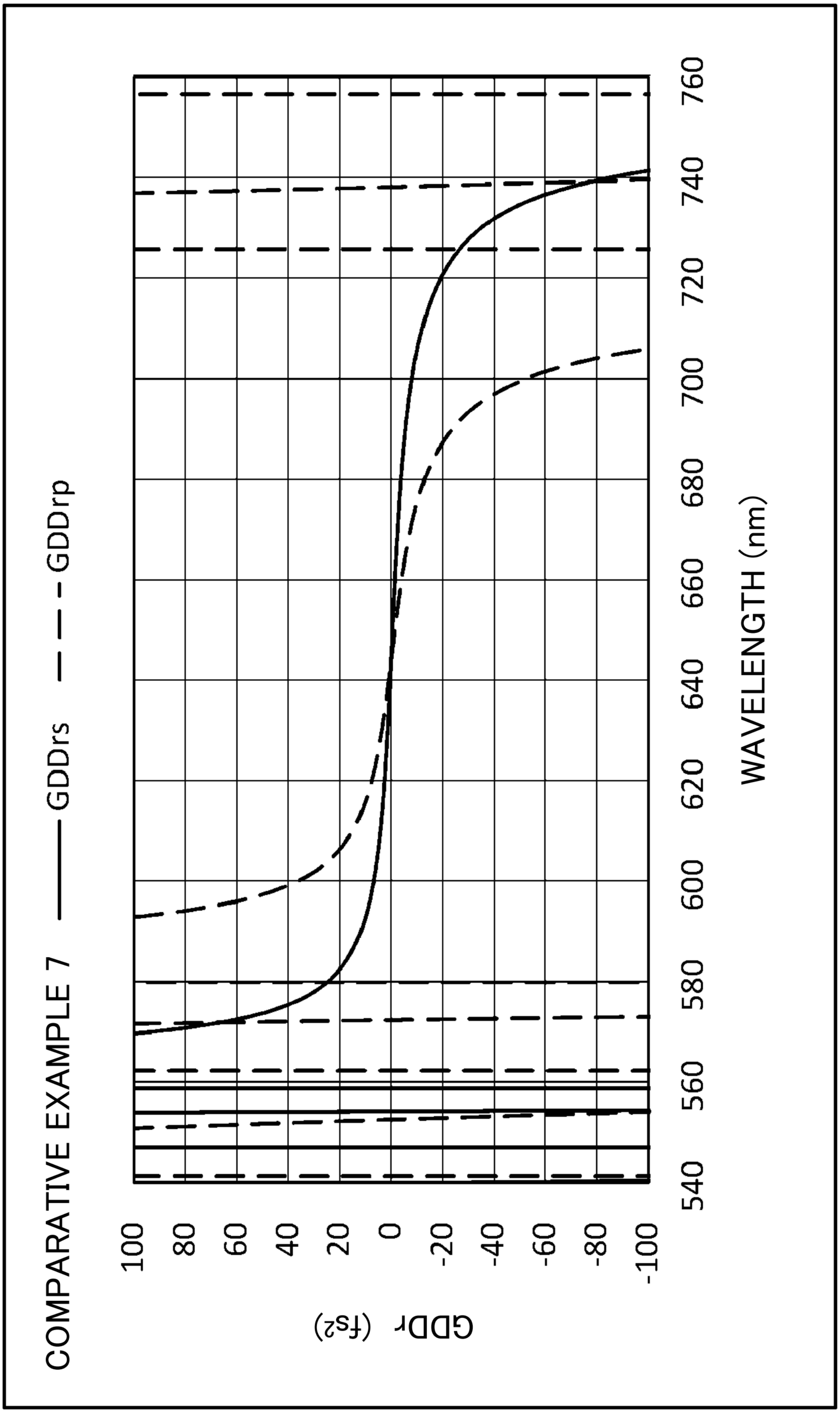
COMPARATIVE EXAMPLE 7
GDDrs
GDDrp
GDDr (fs2)
100
80
60
40
20
0
-20
-40
-60
-80
-100
540
560
580
600
620
640
660
680
700
720
740
760
WAVELENGTH (nm)

FIG.47

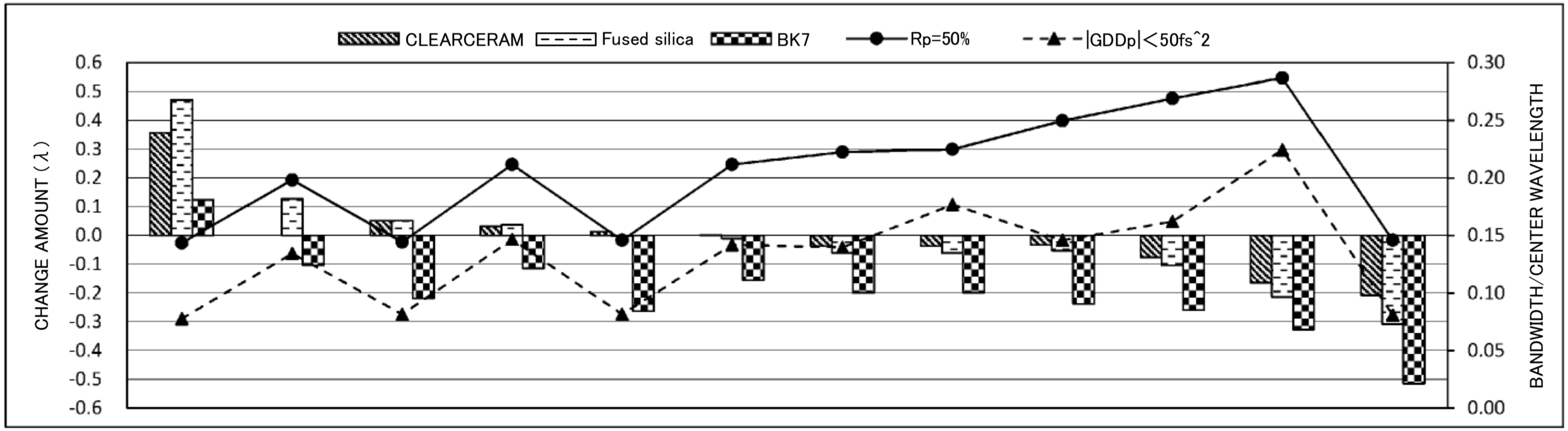


| | COMPARATIVE EXAMPLE 3 | COMPARATIVE EXAMPLE 2 | COMPARATIVE EXAMPLE 5 | EXAMPLE 1 | COMPARATIVE EXAMPLE 6 | EXAMPLE 2 | EXAMPLE 5 | EXAMPLE 6 | EXAMPLE 3 | EXAMPLE 4 | COMPARATIVE EXAMPLE 1 | COMPARATIVE EXAMPLE 4 |
|---|---|---|---|---|---|---|---|---|---|---|---|---|
| | CALCULATION VALUE | MEASUREMENT VALUE | CALCULATION VALUE | MEASUREMENT VALUE | CALCULATION VALUE | MEASUREMENT VALUE | CALCULATION VALUE | CALCULATION VALUE | MEASUREMENT VALUE | MEASUREMENT VALUE | MEASUREMENT VALUE | CALCULATION VALUE |
| $p_T$ | 0 | 0 | 0 | 0.30 | 0 | 0.36 | 0.36 | 0.36 | 0.42 | 0.55 | 1 | 0 |
| t | 0 | 0 | 0 | 0.099 | 0 | 0.120 | 0.120 | 0.120 | 0.139 | 0.183 | 0.337 | 0 |
| h | 0.655 | 0.383 | 0.372 | 0.271 | 0.342 | 0.248 | 0.248 | 0.248 | 0.229 | 0.179 | 0 | 0.180 |
| c | 0.345 | 0.617 | 0.628 | 0.631 | 0.658 | 0.631 | 0.631 | 0.631 | 0.632 | 0.638 | 0.663 | 0.820 |

## INTERNATIONAL SEARCH REPORT

International application No.
**PCT/JP2024/006615**

**A. CLASSIFICATION OF SUBJECT MATTER**

***G02B 5/28***(2006.01)i; ***G02B 1/115***(2015.01)i; ***G02B 5/26***(2006.01)i
FI: G02B5/28; G02B5/26; G02B1/115

According to International Patent Classification (IPC) or to both national classification and IPC

**B. FIELDS SEARCHED**

Minimum documentation searched (classification system followed by classification symbols)

G02B5/28; G02B1/115; G02B5/26

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2011-221207 A (KONICA MINOLTA OPTO INC.) 04 November 2011 (2011-11-04) entire text, all drawings | 1-12 |
| A | JP 2011-221208 A (KONICA MINOLTA OPTO INC.) 04 November 2011 (2011-11-04) entire text, all drawings | 1-12 |
| A | JP 2003-277911 A (OLYMPUS OPTICAL CO., LTD.) 02 October 2003 (2003-10-02) entire text, all drawings | 1-12 |
| A | JP 59-010901 A (NIHON KOUGAKU KOGYO KK) 20 January 1984 (1984-01-20) entire text, all drawings | 1-12 |

☐ Further documents are listed in the continuation of Box C.
☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **16 April 2024** | **07 May 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2024/006615**

| Patent document cited in search report | | | Publication date (day/month/year) | Patent family member(s) | Publication date (day/month/year) |
|---|---|---|---|---|---|
| JP | 2011-221207 | A | 04 November 2011 | (Family: none) | |
| JP | 2011-221208 | A | 04 November 2011 | (Family: none) | |
| JP | 2003-277911 | A | 02 October 2003 | (Family: none) | |
| JP | 59-010901 | A | 20 January 1984 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 59010901 A
- JP 2003277911 A
- JP S5910901 A
- JP 7188754 B
- JP 7195022 B